(19) Europäisches Patentamt
European Patent Office
Office européen des brevets

(11) **EP 3 499 715 A1**

(12) **EUROPEAN PATENT APPLICATION**

(43) Date of publication:
**19.06.2019 Bulletin 2019/25**

(21) Application number: **19155709.9**

(22) Date of filing: **07.05.2012**

(51) Int Cl.:
*H03F 1/32* (2006.01)   *H03F 1/02* (2006.01)
*H03F 3/195* (2006.01)   *H03F 3/24* (2006.01)
*H04B 17/00* (2015.01)   *H03G 3/00* (2006.01)
*H03G 3/30* (2006.01)   *H03F 3/217* (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:
05.05.2011   US 201161482702 P
10.05.2011   US 201161484613 P
15.07.2011   US 201161508202 P
25.08.2011   US 201113218400
25.08.2011   PCT/US2011/049243
02.09.2011   US 201161530625 P
29.09.2011   PCT/US2011/054106
06.10.2011   US 201161544051 P
26.10.2011   US 201161551605 P
30.11.2011   US 201161565138 P
09.12.2011   US 201113316229
09.12.2011   PCT/US2011/064255
16.12.2011   US 201161576520 P
01.02.2012   US 201213363888
01.02.2012   PCT/US2012/023495
07.02.2012   US 201213367973
07.02.2012   PCT/US2012/024124
19.03.2012   US 201213423649

(62) Document number(s) of the earlier application(s) in accordance with Art. 76 EPC:
**12725911.7 / 2 705 604**

(71) Applicant: **Qorvo US, Inc.
Greensboro, NC 27409 (US)**

(72) Inventors:
• **KHLAT, Nadim
F-31270 Cugnaux (FR)**
• **KAY, Michael R.
Summerfield, NC North Carolina 27358 (US)**
• **GORISSE, Philippe
F-31490 Brax (FR)**
• **NGO, Christopher, Truong
Queen Creek, AZ Arizona 85142 (US)**

(74) Representative: **Hanna Moore + Curley
Garryard House
25/26 Earlsfort Terrace
Dublin 2, D02 PX51 (IE)**

Remarks:
This application was filed on 06.02.2019 as a divisional application to the application mentioned under INID code 62.

(54) **POWER MANAGEMENT ARCHITECTURE FOR MODULATED AND CONSTANT SUPPLY OPERATION**

(57)   A pseudo-envelope tracking modulated power supply system, which is used to provide a power amplifier supply voltage to a radio frequency power amplifier, is disclosed. In a first embodiment, during a high power modulation mode and a medium power modulation mode, the power amplifier supply voltage provides envelope tracking. During a low power average power tracking mode, the power amplifier supply voltage provides average power tracking. In a second embodiment, an output power from the radio frequency power amplifier is regulated based on a difference between a target output power from the radio frequency power amplifier and a measured output power from the radio frequency power amplifier. The power amplifier supply voltage provides power for amplification, based on the difference between the target output power and the measured output power.

EP 3 499 715 A1

FIG. 2A

FIG. 2B

FIG. 2C

FIG. 2D

**2**

FIG. 2E

**Description**

Field of the Disclosure

The embodiments described herein relate to a power management system for delivering current to a linear radio frequency power amplifier. More particularly, the embodiments relate to the use of a pseudo-envelope tracker in a power management system of mobile communications equipment.

Background

Next-generation mobile devices are morphing from voice-centric telephones to message and multimedia-based "smart" phones that offer attractive new features. As an example, smart phones offer robust multimedia features such as web-browsing, audio and video playback and streaming, email access and a rich gaming environment. But even as manufacturers race to deliver ever more feature rich mobile devices, the challenge of powering them looms large.

In particular, the impressive growth of high bandwidth applications for radio frequency (RF) hand-held devices has led to increased demand for efficient power saving techniques to increase battery life. Because the radio frequency power amplifier of the mobile device consumes a large percentage of the overall power budget of the mobile device, various power management systems have been proposed to increase the overall power efficiency of the radio frequency power amplifier. As such, there remains a need to further improve the power efficiency of mobile devices to provide extended battery life. In this regard, there is a need to improve the power management system of mobile devices. US2006/0270366 discloses a supply voltage controlled power amplifier that comprises a power amplifier, a closed power control feedback loop configured to generate a power control signal, and a dual voltage regulator coupled to the power control feedback loop, the dual voltage regulator comprising a first regulator stage and a second regulator stage, wherein the closed power control loop minimizes noise generated by the first regulator stage.

US2006/087372 discloses a circuit and method for applying a dynamically varying collector voltage to a power amplifier. A desired output power is determined, and an input and output power of a power amplifier are measured. A processor determines, for the measured input power and the desired output power, a collector voltage.

US2005/208907 discloses small portable communication devices that support multiple modulation techniques, wherein the linearity of a power amplifier is detected by comparing the envelope of the output signal with the base band signal used to modulate the output signal.

US7,917,105 discloses a power amplifier controller circuit that controls a power amplifier based upon an amplitude correction signal indicating the amplitude difference between the amplitude of the input signal and an attenuated amplitude of the output signal.

EP1383235 discloses a method for compensating for the non-linearity of the amplifier with a pre-error correction unit for data values of an input data stream. The amplifier is operated with a supply voltage selected so the amplifier operates in the linear region at least at the start of transmission or following a significant change in an operating parameter.

Summary

According to the present invention, there is provided circuitry according to claim 1.

Those skilled in the art will appreciate the scope of the disclosure and realize additional aspects thereof after reading the following detailed description in association with the accompanying drawings.

Brief Description of the Drawings

The accompanying drawings incorporated in and forming a part of this specification illustrate several aspects of the disclosure, and together with the description serve to explain the principles of the disclosure.

Figure 1A depicts an embodiment of a pseudo-envelope follower power management system for managing power supplied to a linear radio frequency power amplifier according to one embodiment of the pseudo-envelope follower power management system.

Figure 1B depicts an embodiment of the pseudo-envelope follower power management system for managing power supplied to a linear radio frequency power amplifier according to an alternate embodiment of the pseudo-envelope follower power management system.

Figure 2A depicts an embodiment of a pseudo-envelope tracking modulated power supply system depicted in Figures 2B-C according to one embodiment of the pseudo-envelope tracking modulated power supply system.

Figure 2B depicts an embodiment of a switch mode power supply controller of the pseudo-envelope tracking modulated power supply systems depicted in Figures 2A, Figures 2C-E and Figures 8A-B and Figures 8E-H.

Figure 2C depicts an embodiment of a parallel amplifier circuit of a power management system.

Figure 2D depicts an embodiment of a parallel amplifier circuit of a power management system.

Figure 2E depicts an embodiment of a parallel amplifier circuit of a power management system.

Figure 3 depicts an equivalent circuit of the pseudo-envelope follower power management system configured to operate in a low power modulation mode.

Figure 4 depicts an embodiment of a method for determining a power level modulation mode in which to operate a power management system prior to commencement of a data transmission.

Figures 5A-B depict a method for configuring the pseudo-envelope tracking modulated power supply system to operate in a high power modulation mode.

Figure 6A-B depict a method for configuring the pseudo-envelope tracking modulated power supply system to operate in a medium power modulation mode.

Figure 7 depicts a method for configuring the pseudo-envelope tracking modulated power supply system to operate in a low power modulation mode.

Figure 8A depicts an embodiment of a system for generating a pseudo-envelope and average power tracking modulated power supply voltage, depicted in Figure 2B and Figure 8B.

Figure 8B depicts an embodiment of a parallel amplifier circuit to generate a pseudo-envelope an average power tracking modulated power supply, depicted in Figure 2B and Figure 8C.

Figure 8C depicts an embodiment of a parallel amplifier adapted to provide a modulation mode feedback signal.

Figure 8D depicts an embodiment of an offset voltage loop circuit adapted to regulate a switch mode power supply converter operating in various average power tracking modulation modes of operation.

Figure 8E depicts an embodiment of a parallel amplifier circuit of a power management system.

Figure 8F depicts an embodiment of a parallel amplifier circuit of a power management system.

Figure 8G depicts an embodiment of a parallel amplifier circuit of a power management system.

Figure 8H depicts an embodiment of a parallel amplifier circuit of a power management system.

Figure 9 depicts an embodiment of a method for determining a power level modulation mode in which to operate a power management system prior to commencement of a data transmission.

Figure 10A-B depict an embodiment of a method for configuring a power management system to operate in a high power modulation mode during a data transmission.

Figure 11A-B depict an embodiment of a method for configuring a power management system to operate in a medium power modulation mode during a data transmission.

Figure 12A-B depict an embodiment of a method for configuring a power management system to operate in a medium power average power tracking modulation mode during a data transmission.

Figure 13 depicts an embodiment a low power average power tracking modulation mode during a data transmission.

Figure 14 depicts a number of iso-gain contours in relationship to two dynamic ranges of drive level for the modulated radio frequency input signal.

Figure 15 depicts an embodiment of an envelope tracking modulated power supply with power control loop compensation.

Figure 16 depicts an embodiment of a digital baseband circuit of the envelope tracking modulated power supply with power control loop compensation system.

Figure 17A depicts various noise corruption sources that may affect the accuracy of calibration of iso-gain contours of the radio frequency power amplifier.

Figure 17B depicts a noise corruption model for a digital baseband circuit during calibration of a number of iso-gain contours of the radio frequency power amplifier.

Figure 17C depicts a method for reducing the noise corruption during calibration of the iso-gain contours of the radio frequency amplifier.

Figures 18A-D depict a method for compensating generation of a modulated power supply voltage in response to a change in a drive level of a modulated radio frequency input signal provided to a radio frequency power amplifier in order to maintain a linear gain.

Detailed Description

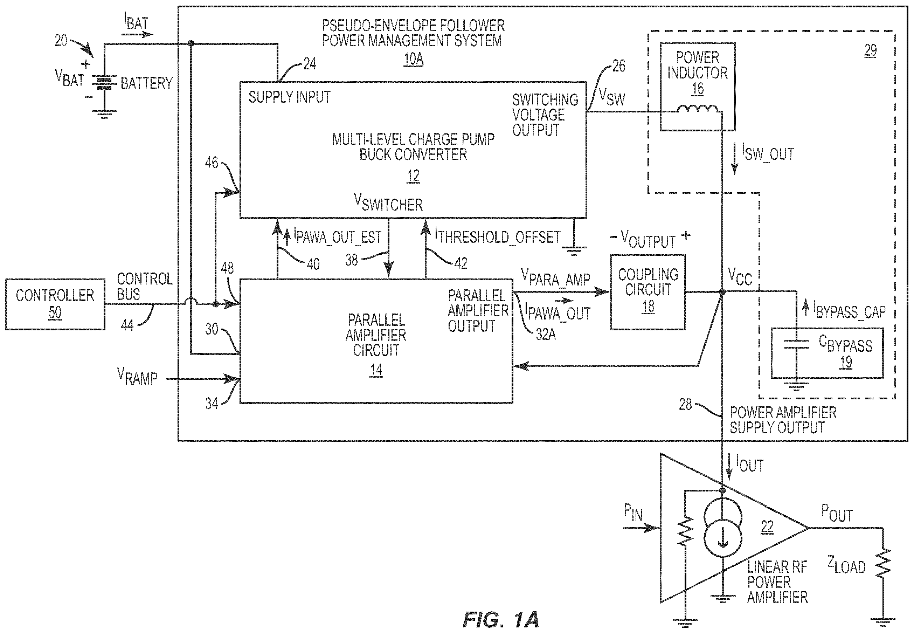

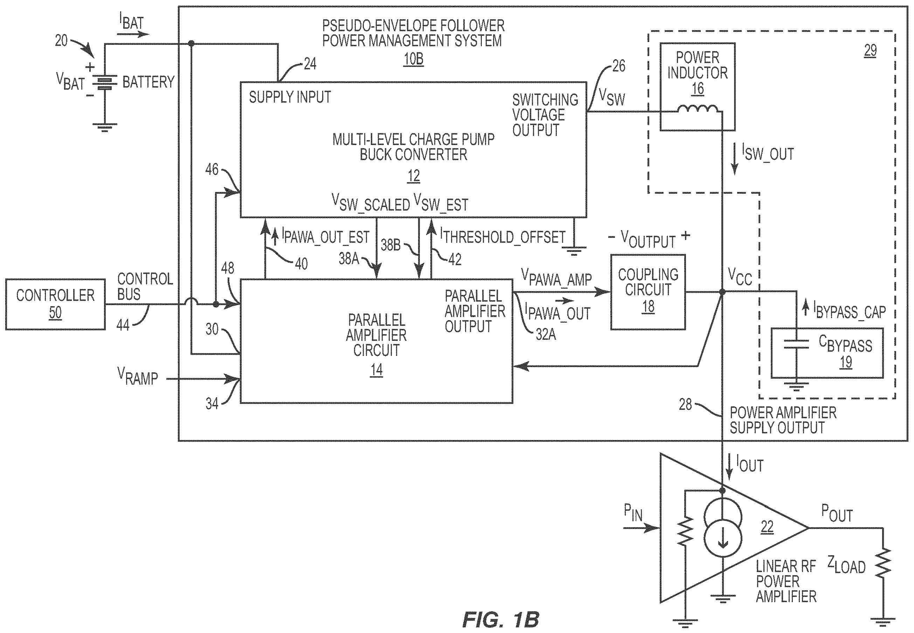

Figure 1A depicts an embodiment of a pseudo-envelope follower power management system 10A for managing power supplied to a linear radio frequency power amplifier 22 according to one embodiment of the pseudo-envelope follower power management system 10A. Figure 1B depicts an embodiment of a pseudo-envelope follower power management system 10B for managing power supplied to the linear radio frequency power amplifier 22 according to an alternate embodiment of the pseudo-envelope follower power management system 10A. As such, Figure 1A depicts an example embodiment of the pseudo-envelope follower power management system 10A including a multi-level charge pump buck converter 12, a parallel amplifier circuit 14, a power inductor 16, a coupling circuit 18, and a bypass capacitor 19. The bypass capacitor 19 has a bypass capacitor capacitance, $C_{BYPASS}$.

The multi-level charge pump buck converter 12 and the parallel amplifier circuit 14 may be configured to operate in tandem to generate a power amplifier supply voltage, $V_{CC}$, at a power amplifier supply output 28 of the pseudo-envelope follower power management system 10A for the linear radio frequency power amplifier 22. The power amplifier supply voltage, $V_{CC}$, may also be referred to as a modulated power supply voltage, $V_{CC}$. The power amplifier supply output 28 provides an output current, $I_{OUT}$, to the linear radio frequency power amplifier 22. The linear radio frequency power amplifier 22 may include a radio frequency power amplifier input configured to receive a modulated radio frequency input signal having an input power $P_{IN}$. The linear radio frequency power amplifier 22 may further include a radio frequency power amplifier output coupled to an output load, $Z_{LOAD}$. The linear radio frequency power amplifier 22 may generate an amplified modulated radio frequency output signal having an output power $P_{OUT}$ in response to the modulated radio frequency input signal having the input power $P_{IN}$.

As an example, the output load, $Z_{LOAD}$, may be an antenna. The radio frequency power amplifier output may generate the amplified modulated radio frequency output signal as a function of the modulated radio frequency input signal and the power amplifier supply voltage, $V_{CC}$. In some embodiments, the power amplifier supply voltage, $V_{CC}$, may be modulated to substantially follow the signal envelope characteristic of the modulated radio frequency input signal to improve the power efficiency of the pseudo-envelope follower power management system 10A. The amplified modulated radio frequency output signal may be provided to the antenna for transmission. The multi-level charge pump buck converter 12 may include a supply input 24, ($V_{BAT}$), configured to receive a battery voltage, $V_{BAT}$, from a battery 20 and a switching voltage output 26 configured to provide a switching voltage, $V_{SW}$. The switching voltage output 26 may be coupled to the power amplifier supply output 28 by the power inductor 16, where the power inductor 16 couples to the bypass capacitor 19 to form an output filter 29 for the switching voltage output 26 of the multi-level charge pump buck converter 12. The power inductor 16 provides a power inductor current, $I_{SW\_OUT}$, to the power amplifier supply output 28. The parallel amplifier circuit 14 may include a parallel amplifier supply input 30 configured to receive the battery voltage, $V_{BAT}$, from the battery 20, a parallel amplifier output 32A, a first control input 34 configured to receive a $V_{RAMP}$ signal, and a second control input configured to receive the power amplifier supply voltage, $V_{CC}$. The parallel amplifier output 32A of the parallel amplifier circuit 14 may be coupled to the power amplifier supply voltage $V_{CC}$, by the coupling circuit 18. A parallel amplifier output voltage, $V_{PARA\_AMP}$, is provided by the parallel amplifier circuit 14.

As an example, the parallel amplifier circuit 14 may generate the parallel amplifier output voltage, $V_{PARA\_AMP}$, based on the difference between the $V_{RAMP}$ signal and the power amplifier supply voltage, $V_{CC}$. Thus, the $V_{RAMP}$ signal may represent either an analog or digital signal that contains the required supply modulation information for a power amplifier collector of a linear radio frequency power amplifier. Typically, the $V_{RAMP}$ signal is provided to the parallel amplifier circuit 14 as a differential analog signal to provide common mode rejection against any noise or spurs that could appear on this signal. The $V_{RAMP}$ signal may be a time domain signal, $V_{RAMP}$ (t), generated by a transceiver or modem and used to transmit radio frequency signals. For example, the $V_{RAMP}$ signal may be generated by a digital baseband processing portion of the transceiver or modem, where the digital $V_{RAMP}$ signal, $V_{RAMP\_DIGITAL}$, is digital-to-analog converted to form the $V_{RAMP}$ signal in the analog domain. In some embodiments, the "analog" $V_{RAMP}$ signal is a differential signal. The transceiver or a modem may generate the $V_{RAMP}$ signal based upon a known radio frequency modulation Amp (t)*cos (2*pi*$f_{RF}$*t + Phase(t)). The $V_{RAMP}$ signal may represent the target voltage for the power amplifier supply voltage, $V_{CC}$, to be generated at the power amplifier supply output 28 of the pseudo-envelope follower power management system 10A, where the pseudo-envelope follower power management system 10A provides the power amplifier supply voltage, $V_{CC}$, to the linear radio frequency power amplifier 22. Also the $V_{RAMP}$ signal may be generated from a detector coupled to the linear radio frequency power amplifier 22.

For example, the parallel amplifier circuit 14 includes the parallel amplifier output 32A that provides the parallel amplifier output voltage, $V_{PARA\_AMP}$, to the coupling circuit 18. The parallel amplifier output 32A sources a parallel amplifier circuit output current, $I_{PAWA\_OUT}$, to the coupling circuit 18. The parallel amplifier circuit 14, depicted in Figure 1A and Figure 1B, may provide a parallel amplifier circuit output current estimate 40, $I_{PAWA\_OUT\_EST}$, to the multi-level charge pump buck converter 12 as an estimate of the parallel amplifier circuit output current $I_{PAWA\_OUT}$, of the parallel amplifier circuit 14. Thus, the parallel amplifier circuit output current estimate 40, $I_{PAWA\_OUT\_EST}$, represents an estimate of the parallel amplifier circuit output current $I_{PAWA\_OUT}$, provided by the parallel amplifier circuit 14 as a feedback signal to the multi-level charge pump buck converter 12. Based on the parallel amplifier circuit output current estimate 40, $I_{PAWA\_OUT\_EST}$, the multi-level charge pump buck converter 12 may be configured to control the switching voltage, $V_{SW}$, provided at the switching voltage output 26 of the multi-level charge pump buck converter 12.

In some embodiments of the pseudo-envelope follower power management system 10A, depicted in Figure 1A, and the pseudo-envelope follower power management system 10B, depicted in Figure 1B, the coupling circuit 18 may be an offset capacitor, $C_{OFFSET}$. An offset voltage, $V_{OFFSET}$, may be developed across the coupling circuit 18. In other alternative embodiments, the coupling circuit 18 may be a wire trace such that the offset voltage, $V_{OFFSET}$, between the parallel amplifier output voltage, $V_{PARA\_AMP}$, and the power amplifier supply voltage output, $V_{CC}$, is zero volts. In still other embodiments, the coupling circuit may be a transformer.

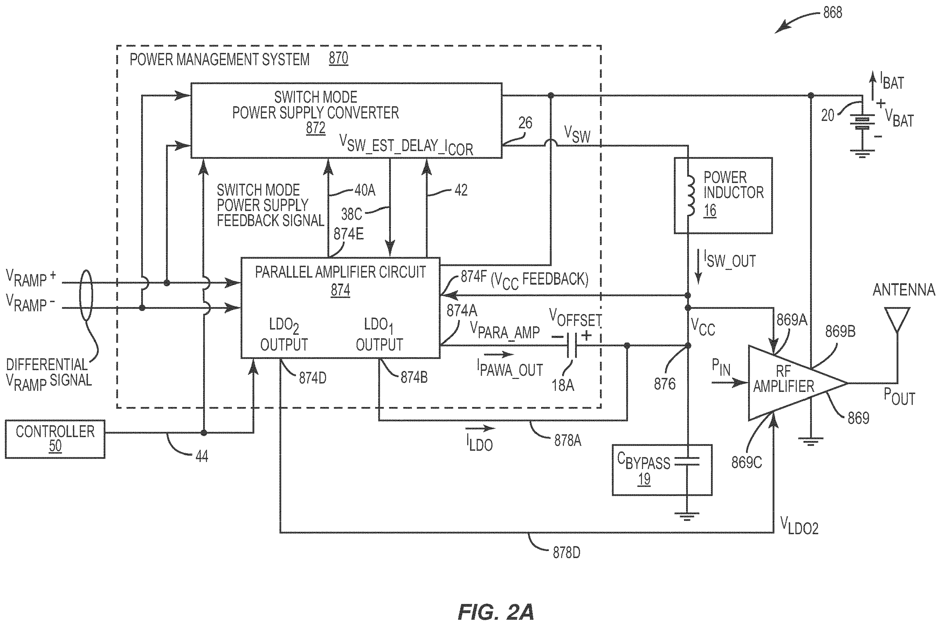

Figure 2A depicts a high level illustration of a pseudo-envelope tracking modulated power supply system 868 that may include a radio frequency power amplifier 869 configured to be powered by or under the control of a power management system 870. The power amplifier supply voltage, $V_{CC}$, may also be referred to as a modulated power supply voltage, $V_{CC}$, that is generated at a modulated power supply output 876.

Similar to other previously described switch mode power supply converters, multi-level charge pump buck converters, and parallel amplifier circuits, a switch mode power supply converter 872 and a parallel amplifier circuit 874 may be configured to receive an input supply voltage from a battery 20. The battery 20 may provide a supply voltage substantially equal to the battery voltage, $V_{BAT}$.

For the sake of simplicity of description, and not by way of limitation, the pseudo-envelope tracking modulated power supply system 868 may include a controller 50 coupled via a control bus 44 to the switch mode power supply converter 872 and the parallel amplifier circuit 874. The switch mode power supply converter 872 may be arranged to cooperatively operate with the parallel amplifier circuit 874 to form the power management system 870, which generates the modulated power supply voltage, $V_{CC}$, at the modulated power supply output 876. For example, in some embodiments, the controller 50 may configure the switch mode power supply converter 872 and the parallel amplifier circuit 874 to operate in various power level modulation modes, depending upon the expected output power to be generated by the radio frequency power amplifier 869 during a transmission of information. In some embodiments, the control functions described with respect to the controller 50 may be incorporated into a digital baseband modem or transceiver circuit that provides a differential $V_{RAMP}$ signal as a control signal to the power management system 870 based on a radio frequency input signal provided to the radio frequency power amplifier 869 for transmission.

The power management system 870 may be configured to receive a differential $V_{RAMP}$ signal having a non-inverted $V_{RAMP}$ signal component, $V_{RAMP}+$, and an inverted $V_{RAMP}$ signal component, $V_{RAMP}-$. In some alternative embodiments, the power management system 870 may be configured to receive a $V_{RAMP}$ signal that is a single ended $V_{RAMP}$ signal, a differential $V_{RAMP}$ signal, and/or both the single ended $V_{RAMP}$ signal and the differential $V_{RAMP}$ signal. The differential $V_{RAMP}$ signal may be provided as a control signal to govern generation of the modulated power supply voltage, $V_{CC}$. Illustratively, the switch mode power supply converter 872 and the parallel amplifier circuit 874 may each be configured to receive the differential $V_{RAMP}$ signal.

The switch mode power supply converter 872 may include the switching voltage output 26 in communication with the modulated power supply output 876. A power inductor 16 may be coupled between the switching voltage output 26 and the modulated power supply output 876.

The parallel amplifier circuit 874 may include a parallel amplifier circuit output 874A in communication with the modulated power supply output 876. Illustratively, in some embodiments, a coupling capacitor 18A is coupled between the modulated power supply output 876 and the parallel amplifier circuit output 874A. In addition, the parallel amplifier circuit 874 may also include a first linear regulator output 874B, $LDO_1$ OUTPUT, in communication with the modulated power supply output 876. In some power level modulation modes, the power management system 870 may configure the first linear regulator output 874B, $LDO_1$ OUTPUT, to provide a high impedance path with respect to ground. In other power level modulation modes, the power management system 870 may configure the first linear regulator output 874B, $LDO_1$ OUTPUT, to apply a first linear regulator output current 878A, $I_{LDO}$, to the modulated power supply output 876 to regulate the modulated power supply voltage, $V_{CC}$.

The parallel amplifier circuit 874 may also include a second linear regulator output 874D, $LDO_2$ OUTPUT, in communication with a CMOS logic supply input 869C. In some power level modulation modes, the power management system 870 may configure the second linear regulator output 874D, $LDO_2$ OUTPUT, to provide a second linear regulator output voltage, $V_{LDO2}$, to the CMOS logic supply input 869C as a function of the battery voltage, $V_{BAT}$. As an example, the CMOS logic supply input 869C may include a minimum CMOS logic supply voltage threshold. Accordingly, the power management system 870 may configure the second linear regulator output 874D, $LDO_2$ OUTPUT, to provide a second linear regulator output voltage, $V_{LDO2}$, to the CMOS logic supply input 869C that is at least equal to the minimum CMOS logic supply voltage threshold.

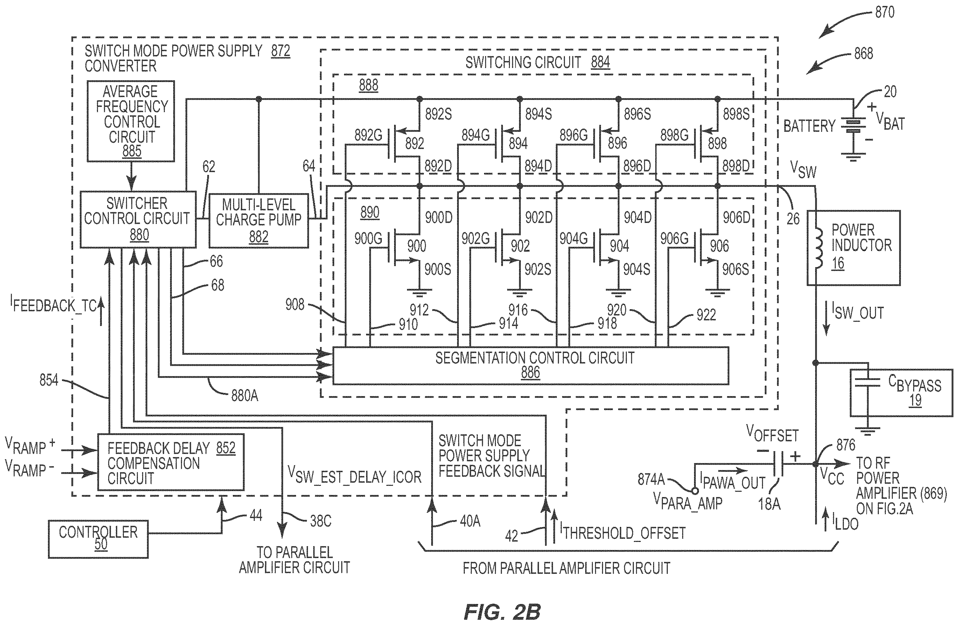

The parallel amplifier circuit 874 may also include a switch mode power supply converter control output 874E configured to output a switch mode power supply feedback signal 40A to the switch mode power supply converter 872, depicted in Figures 2B. In addition, the parallel amplifier circuit 874 may provide a threshold offset current 42, $I_{THRESHOLD\_OFFSET}$, to the switch mode power supply converter 872. The parallel amplifier circuit 874 may receive the modulated power supply voltage, $V_{CC}$, from the modulated power supply output 876 at a modulated power supply voltage feedback input 874F. The parallel amplifier circuit 874 may use the input to the modulated power supply voltage feedback input 874F as a feedback signal to regulate the modulated power supply voltage, $V_{CC}$.

In some embodiments, the radio frequency power amplifier 869 may be a linear radio frequency power amplifier. The radio frequency power amplifier 869 may include a radio frequency power amplifier input configured to receive a modulated radio frequency input signal from a digital baseband processing portion of the transceiver or modem, where the modulated radio frequency input signal has an input power, $P_{IN}$. In addition, the radio frequency power amplifier 869 may also include a radio frequency power amplifier output in communication with an antenna via the radio frequency duplexer and switch (not shown). The radio frequency power amplifier 869 may generate an amplified modulated radio frequency output signal having an output power $P_{OUT}$ at the radio frequency power amplifier output.

In some embodiments, the radio frequency power amplifier 869 may include a collector voltage supply input 869A configured to receive the modulated power supply voltage, $V_{CC}$, from the modulated power supply output 876. The radio frequency power amplifier 869 may further include a battery voltage supply input 869B configured to receive the battery voltage, $V_{BAT}$, from the battery 20. The radio frequency power amplifier 869 may also include a CMOS logic supply input 869C configured to receive a second linear regulator output voltage, $V_{LDO2}$.

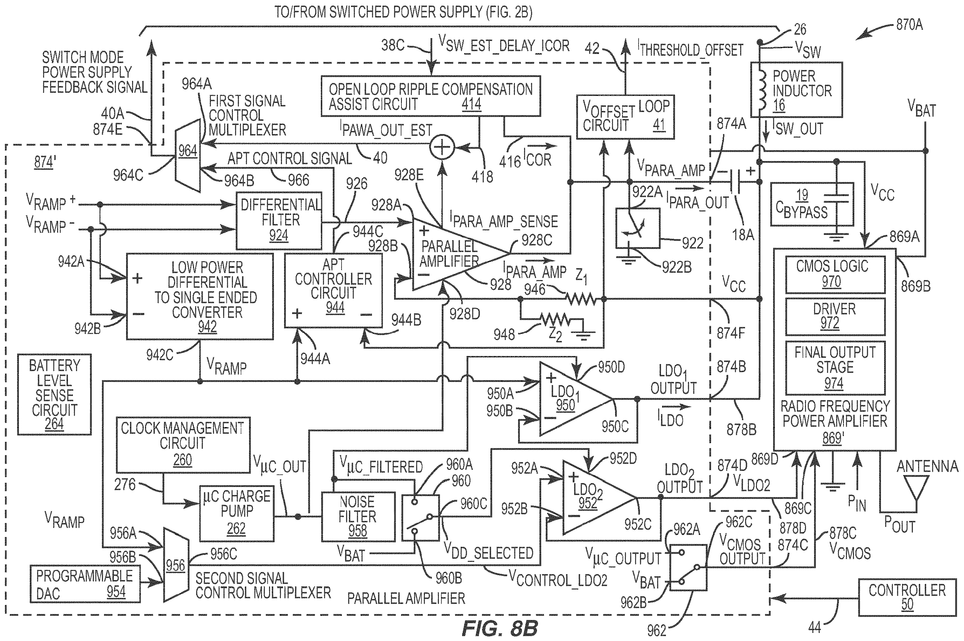

Another example embodiment of the radio frequency power amplifier 869 is the radio frequency power amplifier 869' depicted in Figure 8B. Figure 8B depicts that the radio frequency power amplifier 869' includes CMOS logic 869E, a driver 869F, and a final output stage 869G. In some embodiments, the driver supply voltage input 869D may have a minimum driver supply voltage that is a function of the output power to be generated by the radio frequency power amplifier 869'. For example, the driver 869F may have a minimum driver supply voltage threshold that is based on a relationship between a minimum driver supply voltage and the output power $P_{OUT}$ generated by the radio frequency power amplifier 869'. In some embodiments, the minimum driver supply voltage threshold may be further dependent on the input power $P_{IN}$ or drive level of the radio frequency input signal provide to the radio frequency power amplifier 869' for transmission.

Similar to the radio frequency power amplifier 869, the radio frequency power amplifier 869' may include a collector voltage supply input 869A configured to receive the modulated power supply voltage, $V_{CC}$, a battery voltage supply input 869B configured to receive the battery voltage, $V_{BAT}$, a CMOS logic supply input 869C configured to receive a CMOS logic supply voltage 878C, $V_{CMOS}$, and a driver supply voltage input 869D configured to receive the second linear regulator output voltage, $V_{LDO2}$.

Returning to Figure 2A with continuing reference to Figure 8B, in some embodiments, the radio frequency power amplifier 869 may be configured to selectively provide either the battery voltage, $V_{BAT}$, received at the battery voltage supply input, 869B, or the second linear regulator output voltage, $V_{LDO2}$, received at the CMOS logic supply input 869C to power the CMOS logic 869E as a function of the battery voltage and the minimum CMOS logic supply voltage threshold. For example, in the case where the battery voltage, $V_{BAT}$, is above the minimum CMOS logic supply voltage threshold, the radio frequency power amplifier 869 supplies the battery voltage, $V_{BAT}$, to the CMOS logic 869E. In the cases where the battery voltage, $V_{BAT}$, falls below the minimum CMOS logic supply voltage threshold, the radio frequency power amplifier 869 configures the CMOS logic 869E to be powered from the CMOS logic supply input 869C.

In some embodiments of the power management system 870, the power management system 870 may be configured to operate in various power level modulation modes based on an expected output power to be generated by the radio frequency power amplifier 869 during a data transmission. In addition, the power management system 870 may be reconfigured prior to each data transmission to minimize the energy drawn from the battery 20 during the data transmission. For example, some embodiments of the power management system 870 may be configured to operate in one of many power level modulation modes on a data transmission slot by data transmission slot basis.

As a non-limiting list of example power level modulation modes of operation, the power management system 870 may be configured to operate in a set of power level modulation modes including a high power modulation mode, a medium power modulation mode, and low power modulation mode. As another example, in other embodiments, the power management system 870 may be configured to operate in a set of power level modulation modes including a high power modulation mode, a medium power modulation mode, a medium power average power tracking modulation modes, and a low power average power tracking modulation mode.

As a further example, in a slow tracking mode of operation, the power management system 870 may disable the switch mode power supply converter 872, and configure the parallel amplifier circuit 874 to track an envelope of a modulated radio frequency input signal to be transmitted by the radio frequency power amplifier 869 as a function of a slowly modulated or unmodulated differential $V_{RAMP}$ signal. In the no tracking mode of operation, the power management system 870 may further configure the parallel amplifier circuit 874 to provide a modulated power supply voltage, $V_{CC}$, based on a substantially unmodulated differential $V_{RAMP}$ signal. In the no tracking mode, the power management system 870 may be configured to generate a modulated power supply voltage, $V_{CC}$ that has a substantially fixed voltage level. In the slow tracking mode of operation, the parallel amplifier circuit 874 may be configured to slowly track the envelope of the differential $V_{RAMP}$ signal.

To minimize energy consumed from the battery during a data transmission, the power management system 870 may enable and disable various elements and signal processing functions of the switch mode power supply converter 872 and the parallel amplifier circuit 874 as a function of the power level modulation mode of operation. In some embodiments, the power management system 870 may disable the least energy efficient element and signal processing functions as a function of the expected output power to be generated by the radio frequency power amplifier 869. For example, the power management system 870 may disable portions of the switch mode power supply converter 872, the parallel amplifier circuit 874, and/or a combination thereof as the expected output power of the radio frequency power amplifier 869 decreases to achieve an overall decrease in energy consumption from the battery 20 during a data transmission. In addition, some embodiments of the power management system 870 may generate the modulated power supply output 876 using a less energy efficient device or power generation circuit in response to an expected output power of the radio frequency power amplifier 869 falling below a low power modulation mode threshold in order to disable other energy consuming circuitry and achieve an overall reduction in energy drawn from the battery 20 during a data transmission.

As a non-limiting example, in some embodiments of the high power level modulation mode and the medium power modulation mode, the power management system 870 may configure the switch mode power supply converter 872 and the parallel amplifier circuit 874 to generate the modulated power supply voltage, $V_{CC}$, based on the differential $V_{RAMP}$ signal as a function of the expected output power to be generated by the radio frequency power amplifier 869 during the data transmission. As an example, in some embodiments of the high power modulation mode and the medium power modulation mode, the parallel amplifier circuit 874 may be configured to govern the operation of the switch mode power supply converter 872, regulate generation of the modulated power supply voltage, $V_{CC}$, as a function of the differential $V_{RAMP}$ signal, and regulate the offset voltage, $V_{OFFSET}$, across the coupling capacitor 18A.

As an example, the parallel amplifier circuit 874 may be configured to apply a parallel amplifier circuit output current, $I_{PAWA\_OUT}$, from the parallel amplifier circuit 874 to regulate the modulated power supply voltage, $V_{CC}$, as a function of the differential $V_{RAMP}$ signal. The parallel amplifier circuit 874 may provide the switch mode power supply feedback signal 40A and a threshold offset current 42, $I_{THRESHOLD\_OFFSET}$, to govern the operation of the switch mode power supply converter 872 and regulate the offset voltage, $V_{OFFSET}$, across the coupling capacitor 18A. In response to the switch mode power supply feedback signal 40A and the threshold offset current 42, $I_{THRESHOLD\_OFFSET}$, and the differential $V_{RAMP}$ signal, the switch mode power supply converter 872 may generate the switching voltage, $V_{SW}$, at the switching voltage output 26, and provide a delayed $I_{COR}$ estimated switching voltage output 38C, $V_{SW\_EST\_DELAY\_ICOR}$, to the parallel amplifier circuit 874. In addition, the parallel amplifier circuit 874 may configure the first linear regulator output 874B, $LDO_1$ OUTPUT, to provide a high impedance path to ground. Depending on the battery voltage, $V_{BAT}$, the parallel amplifier circuit 874 may configure the second linear regulator output 874D, $LDO_2$ OUTPUT, to provide the second linear regulator output voltage, $V_{LDO2}$, at least equal to the minimum CMOS logic supply voltage to the CMOS logic supply input 869C of the radio frequency power amplifier 869.

As another non-limiting example, in some embodiments of the low power modulation mode, the power management system 870 may disable the switch mode power supply converter 872 and configure the switching voltage output 26 to provide a high impedance path to ground. In addition, the parallel amplifier circuit output 874A may be configured to provide a low impedance path to ground to short the negative terminal of the coupling capacitor 18A to ground.

To generate the modulated power supply voltage, $V_{CC}$, the first linear regulator output 874B, $LDO_1$ OUTPUT, may be configured to apply a linear regulator output current, $I_{LDO}$, to the modulated power supply output 876 as a function of the differential $V_{RAMP}$ signal and a selected tracking mode of operation. The differential $V_{RAMP}$ signal may be substantially constant or only slowly modulated during the data transmission. In the case where the differential $V_{RAMP}$ signal is substantially constant, the power management system 870 may configure the parallel amplifier circuit 874 to operate in a no tracking mode of operation. In the no tracking mode of operation, the first linear regulator output 874B, $LDO_1$ OUTPUT, may regulate the modulated power supply voltage, $V_{CC}$, to be substantially constant or unmodulated during data transmission. Alternatively, in the case where the differential $V_{RAMP}$ signal slowly changes relative to the envelope of the radio frequency input signal provided to the radio frequency power amplifier 869, the power management system 870 may configure the first linear regulator output 874B, $LDO_1$ OUTPUT, to slowly track the differential $V_{RAMP}$ signal during the data transmission.

In some embodiments of the low power modulation mode, the parallel amplifier circuit 874 may disable the second linear regulator output 874D, $LDO_2$ OUTPUT. In some alternative embodiments of the low power modulation mode, the parallel amplifier circuit 874 may configure the second linear regulator output 874D, $LDO_2$ OUTPUT, to selectively output the second linear regulator output voltage, $V_{LDO2}$, to the CMOS logic supply input 869C as a function of the battery voltage, $V_{BAT}$.

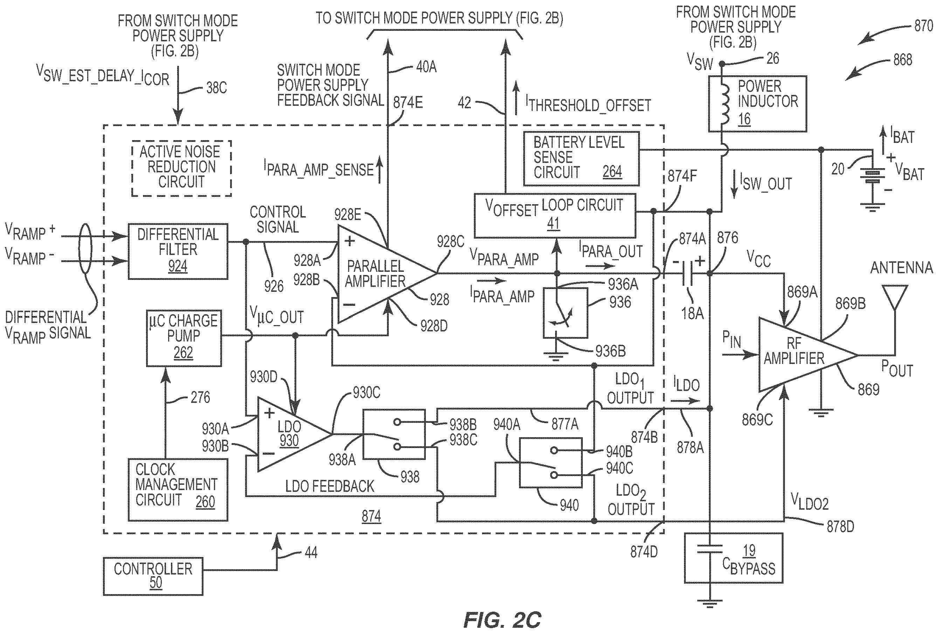

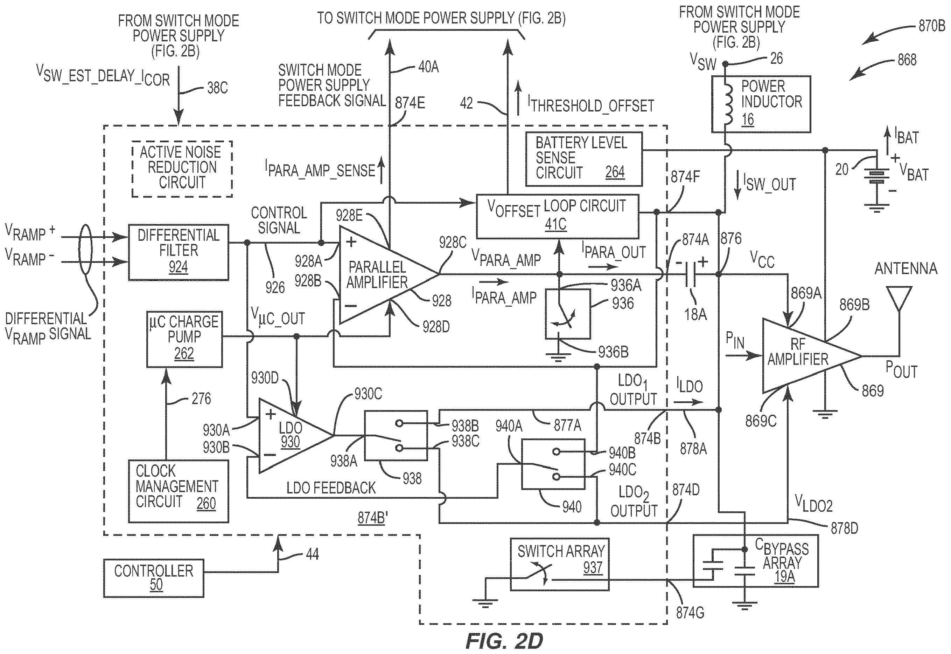

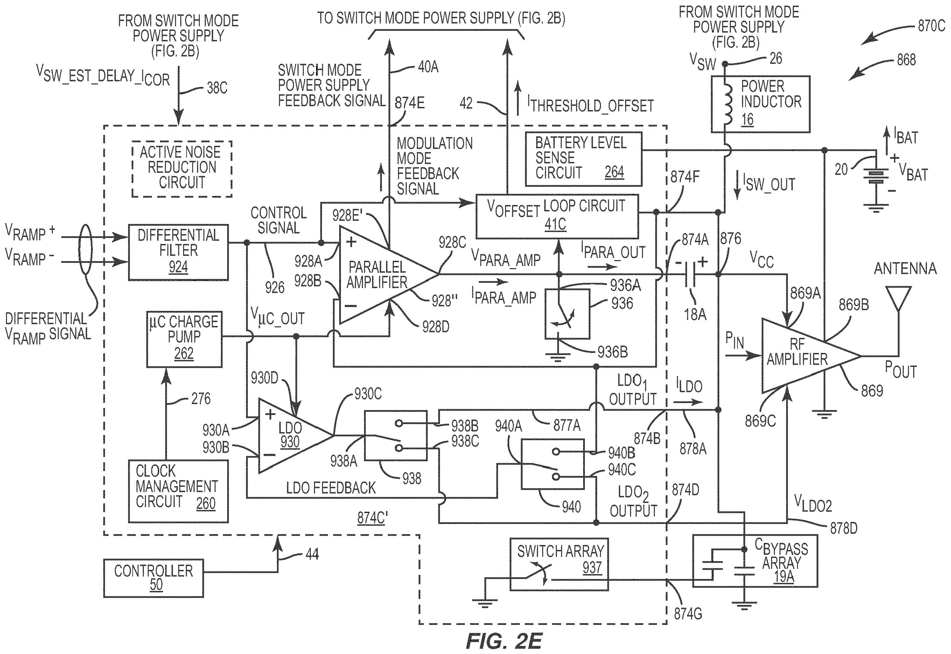

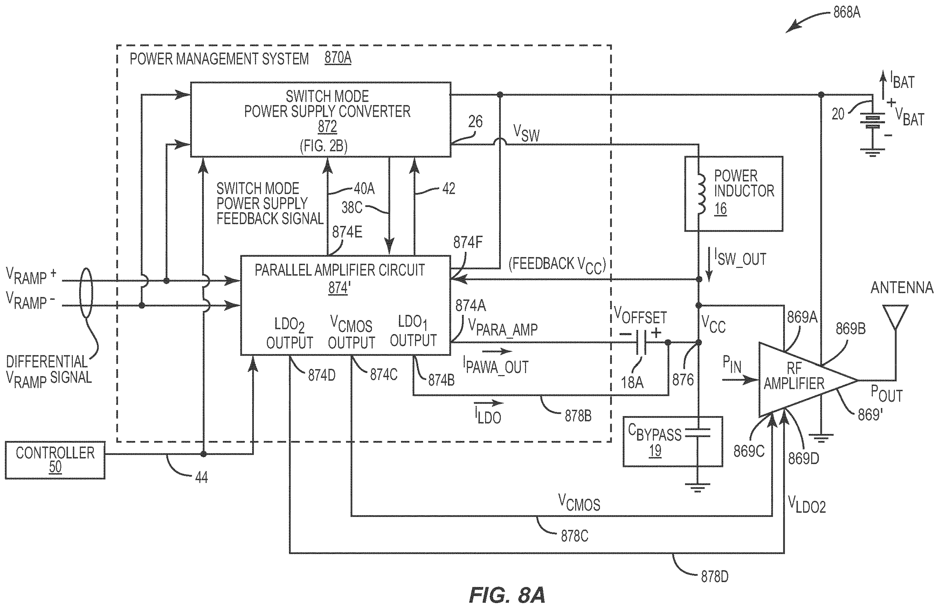

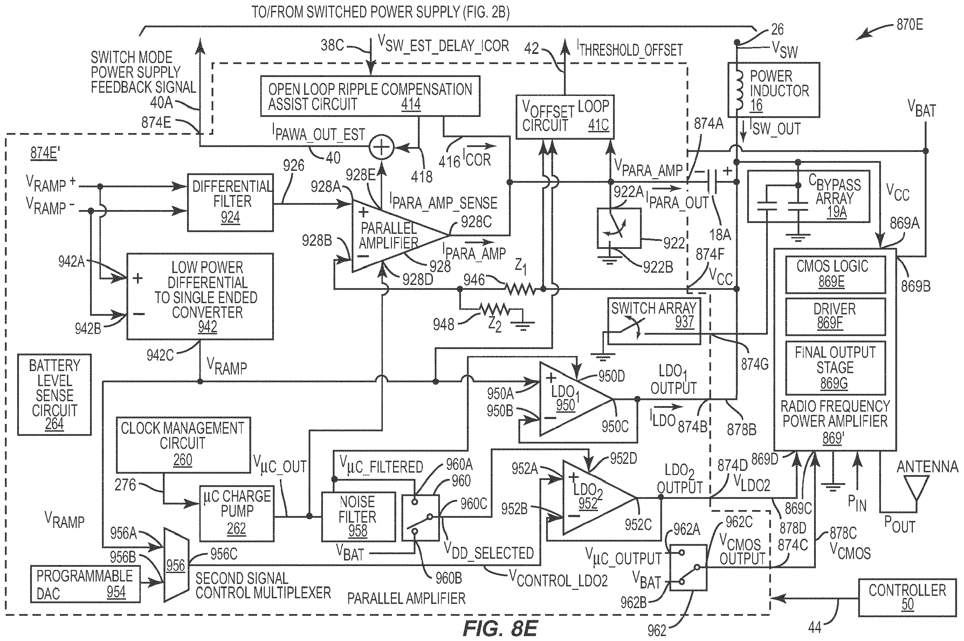

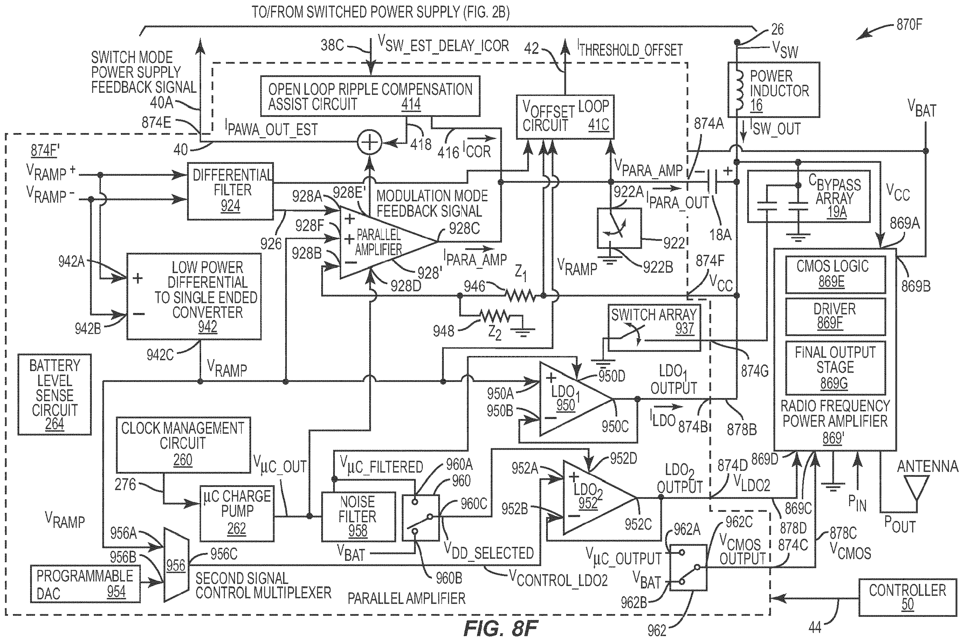

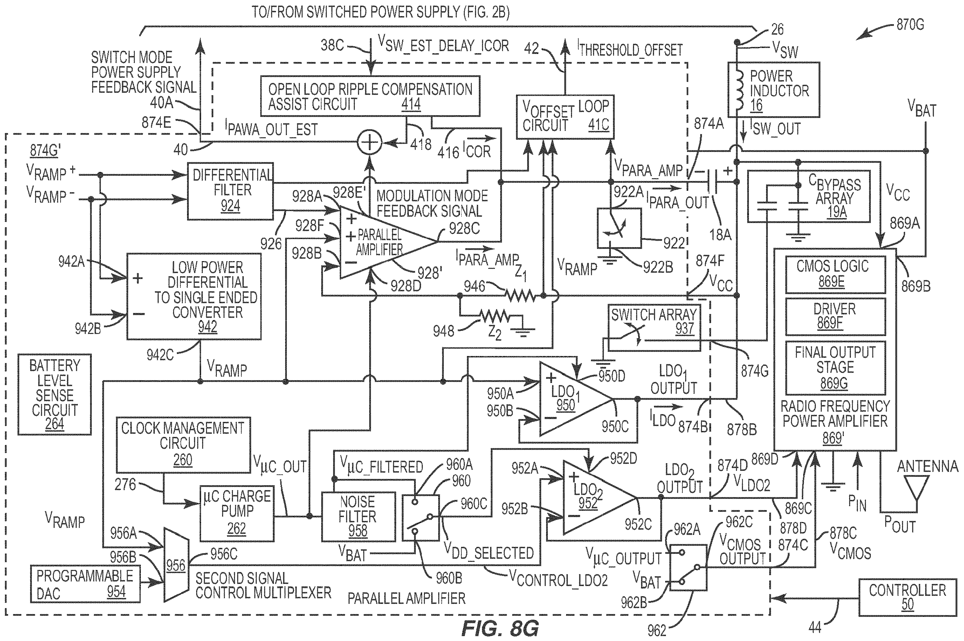

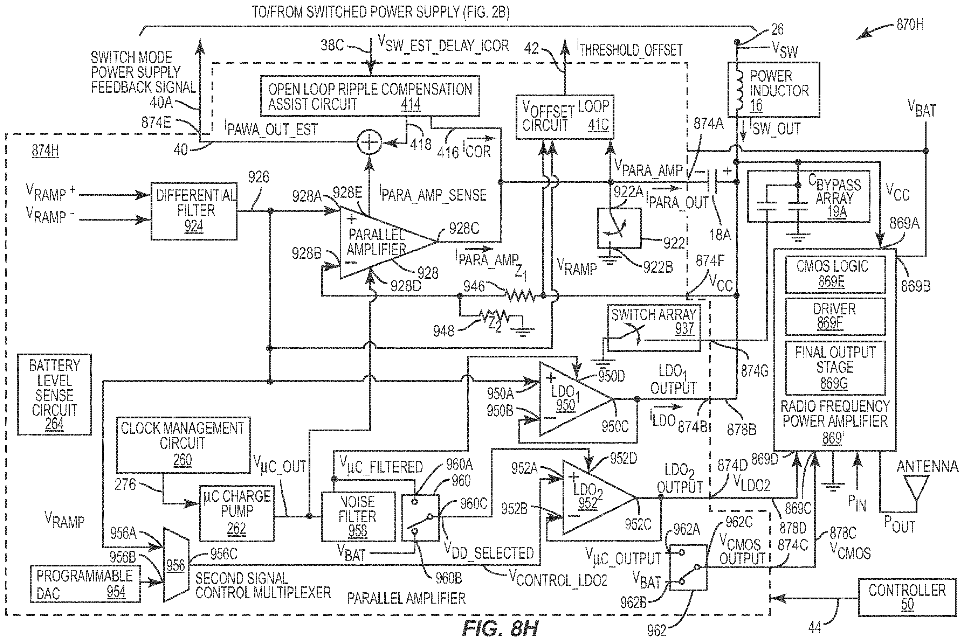

Figure 2B depicts a non-limiting example of the embodiments of the switch mode power supply converter 872 that may be selectively configured to operate in a number of various buck converter modes, a number of various envelope tracking modes, a number of various average power tracking modes, and/or a combination thereof as a function of an expected output power to be generated by the radio frequency power amplifiers 869 and 869', depicted Figures 2A, 2C-E, and 8A-H. The switch mode power supply converter 872 may further include an off mode. The various embodiments of the switch mode power supply converter 872 are described with continuing reference to the various embodiments of the power management system 870, depicted in Figures 2A-C, the power management system 870A, depicted in Figures 8A-C, the power management system 870B and parallel amplifier circuit 874B', depicted in Figure 2D, the power management system 870C and parallel amplifier circuit 874C', depicted in Figure 2E, the power management system 870E and parallel amplifier circuit 874E', depicted in Figure 8E, power management system 870F and parallel amplifier circuit 874F', depicted in Figure 8F, the power management system 870G and parallel amplifier circuit 874G', depicted in Figure 8G, and the power management system 870H and parallel amplifier circuit 874H', depicted in Figure 8H.

As an example, the various envelope tracking modes may include one or more envelope tracking power modes of operation including the high power modulation mode and the medium power modulation mode. As another example, the various average power tracking modes may include one or more average power tracking modes of operation including a medium power average power tracking mode. The controller 50 may configure the switch mode power supply converter 872 to operate in the medium power average power tracking mode when the power management systems 870, 870A-C, and 870E-H are configured to operate in a medium power average power tracking modulation mode. The controller 50 may configure the switch mode power supply converter 872 to be in a high power mode when the power management systems 870, 870A-C, and 870E-H are configured to operate in the high power modulation mode. The controller 50 may configure the switch mode power supply converter 872 to be in a medium power mode when the power management systems 870, 870A-C, and 870E-H are configured to operate in the medium power modulation mode. The controller 50 may configure the switch mode power supply converter 872 to be in an off mode when the power management systems 870, 870A-C, and 870E-H are configured to operate in either a low power modulation mode or a low power average power tracking mode.

The switch mode power supply converter 872 may include embodiments of a switcher control circuit 880, a multi-level charge pump 882, a switching circuit 884, and an average frequency control circuit 885. The switcher control circuit 880, the multi-level charge pump 882, the switching circuit 884, and a feedback delay compensation circuit 852 may be configured to receive the battery voltage, $V_{BAT}$. Some embodiments of the switch mode power supply converter 872 may further include the feedback delay compensation circuit 852. The controller 50 may configure the switcher control circuit 880 to govern the operation of the multi-level charge pump 882 and the switching circuit 884 as a function of the power level modulation mode and the expected output power to be generated by the embodiments of the radio frequency power amplifiers 869 and 869' in response to a modulated radio frequency input signal to be transmitted. In some embodiments, the switcher control circuit 880 may also be configured to control the operation of the feedback delay compensation circuit 852 as a function of the power level modulation mode and the expected output power of the radio frequency power amplifiers 869 and 869'. In addition, in some embodiments, the feedback delay compensation circuit 852 may generate a feedback delay compensation signal 854, $I_{FEEDBACK\_TC}$, as a function of the power level modulation mode and the expected output power of the radio frequency power amplifiers 869 and 869'.

As a non-limiting example, in the high power mode of operation, the controller 50 or the switcher control circuit 880 may configure the feedback delay compensation circuit 852 to operate as a function of a high power mode apparent gain to increase the aggressiveness of the feedback compensation provided by the feedback delay compensation signal 854, $I_{FEEDBACK\_TC}$. As the apparent gain of the feedback delay compensation circuit 852 is increased, the switch mode power supply converter 872 may respond to a change in the target voltage for the modulated power supply voltage, $V_{CC}$, provided by the differential $V_{RAMP}$ signal, which may increase the power efficiency of the various embodiments of a parallel amplifier 928, depicted in Figures 2C-D and Figures 8B, 8E, and 8H, the parallel amplifier 928', depicted in Figures 8F-G, the parallel amplifier 928", depicted in Figure 2E.

In the medium power mode of operation, the controller 50 or the switcher control circuit 880 may configure the feedback delay compensation circuit 852 to operate as a function of a medium power mode apparent gain to decrease the aggressiveness of the feedback compensation provided by the feedback delay compensation signal 854, $I_{FEEDBACK\_TC}$, in order to prevent the switcher control circuit 880 from pre-maturely changing the switching voltage, $V_{SW}$. The feedback delay compensation circuit 852 may operate in an overly aggressive manner when the apparent gain is set too high with respect to the expected output power to be generated by the radio frequency power amplifier 869 or 869' during a data transmission. Over aggressiveness of feedback compensation provided by the feedback delay compensation circuit 852 may result in pre-mature changes in the switching voltage, $V_{SW}$, because the switch mode power supply converter 872 may overreact to a change in the target voltage for the modulated power supply voltage, $V_{CC}$, provided by the differential $V_{RAMP}$ signal. As a result, the switch mode power supply converter 872 may generate a switching voltage that provides too much or too little energy to the modulated power supply voltage $V_{CC}$, which may decrease the power efficiency of the various embodiments of the parallel amplifier 928, depicted in Figures 2C-D and Figures 8B, 8E, and 8H, the parallel amplifier 928', depicted in Figures 8F-G, the parallel amplifier 928", depicted in Figure 2E.

In some embodiments of the medium power mode, the controller 50 may set the apparent gain of the feedback delay compensation circuit 852 based on a sliding scale as a function of the expected output power to be generated by the radio frequency power amplifier 869 or 869' during the data transmission. As an alternative example, some embodiments of the switcher control circuit 880 may be further configured to adjust the apparent gain of the feedback delay compensation circuit 852 based on a segmentation mode of the switching circuit 884. In some embodiments, the controller 50 or the switcher control circuit 880 may disable the feedback delay compensation circuit 852 during the average power tracking mode and during the off mode. For example, referring briefly to Figures 8A-B, some embodiments of the power management system 870A may disable the feedback delay compensation circuit 852 during a medium power average power tracking mode and during a low power average power tracking modulation mode. Similarly, referring briefly to referring briefly to Figures 2A-C and Figures 8A-B, some embodiments of the power manage system 870 and power management system 870A may disable the feedback delay compensation circuit 852 in a low power modulation mode, and enable the feedback delay compensation circuit 852 in a high power modulation mode and a medium power modulation mode.

The switcher control circuit 880 may be configured to operate in the average power tracking mode in response to the power management systems 870A-C and 870E-H being configured to operate in the medium power average power tracking modulation mode. In the off mode, the switcher control circuit 880 may disable the multi-level charge pump 882 and the switching circuit 884, and configure the switching voltage output 26 to provide a high impedance path to ground. In the off mode, the switch mode power supply converter 872 may be configured to disable a clocking signal that may be used by the $\mu$C charge pump circuit 262, depicted in Figure 2C, Figure 8B, and Figures 8E-H.

In a buck converter "bang-bang" mode of operation, the switcher control circuit 880 may disable the multi-level charge pump 882, and control the switching circuit 884 to swing the switching voltage, $V_{SW}$, between the battery voltage, $V_{BAT}$, and ground. In the multi-level charge pump buck converter mode, the switcher control circuit 880 may enable both the multi-level charge pump 882 and the switching circuit 884. The switcher control circuit 880 may further control the multi-level charge pump 882 and the switching circuit 884 to generate both buck level voltages and boost level voltages to provide the switching voltage, $V_{SW}$, at the switching voltage output 26 as a function of the operational state of the switcher control circuit 880 and the power level modulation mode.

In the medium power average power tracking mode of operation, the switcher control circuit 880 may be configured to operate in a number of average power tracking "bang-bang" modes of operation. As an example, in some embodiments of an average power tracking "bang-bang" mode of operation, the switcher control circuit 880 may configure the multi-level charge pump 882 and the switching circuit 884 to switch the switching voltage, $V_{SW}$, between only a first bang-bang switching voltage, $V_{SW\_BB1}$, and a second bang-bang switching voltage, $V_{SW\_BB2}$, during a data transmission, where the first bang-bang switching voltage, $V_{SW\_BB1}$, is less than the second bang-bang switching voltage, $V_{SW\_BB2}$.

Unlike a buck converter mode of operation in which the switching voltage $V_{SW}$ swings between ground and the battery supply, $V_{BAT}$, the first bang-bang switching voltage, $V_{SW\_BB1}$, may be substantially equal to ground, the battery voltage, $V_{BAT}$, or the switching voltage $V_{SW}$ between ground and the battery voltage, $V_{BAT}$. The second bang-bang switching voltage, $V_{SW\_BB2}$, may be substantially equal to the supply voltage, $V_{BAT}$, or a charge pump output voltage generated by the multi-level charge pump 882 from the battery voltage, $V_{BAT}$. The average power tracking "bang-bang" modes of operation may include an average power tracking "buck-buck" mode of operation and an average power tracking "buck-boost" mode of operation.

In the average power tracking "buck-buck" mode of operation, the switcher control circuit 880 may configure the multi-level charge pump 882 and the switching circuit 884 to generate a first bang-bang switching voltage, $V_{SW\_BB1}$, and a second bang-bang switching voltage, $V_{SW\_BB2}$, that are no greater than the battery voltage, $V_{BAT}$. For example, the switcher control circuit 880 may configure the multi-level charge pump 882 to generate only a bucked output voltage at a charge pump output 64. As an example, the switcher control circuit may configure the multi-level charge pump 882 to generate a first buck mode output voltage, $V_{FIRST\_BUCK}$, substantially equal to $1/2 \times V_{BAT}$ in a first buck mode of operation. In the average power tracking "buck-buck" mode, the switcher control circuit 880 may disable the multi-level charge pump 882 provided the first bang-bang switching voltage, $V_{SW\_BB1}$, and the second bang-bang switching voltage, $V_{SW\_BB2}$, are a shunt mode output voltage substantially equal to ground and a series mode output voltage substantially equal to $V_{BAT}$, respectively.

In the average power tracking "buck-boost" mode, the first bang-bang switching voltage, $V_{SW\_BB1}$, may be no greater than the battery voltage, $V_{BAT}$, and the second bang-bang switching voltage, $V_{SW\_BB2}$, is a boost voltage that is greater than the battery voltage, $V_{BAT}$. In the average power tracking "buck-boost" mode, the switcher control circuit 880 may configure the multi-level charge pump 882 and the switching circuit 884 to generate the first bang-bang switching voltage, $V_{SW\_BB1}$. The switcher control circuit 880 may configure the multi-level charge pump 882 to generate the second bang-bang switching voltage, $V_{SW\_BB2}$. A further description of the average power tracking "bang-bang" modes of operation is provided below.

The switcher control circuit 880 may receive a feedback delay compensation signal 854, $I_{FEEDBACK\_TC}$, from a feedback delay compensation circuit 852 and a switch mode power supply feedback signal 40A from the parallel amplifier circuit 874. The switcher control circuit 880 may also receive the threshold offset current 42, $I_{THRESHOLD\_OFFSET}$, from the $V_{OFFSET}$ loop circuit 41, depicted in Figure 2C and Figure 8B, or the $V_{OFFSET}$ loop circuit 41C, depicted in Figures 2D-E and Figures 8E-H.

Some embodiments of the switcher control circuit 880 may be configured to form a composite control signal as a function of the various envelope tracking modes, the various average power tracking modes, and buck converter modes. As an example, the various embodiments of the switcher control circuit 880 may combine the various fractional amounts and combinations of the feedback delay compensation signal 854, $I_{FEEDBACK\_TC}$, the switch mode power supply feedback signal 40A, and the threshold offset current 42, $I_{THRESHOLD\_OFFSET}$, to form one or more composite control signals as a function of the power level modulation mode. In some embodiments, the composite control signal may depend on the power level modulation mode.

Depending on the power level modulation mode the expected output power to be generated by the radio frequency power amplifiers 869 and 869', and/or a combination thereof, the switcher control circuit 880 may compare the one or more composite control signals to one or more threshold levels to set an operational state of the switcher control circuit 880. In some embodiments, the level of contribution of the feedback delay compensation signal 854, $I_{FEEDBACK\_TC}$, the switch mode power supply feedback signal 40A, and the threshold offset current 42, $I_{THRESHOLD\_OFFSET}$, to form the composite control signal may depend on the power level modulation mode. Also, as described below, in some embodiments of the power management system 870, depicted in Figures 2A-C, the power management system 870A, depicted in Figures 8A-B, the power management system 870B and parallel amplifier circuit 874B', depicted in Figure 2D, the power management system 870C and parallel amplifier circuit 874C', depicted in Figure 2E, the power management system 870E and parallel amplifier circuit 874E', depicted in Figure 8E, power management system 870F and parallel amplifier circuit 874F', depicted in Figure 8F, the power management system 870G and parallel amplifier circuit 874G', depicted in Figure 8G, and the power management system 870H and parallel amplifier circuit 874H', depicted in Figure 8H, the generation of the switch mode power supply feedback signal 40A, the threshold offset current 42, $I_{THRESHOLD\_OFFSET}$, and/or a combination thereof may depend on the power level modulation mode in which each of the embodiments of the power management systems 870 and 870A-H are configured to operate.

As an example, Figure 2C depicts an embodiment of the power management system 870 in which the parallel amplifier 928 may generate the switch mode power supply feedback signal 40A in the high power modulation mode and the low power modulation mode. In addition, the $V_{OFFSET}$ loop circuit 41 may generate the threshold offset current 42, $I_{THRESHOLD\_OFFSET}$, in the high power modulation mode and the medium power modulation mode.

As an example, Figure 2D depicts an embodiment of the power management system 870B in which the parallel amplifier 928 may generate the switch mode power supply feedback signal 40A in the high power modulation mode and the low power modulation mode. In addition, the $V_{OFFSET}$ loop circuit 41C may generate the threshold offset current 42, $I_{THRESHOLD}$, in the high power modulation mode, the low power modulation mode, and the medium power average power tracking modulation mode.

As a further example, Figure 2E depicts an embodiment of the power management system 870C in which a parallel amplifier 928" may generate the switch mode power supply feedback signal 40A in the high power modulation mode, the low power modulation mode, and the medium power average power tracking modulation mode. In addition, the $V_{OFFSET}$ loop circuit 41C may generate the threshold offset current 42, $I_{THRESHOLD\_OFFSET}$, in the high power modulation mode, the low power modulation mode, and the medium power average power tracking modulation mode. In some embodiments, the power management system 870C may disable one of the parallel amplifier 928" and the $V_{OFFSET}$ loop circuit 41C as a function of the average some average power tracking "bang-bang" mode of operation.

As an example, Figure 8B depicts an embodiment of the power management system 870A in which the parallel amplifier 928 may generate the switch mode power supply feedback signal 40A in the high power modulation mode and the medium power modulation mode. In addition, the $V_{OFFSET}$ loop circuit 41 may generate the threshold offset current 42, $I_{THRESHOLD\_OFFSET}$, in the high power modulation mode and the medium power modulation mode. And the average power tracking controller 44 may generate an average power tracking control signal 966, which is provided as the switch mode power supply feedback signal 40A in the medium power average power tracking modulation mode.

Advantageously, the power management system 870C may form the composite control signal to obtain the benefits associated with each of the various embodiments of the parallel amplifier 928" and the $V_{OFFSET}$ loop circuit 41C. As an example, in the medium power average power tracking modulation mode, some embodiments of the parallel amplifier 928" may generate a modulation mode feedback signal that provides an indication of an instantaneous error voltage between the $V_{RAMP}$ signal and the modulated power supply voltage, $V_{CC}$. In contrast, in the medium power average power tracking modulation mode, some embodiments of the $V_{OFFSET}$ threshold circuit 41C may generate the threshold offset current 42, $I_{THRESHOLD\_OFFSET}$, to provide an indication of a weighted error voltage between the $V_{RAMP}$ signal and the modulated power supply voltage, $V_{CC}$. The weighted error voltage signal includes an instantaneous error voltage component and an average error voltage component. Some embodiments of the $V_{OFFSET}$ threshold circuit 41C may be further configured to generate a threshold offset current 42, $I_{THRESHOLD\_OFFSET}$, to provide a composite control signal to the switcher control circuit 880 that is substantially equivalent to the modulation mode feedback signal generated by the parallel amplifier 928" in the medium power average power tracking mode.

As another example, Figure 8E depicts an embodiment of the power management system 870E in which a parallel amplifier circuit output current estimate 40, $I_{PAWA\_OUT\_EST}$, is provided as the switch mode power supply feedback signal 40A in the high power modulation mode and the low power modulation mode. In addition, the $V_{OFFSET}$ loop circuit 41C may generate the threshold offset current 42, $I_{THRESHOLD\_OFFSET}$, in the high power modulation mode, the medium power modulation mode, and the medium power average power tracking modulation mode.

As a further example, Figure 8F depicts an embodiment of the power management system 870F in which a parallel amplifier 928' may generate the switch mode power supply feedback signal 40A in the high power modulation mode, the low power modulation mode, and the medium power average power tracking modulation mode. In addition, the $V_{OFFSET}$ loop circuit 41C may generate the threshold offset current 42, $I_{THRESHOLD\_OFFSET}$, in the high power modulation mode, the low power modulation mode, and the medium power average power tracking modulation mode. Because the open loop ripple compensation circuit 414 is disabled in the medium power average power tracking mode, the parallel amplifier circuit output current estimate 40, $I_{PAWA\_OUT\_EST}$, provided as the switch mode power supply feedback signal 40A only includes the modulation mode feedback signal generated by the parallel amplifier 928' in the medium power average power tracking modulation mode.

As another example, Figure 8G depicts an embodiment of the power management system 870G that is similar to the power management system 870F except the parallel amplifier 928" may generate the switch mode power supply feedback signal 40A in the high power modulation mode, the low power modulation mode, and the medium power average power tracking modulation mode.

As a further example, Figure 8H depicts an embodiment of the power management system 870H in which a parallel amplifier 928 may generate the switch mode power supply feedback signal 40A in the high power modulation mode and the low power modulation mode. The $V_{OFFSET}$ loop circuit 41C may generate the threshold offset current 42, $I_{THRESHOLD\_OFFSET}$, in the high power modulation mode, the medium power modulation mode, and the medium power average power tracking mode.

The operation of the switcher control circuit 880 in each operational state of a set of operational states may be dependent on the expected output power of the radio frequency power amplifier during a data transmission. Some embodiments of the switcher control circuit 880 may include firmware, logic circuits, discrete logic circuits, controllers, processors, comparators, delays elements, counters, analog logic circuitry, switches, multiplexers, transistor logic, diode logic, registers, buffers, data buffers, level detectors, programmable logic circuits, and/or combinations thereof to implement and govern the operation of one or more state machines. The one or more state machines may be configured to govern the transitions between the various operational states of the switcher control circuit 880 as a function of the composite control signal, the power level modulation mode, and the expected output power generated by the radio frequency power amplifier 869 or the radio frequency power amplifier 869' during a data transmission. Based on the operational state of the switcher control circuit 880, the switcher control circuit 880 may generate the charge pump mode control signal 60, the series switch control signal 66, the shunt switch control signal 68, and the segmentation control signal 880A.

The switcher control circuit 880 may provide a charge pump mode control signal 60 to the multi-level charge pump 882 to configure the operation of the multi-level charge pump 882. In response to the charge pump mode control signal 60, the multi-level charge pump 882 may generate a boost output voltage or a buck output voltage at the charge pump output 64. The switcher control circuit 880 may generate the charge pump mode control signal 60 as a function of the power level modulation mode. In some embodiments, the switcher control circuit 880 may generate the charge pump mode control signal 60 as a function of both the power level modulation mode and the expected output power to be generated by the radio frequency power amplifiers 869 and 869' during a data transmission.

The switcher control circuit 880 may also provide a series switch control signal 66 and a shunt switch control signal 68 to the switching circuit 884. In response to an assertion of the series switch control signal 66, the switching circuit 884 couples the switching voltage output 26 to the battery voltage, $V_{BAT}$, to generate the switching voltage, $V_{SW}$, substantially equal to $V_{BAT}$. In response to the shunt switch control signal 68, the switching circuit 884 couples the switching voltage output 26 to ground to generate the switching voltage, $V_{SW}$, substantially equal to zero. In addition, the switcher control circuit 880 provides a segmentation control signal 880A to the switching circuit 884 as a function of the power level modulation mode. In some embodiments, the switcher control circuit 880 may generate the segmentation control signal 880A as a function of the power level modulation mode and the expected output power to be generated by the radio frequency power amplifiers 869 and 869' during a data transmission. For example, some embodiments of the power management systems 870 and 870A may be configured to generate the segmentation control signal 880A based on an average expected output power, $P_{OUT\_AVE}$, of the radio frequency power amplifier 869 that maximizes the efficiency of the switch mode power supply converter 872.

The switcher control circuit 880 may configure the switch mode power supply converter 872 to generate a switching voltage, $V_{SW}$, at the switching voltage output 26 based on an operational state of the switcher control circuit 880 as a function of a power level modulation mode, which is dependent on the expected output power to be generated by the radio frequency power amplifiers 869 and 869' during a data transmission. In some embodiments, the switcher control circuit 880 may configure the multi-level charge pump 882 and the switching circuit 884 to operate in one of a buck converter "bang-bang" mode, a multi-level charge pump buck converter mode, and an average power tracking mode of operation as a function of the power level modulation mode and operational mode of the switcher control circuit 880.

Referring to Figure 2C and 8B, in some embodiments, the control signal 926 received at the non-inverting input of the parallel amplifier 928 to generate the parallel amplifier output current, $I_{PARA\_AMP}$, may be generated by a differential filter 924 as a function of the power level modulation mode. For example, in the high power modulation mode, the differential filter 924 may provide an increased level of frequency compensation or correction as compared to the frequency compensation or correction provided by the differential filter 924 in the medium power modulation mode. Accordingly, some embodiments of the switcher control circuit 880, the switch mode power supply converter 872, the parallel amplifier circuits 874 and 874', and/or a combination thereof, may be further adapted to adjust a scaling factor, M, provided to a buffer scalar 434, and/or the magnitude of the delayed $I_{COR}$ estimated switching voltage output 38C, $V_{SW\_EST\_DELAY\_ICOR}$, as a function of the power level modulation mode.

Some alternative embodiments of the switcher control circuit 880, the switch mode power supply converter 872, the parallel amplifier circuits 874 and 874', and/or combinations thereof, may be further configured to adjust the magnitude of the delayed $I_{COR}$ estimated switching voltage output 38C, $V_{SW\_EST\_DELAY\_ICOR}$, based on the magnitude of the control signal 926 that is received by at the non-inverting input of the parallel amplifier 928, which is generated by the differential filter 924. In some embodiments, the switcher control circuit 880 may selectively adjust the scaling factor, M, as a function of the magnitude of the differential $V_{RAMP}$ signal and the power level modulation mode. For example, in some embodiments of the switcher control circuit 880, the scaling factor, M, may be further adjusted as a function of the power level modulation mode to reflect the amount of frequency compensation or correction applied by the differential filter 924 to generate the control signal 926 received at the non-inverting input 928A of the parallel amplifier 928, depicted in Figures 2C and 8B.

In some embodiments of the power management system 870 and 870A, either the switch mode power supply converter 872 or the parallel amplifier circuit 874 may be further adapted to adjust the scaling factor, M, based on the magnitude of the control signal 926 or the power level modulation mode. For example, in some embodiments, the magnitude of the delayed $I_{COR}$ estimated switching voltage output 38C, $V_{SW\_EST\_DELAY\_ICOR}$, used by the open loop ripple compensation assist circuit 414 may be adjusted as a function of the power level modulation mode, the magnitude of the differential $V_{RAMP}$ signal, and the expected frequency response of the parallel amplifier 928 when operating in each of the respective power level modulation modes.

For example, a switcher propagation delay is a time period between when the state of the switcher control circuit 880 changes to a new operational state and the switching voltage, $V_{SW}$, generated in response to the new operational state of the switcher control circuit 880, is generated at the switching voltage output 26. In some embodiments of the switch mode power supply converter 872, the switcher propagation delay may vary based on being configured to operate in the envelope tracking mode of operation and the average power tracking mode. Thus, the controller 50 may be configured to adjust the programmable delay period as a function of an expected output power to be generated by the radio frequency power.

As another example, in some embodiments, the switching circuit 884 may be a segmented switching circuit having a number of sets of series switch and shunt switch pairs. The sets of series switch and shunt switch pairs may be arranged in parallel and operably coupled to form a segmented series switch and shunt switch network. The switcher control circuit 880 may generate a series switch control signal 66, a shunt switch control signal 68, and the segmentation control signal 880A based on an operational state of the switcher control circuit 880 to control the operation of the switching circuit 884. In addition, the segmentation control signal 880A may be dependent on the power level modulation mode of the power management systems 870 and 870A. For example, the switcher control circuit 880 may configure the segmentation control signal 880A to enable or disable various combinations of the sets of series switch and shunt switch pairs of the switching circuit 884 based on the power level modulation mode of operation of the respective power management system 870, depicted in Figures 2A-C, and the power management system 870A, depicted in Figures 8A-B. As an example, in some embodiments of the medium power modulation mode, the switcher control circuit 880 may generate a segmentation control signal 880A to enable either 75% or 50% of the number of sets of series switch and shunt switch pairs of the switching circuit 884.

In some embodiments of the switching circuit 884, the switcher propagation delay may vary depending on the number of sets of series switch and shunt switch pairs configured to operate during a data transmission. In some embodiments, the switcher control circuit 880 may be configured to adjust a programmable delay period depending on the segmentation control signal 880A to maintain the temporal alignment of the delayed $I_{COR}$ estimated switching voltage output 38C $V_{SW\_EST\_DELAY\_ICOR}$ with respect to the switching voltage, $V_{SW}$, provided at the switching voltage output 26.

The switching circuit 884 may include a segmentation control circuit 886 configured to receive a segmentation control signal 880A from the switcher control circuit 880. The switching circuit 884 may further include segmented series switches 888 and segmented shunt switches 890 in communication with the segmentation control circuit 886. The segmented series switches 888 may include a first series switch 892, a second series switch 894, a third series switch 896, and a fourth series switch 898. The segmented shunt switches 890 may include a first shunt switch 900, a second shunt switch 902, a third shunt switch 904, and a fourth shunt switch 906.

A source 892S of the first series switch 892, a source 894S of the second series switch 894, a source 896S of the third series switch 896, and a source 898S of the fourth series switch 898 are in communication with a supply voltage received from the battery 20 substantially equal to the battery voltage, $V_{BAT}$. A drain 892D of the first series switch 892, a drain 894D of the second series switch 894, a drain 896D of the third series switch 896, and a drain 898D of the fourth series switch 898 are respectively coupled to a drain 900D of the first shunt switch 900, a drain 902D of the second shunt switch 902, a drain 904D of the third shunt switch 904, and a drain 906D of the fourth shunt switch 906 to form the switching voltage output 26. A source 900S of the first shunt switch 900, a source 902S of the second shunt switch 902, a source 904S of the third shunt switch 904, and a source 906S of the fourth shunt switch 906 are in communication with a reference voltage substantially equal to ground.

The segmentation control circuit 886 may include a first series switch control output 908 coupled to the gate 892G of the first series switch 892, a first shunt switch control output 910 coupled to the gate 900G of the first shunt switch 900, a second series switch control output 912 coupled to the gate 894G of the second series switch 894, a second shunt switch control output 914 coupled to the gate 902G of the second shunt switch 902, a third series switch control output 916 coupled to the gate 896G of the third series switch 896, a third shunt control output 918 coupled to the gate 904G of the third shunt switch 904, a fourth series switch control output 920 couple to the gate 898G of the fourth series switch 898, and a fourth shunt switch control output 922 coupled to the gate 906G of the fourth shunt switch 906.

Operationally, the segmentation control circuit 886 may divide the segmented series switches 888 and segmented shunt switches 890 into logical groupings of sets of series and shunt switches such that each set of series and shunt switches includes one of the segmented series switches 888 and one of the segmented shunt switches 890. For example, a first set of series and shunt switches may include the first series switch 892 and the first shunt switch 900. A second set of series and shunt switches may include the second series switch 894 and the second shunt switch 902. A third set of series and shunt switches may include the third series switch 896 and the third shunt switch 904. A fourth set of series and shunt switches may include the fourth series switch 898 and the fourth shunt switch 906.

The segmentation control circuit 886 is configured to receive a series switch control signal 66 and a shunt switch control signal 68 from the switcher control circuit 880. The power management system 870 may configure the switcher control circuit 880 to generate a segmentation control signal 880A to select which of the segmented series switches 888 and segmented shunt switches 890 are to be enabled by the segmentation control circuit 886 to generate the switching voltage, $V_{SW}$, at the switching voltage output 26 as a function of the average expected output power, $P_{OUT\_AVE}$, to be generated by the radio frequency power amplifier 869 during the data transmission. Illustratively, in the case where there are four sets of series and shunt switches, the operation of the segmentation control circuit 886 may be divided into four regions or modes of operation.

In some embodiments, the switcher control circuit 880 may generate the segmentation control signal 880A as a function of the average expected output power, $P_{OUT\_AVE}$, and a set of switcher output power thresholds including a first switcher output power threshold, $P_{OUT1}$, a second switcher output power threshold, $P_{OUT2}$, and a third switcher output power threshold, $P_{OUT3}$. The values of the first switcher output power threshold, $P_{OUT1}$, the second switcher output power threshold, $P_{OUT2}$, and the third switcher output power threshold, $P_{OUT3}$, may be determined to maximize the efficiency of the switch mode power supply converter 872 with respect to the expected output power of the radio frequency power amplifier 869 as a function of the power level modulation mode and an expected load line, $R_{RF\_AMP\_EXP}$, of the radio frequency power amplifier 869 during the data transmission.

In the case where the average expected output power, $P_{OUT\_AVE}$, of the radio frequency power amplifier 869 is at least equal to the first switcher output power threshold, $P_{OUT1}$, the segmentation control signal 880A may configure the segmentation control circuit 886 to enable all four of the series switch and shunt switch segments. In the case where the average expected output power, $P_{OUT\_AVE}$, of the radio frequency power amplifier 869 is less than the first switcher output power threshold, $P_{OUT1}$, and at least equal to the second switcher output power threshold, $P_{OUT2}$, the segmentation control signal 880A may configure the segmentation control circuit 886 to enable three of the series switch and shunt switch segments. In the case where the average expected output power, $P_{OUT\_AVE}$, of the radio frequency power amplifier 869 is less than the second switcher output power threshold, $P_{OUT2}$, and at least equal to the third switcher output power threshold, $P_{OUT3}$, the segmentation control signal 880A may configure the segmentation control circuit 886 to enable two of the series switch and shunt switch segments. And in the case where the average expected output power, $P_{OUT\_AVE}$, of the radio frequency power amplifier 869 is less than the third switcher output power threshold, $P_{OUT3}$, the segmentation control signal 880A may configure the segmentation control circuit 886 to enable one of the series switch and shunt switch segments.

The multi-level charge pump 882 may configure a multi-level charge pump switching network to generate a variety of "boost" output voltages and "buck" output voltages as a function of a charge pump mode control signal 62 received from the switcher control circuit 880. Some embodiments of the multi-level charge pump 882 may generate a variety of "boost" output voltages and "buck" output voltages as a multi-level charge pump output voltage, $V_{MLCP}$, in response to the charge pump mode control input 62 generated by the switcher control circuit 880. The multi-level charge pump 882 may provide the multi-level charge pump output voltage, $V_{MLCP}$, to the charge pump output 64, which may be coupled through the switching circuit 884 to the switching voltage output 26.

For example, in a second boost mode of operation, the multi-level charge pump 882 may configure the multi-level charge pump switching network to generate a second boost mode output voltage, $V_{SECOND\_BOOST}$, substantially equal to 2 x $V_{BAT}$ at the charge pump output 64. In a first boost mode of operation, the multi-level charge pump 882 may configure the switching network to generate a first boost mode output voltage at the charge pump output 64 substantially equal to 3/2 x $V_{BAT}$. In a first buck mode of operation, the multi-level charge pump 882 may configure the multi-level charge pump switching network to generate a first buck mode output voltage at the charge pump output 64 substantially equal to 1/2 x $V_{BAT}$. In some alternative embodiments, the multi-level charge pump 882 may be configured to generate other ratios of boost mode output voltages and buck mode output voltage.

Some embodiments of the multi-level charge pump 882 may include only two flying capacitors that are coupled in various switching arrangements with respect to each other, the battery voltage, $V_{BAT}$, and the charge pump output 64 to generate the various charge pump output voltages at the charge pump output 64. For example, similar to the μC charge pump circuit 262, some embodiments of the multi-level charge pump 882 may generate various ratios of output voltages that may be provided as a boost output voltage or a buck output voltage to the switching voltage output 26 as the switching voltage, $V_{SW}$. In still other alternative embodiments, the multi-level charge pump 882 may generate a boost output voltage or a buck output voltage with respect to a supply voltage other than the battery voltage, $V_{BAT}$, where the supply voltage may be greater than the battery voltage, $V_{BAT}$, or less than the battery voltage, $V_{BAT}$. In some alternative embodiments, the supply voltage provided to the multi-level charge pump 882 may be a boosted voltage or a bucked voltage derived from the battery voltage, $V_{BAT}$.

Based on the power level modulation mode, in some embodiments of the multi-level charge pump buck converter mode of operation, the switcher control circuit 880 may configure the switch mode power supply converter 872 to generate a series output voltage substantially equal to the battery voltage, $V_{BAT}$, a shunt output voltage substantially equal to a ground voltage, and a subset of the available charge pump output voltages. As an example, as a function of the power level modulation mode, the switcher control circuit 880 may configure the multi-level charge pump 882 and the switching circuit 884 to generate a shunt mode output voltage substantially equal to a ground voltage in the shunt output mode, a series mode output voltage substantially equal to $V_{BAT}$ in the series output mode, and a first boost mode output voltage $V_{FIRST\_BOOST}$ substantially equal to 3/2 x $V_{BAT}$ in the first boost output mode. As another non-limiting example, as a function of the power level modulation mode, in some power level modulation modes, the switcher control circuit 880 may configure the multi-level charge pump 882 to provide a first buck mode output voltage substantially equal to 1/2 x $V_{BAT}$ in the first buck mode of operation. As an example, as a function of the power level modulation mode, the switcher control circuit 880 may configure the multi-level charge pump 882 and the switching circuit 884 to generate a shunt mode output voltage substantially equal to ground, a first buck mode output voltage substantially equal to 1/2 x $V_{BAT}$, a series mode output voltage substantially equal to $V_{BAT}$, and a first boost mode output voltage substantially equal to 3/2 x $V_{BAT}$ as a function of the operational state of the switcher control circuit 880. As still another non-limiting example, in some power level modulation modes, the switcher control circuit 880 may configure the multi-level charge pump 882 to only operate in a first boost mode of operation to generate a first boost mode output voltage, $V_{FIRST\_BOOST}$, substantially equal to 3/2 x $V_{BAT}$.

As another example, in some power level modulation modes, the multi-level charge pump 882 may be configured to only operate in the second boost mode of operation. In still another example, in some power level modulation modes, the multi-level charge pump 882 may be configured to operate in the first buck mode and either the first boost mode or the second boost mode of operation. For example, in some power level modulation modes, the switcher control circuit 880 may configure the multi-level charge pump 882 to provide either a first buck mode output voltage substantially equal to 1/2 x $V_{BAT}$ and a first boost mode output voltage substantially equal to 3/2 x $V_{BAT}$ as a function of the operational state of the switcher control circuit 880. In other power level modulation modes, the switcher control circuit may configure the multi-level charge pump 882 to provide a buck output voltage substantially equal to 1/2 x $V_{BAT}$ in the first buck mode and a second boost level output voltage substantially equal to 2 x $V_{BAT}$ as a function of the operational state of the switcher control circuit 880.

In some modes of operation, either the controller 50 or the switcher control circuit 880 may either increase or decrease the average switching frequency of the switch mode power supply converter 872 to move the ripple frequency energy into specific frequency location that is away from the public safety band. For example, the controller 880 may configure the switching frequency of the switch mode power supply converter 872 in either the average power tracking mode of operation, the envelope tracking mode of operation, or the buck mode of operation to reduce the level of harmonic switching frequencies that may fall inside a band of operation that is sensitive to spurious noise. The radio frequency power amplifier 869 or 869' may generate the harmonic switching frequencies as a function of the amplification of the modulated radio frequency input signal and ripple voltages present at the modulated power supply output 876. The ripple voltage may be due in part to the high frequency ripple current generated by the switching action of the switch mode power supply converter 872, the non-ideal impedance of the parallel amplifier 928, and/or a combination thereof. By controlling the location of the switching frequency in the frequency spectrum, the various embodiments of the power management systems 870, 870A-C and 870E-H, depicted in Figures 2A-E and Figures 8A-B and 8E-H, may reduce the maximum energy level or power level of the harmonic switching frequencies generated within a receive channel or transmit channel of another band of operation.

As an example, depending on the power level modulation mode, the power management systems 870, 870A-C, and 870E-H may use either an open loop or a closed control loop to govern the switching frequency of the switch mode power supply converter 872.

In the high power modulation mode and the medium power modulation mode, various embodiments of the power management systems 870, 870A-C, and 870E-H may enable the average frequency control circuit 885 to govern the switching frequency of the switch mode power supply converter 872 based on a target switching frequency. In some embodiments, the average frequency control circuit 885 may be configured to govern the switching frequency of the switch mode power supply converter 872 to generate a switching frequency such that the average of the switching frequency is substantially near or equal to the target switching frequency. As a result, the controller 50 may configure the average frequency control circuit 885 to move the switching frequency of the switch mode power supply converter 872 to a location such that some of the energy associated with the harmonic frequencies of the switching frequency may be moved out of or away from a sensitive band of operation and/or the maximum energy level or power level at the harmonic switching frequencies within the sensitive band of operation may be reduced.

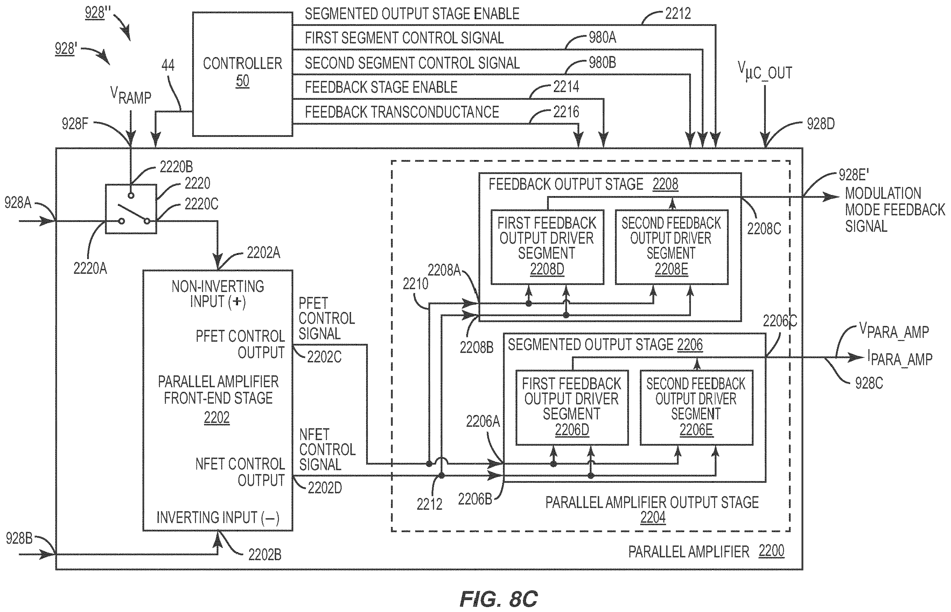

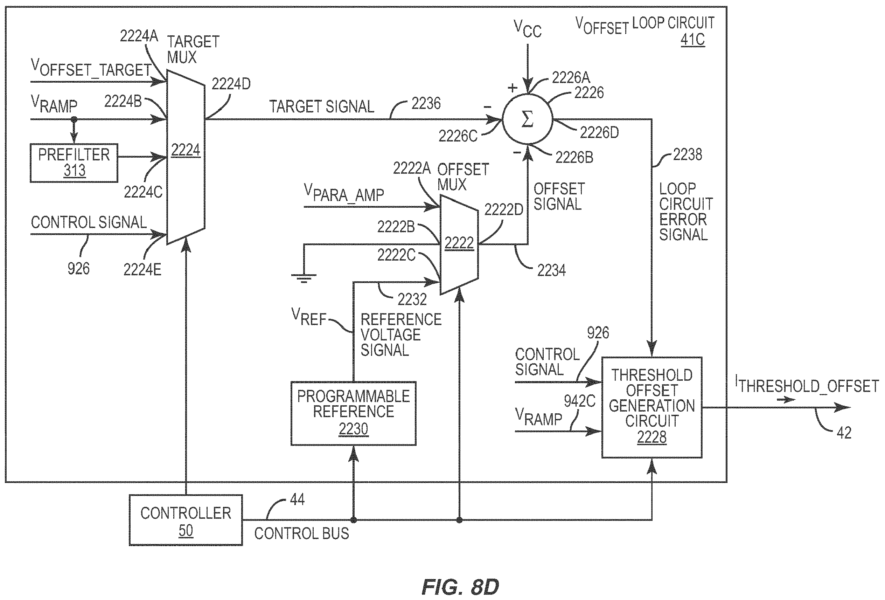

In some embodiments of the medium power average power tracking mode, the feedback delay compensation circuit 852 and all active notice reduction circuits may be disabled. As an example, the open loop ripple compensation assist circuit 414 may be disabled. In addition, in some embodiments of the medium power average power tracking mode, the parallel amplifier 928 may be disabled and the $V_{OFFSET}$ loop circuit 41 may be disable. In this case, as depicted in Figure 8B, the power management system 870A may configure the parallel amplifier circuit 874' to generate a power tracking control signal 966 as a function of the differential $V_{RAMP}$ signal, which is described below. The parallel amplifier circuit 874' may provide the power tracking control signal 966 as the switch mode power supply feedback signal 40A from the switch mode power supply converter control output 874E. Because the other contributors to the composite control signal may be disabled, the composite control signal may be a function of the power tracking control signal 966. The average power tracking control signal 966 may be proportional to an error voltage substantially equal to a $V_{RAMP}$ signal less the modulated power supply voltage, $V_{CC}$, where the $V_{RAMP}$ signal is a single ended version of the differential $V_{RAMP}$ signal. As explained below with respect to the parallel amplifier 2200, depicted in Figure 8C, in still other embodiments, the composite control signal may be provided by an embodiment of the parallel amplifier 928 configured to provide a modulation mode feedback signal that is substantially equivalent to the average power tracking control signal 966 while the parallel amplifier output 928C is configured to provide a high impedance path to ground. In still other embodiments, the composite control signal may be provided by an embodiment of the $V_{OFFSET}$ loop circuit 41 adapted to regulate the switch mode power supply converter 872 in various average power tracking modulation modes of operation. For example, Figure 8D depicts an embodiment of a $V_{OFFSET}$ loop circuit 41C adapted to generate a threshold offset current 42, $I_{THRESHOLD\_OFFSET}$, to provide a composite control signal substantially equivalent to the average power tracking control signal 966. However, in some embodiments, $V_{OFFSET}$ loop circuit 41C may be adapted to generate a threshold offset current 42, $I_{THRESHOLD\_OFFSET}$, that is based on a weighted error voltage between a target voltage for the modulated power supply output 876 and the modulate power supply voltage, $V_{CC}$.

In addition, in the medium power average power tracking modulation mode, the various embodiments of the power management system 870 and 870A may cause the parallel amplifier circuit output 874A to provide a low impedance path to ground such that the coupling capacitor 18A is substantially coupled between the modulated power supply output 876 and ground. The coupling capacitor 18A may be substantially in parallel with the bypass capacitor 19, which may reduce the voltage ripple generated at the modulated power supply output 876 by the switching action of switch mode power supply converter 872.

In addition, as depicted in Figures 2D-E and Figure 8E-H, the bypass capacitor 19 may be replace by a capacitor array 19A. Depending on the mode of operation of the communication device, a band of operation in which the communication device is operating, a number of resource blocks allocated for a data transmission, some embodiments of the parallel amplifier circuits 847B'-C' and 874E'-H' may switchably control the capacitor array 19A to increase the amount of bypass capacitance between the modulated power supply output 876. For example, increase in the amount of bypass capacitance provide by the capacitor array 19A may increase the ripple rejection at the modulate power supply output 876, which decreases ripple voltage in the modulated power supply voltage, $V_{CC}$, provided to the various embodiments of the radio frequency power amplifier 869 and the radio frequency power amplifier 869'. As an example, the various embodiments of the power management system 870 and 870A may configure the decoupling capacitance at the modulated power supply output 876 as a function of the number of resource blocks to be used for a particular LTE band number assigned to a communication device. As discussed above, the LTE band number may correspond to a band of operation in which a communication device is assigned to operate in a mobile communication network. As a further example, the decoupling capacitance provided by decoupling capacitor array 19A may be switchably configured to provide substantially near between 1nF to 2 nF when at least twelve resource blocks are to be used during a data transmission. Alternatively, the decoupling capacitor array 19A may be switchably configured to provide substantially near between 4nF to 8 nF when less than twelve resource blocks are to be used during a data transmission.

Referring to Figure 8B, in some embodiments of the medium power average power tracking modulation mode, the switcher control circuit 880 and/or the controller 50 may enable the average power tracking controller circuit 944, and disable any embodiment of an active noise reduction circuit such as an open loop ripple compensation assist circuit 414. The controller 50 may further disable the feedback delay compensation circuit 852, and the $V_{OFFSET}$ loop circuit 41, and the parallel amplifier 928, depicted in Figures 2B and 8B, to generate a composite control signal substantially based on the average power tracking control signal 966 generated by the average power tracking controller circuit 944 as a function of the differential $V_{RAMP}$ signal.

As discussed below with respect to Figure 8B, the parallel amplifier circuit 874' may provide an average power tracking control signal 966 as the switch mode power supply feedback signal 2A. The average power tracking control signal 966 is an error signal generated based on a different between a target output voltage of the modulated power supply voltage, $V_{CC}$, provided by the differential $V_{RAMP}$ signal and the modulated power supply voltage, $V_{CC}$, received at the modulated power supply voltage feedback input 874F. The average power tracking control signal 966 may represent an error signal between a present voltage at the modulated power supply output 876 and a target voltage to be generated at the modulated power supply output 876 by the switch mode power supply converter 872.

Referring to Figures 2C and 8B, some embodiments of the $V_{OFFSET}$ loop circuit 41 may be configured to provide a threshold offset current 42, $I_{THRESHOLD\_OFFSET}$, to the switcher control circuit 880 in the medium power average power tracking modulation mode. As an example, Figure 8D depicts embodiments of a $V_{OFFSET}$ loop circuit 41C that may generate a threshold offset current 42, $I_{THRESHOLD\_OFFSET}$, as a function of the differential $V_{RAMP}$ signal and the modulated power supply voltage, $V_{CC}$, received at the modulated power supply voltage feedback input 874F. In some embodiments, the $V_{OFFSET}$ loop circuit 41C may be configured to generate the threshold offset current 42, $I_{THRESHOLD\_TARGET}$, by integrating a difference between the modulated power supply voltage, $V_{CC}$, and the target output voltage of the modulated power supply voltage, $V_{CC}$, derived from the differential $V_{RAMP}$ signal. In some embodiments, the programmable time constants of the $V_{OFFSET}$ loop circuit 41C may be configured to improved stability, increase a responsiveness of the control loop governing the generation of the switching voltage, $V_{SW}$, or configured the switch mode power supply converter 872 to pre-charge the modulated power supply voltage, $V_{CC}$, prior to commencement of a data transmission. As depicted in Figure 8D, in some embodiments the $V_{OFFSET}$ loop circuit 41C may receive a single-ended version of the $V_{RAMP}$ signal. And the $V_{OFFSET}$ loop circuit 41C may be further configured to pre-distort the $V_{RAMP}$ signal to provide a frequency response compensated target voltage derived from the differential $V_{RAMP}$ signal. In some alternative embodiments, the $V_{OFFSET}$ loop circuit 41C may receive a compensated $V_{RAMP}$ signal, $V_{RAMP\_C}$, which may be used as a frequency compensated target voltage of the modulated power supply voltage, $V_{CC}$. The threshold offset current 42, $I_{THRESHOLD\_TARGET}$, generated with either the $V_{RAMP}$ signal or the compensated $V_{RAMP}$ signal, may represent an average error in the modulated power supply voltage, $V_{CC}$, generated at the modulated power supply output 876.

Figure 2C depicts an embodiment of the parallel amplifier circuit 874 that includes a differential filter 924 configured to generate a control signal 926 based on the differential $V_{RAMP}$ signal. The differential filter 924 may provide degrees of frequency response correction as a function of the expected output power of the radio frequency power amplifier 869. For example, the controller 50 may determine or obtain the expected output power to be generated by the radio frequency power amplifier 869 during a data transmission in an upcoming data transmission slot. For example, the controller 50 may obtain the expected output power of the radio frequency power amplifier 869 from the digital baseband processing portion of a transceiver or modem that provides the differential $V_{RAMP}$ signal.

Based on a determination that the expected output power of the radio frequency power amplifier 869 is at least equal to the high power modulation mode threshold, the controller 50 may configure the differential filter 924 to provide maximum peaking of the differential $V_{RAMP}$ signal. Alternatively, in some embodiments, either the controller 50 or the power management system 870 may receive an indication to configure the power management system to operate in the high power modulation mode. In this case, the differential filter 924 may be configured to provide a maximum level of frequency response compensation or correction.

Alternatively, based on a determination that the output power to be generated by the radio frequency power amplifier 869 is less than the high power modulation mode threshold but greater than the low power modulation mode threshold, the power management system 870 may configure the differential filter 924 to provide a medium level of frequency response correction. In other words, based on a determination that the expected output power of the radio frequency power amplifier 869 is less than the high power modulation mode threshold, the controller 50 or the power management system 870 may configure the differential filter 924 to provide less frequency response compensation as a function of the expected output power of the radio frequency power amplifier 869.

As another example, based on a determination that the radio frequency power amplifier will generate an expected output power less than the low power modulation mode threshold, the controller 50 may configure the differential filter 924 to provide either minimum or no frequency response correction as a function of a tracking mode of the power management system 870.

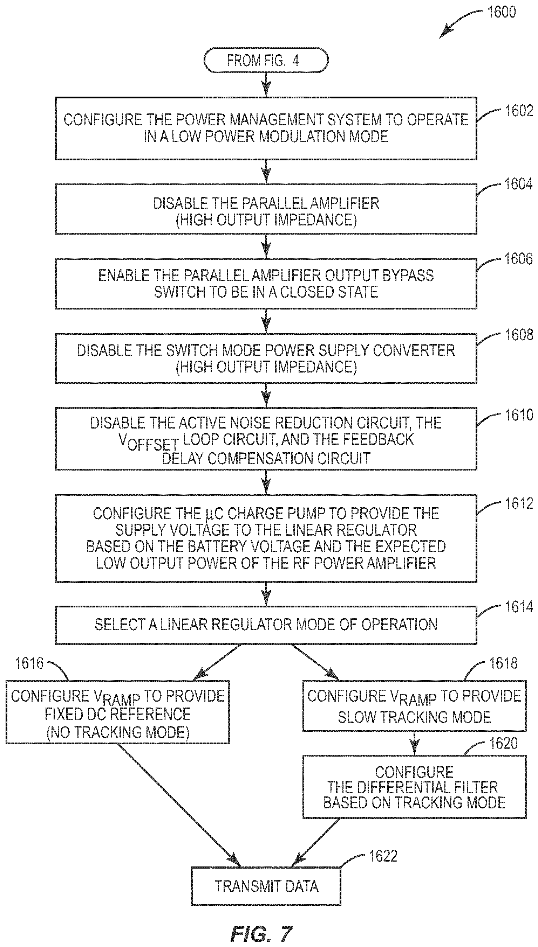

The parallel amplifier 928 may include a non-inverting input 928A configured to receive the control signal 926. In some embodiments, the control signal 926 may be a compensated $V_{RAMP}$ signal, $V_{RAMP\_C}$. The parallel amplifier 928 may also include an inverting input 928B in communication with the modulated power supply output 876. Based on the difference between the control signal and the modulated power supply voltage, $V_{CC}$, the parallel amplifier 928 may generate a parallel amplifier output current, $I_{PARA\_AMP}$, at the parallel amplifier output 928C in order to generate the parallel amplifier output voltage, $V_{PARA-AMP}$. The parallel amplifier 928 may generate a scaled parallel amplifier output current estimate, $I_{PARA\_AMP\_SENSE}$, which is a fractional representation of the parallel amplifier output current, $I_{PARA\_AMP}$, from the parallel amplifier feedback output 928E. The parallel amplifier 928 may include a parallel amplifier supply voltage input 928D configured to receive a μC charge pump output voltage, $V_{\mu C\_OUT}$, from the μC charge pump circuit 262. Alternatively, as previously described, in some embodiments the parallel amplifier supply voltage input 928D may be switchably configured to be powered by the μC charge pump output voltage, $V_{\mu C\_OUT}$, or a supply voltage provided by the multi-level charge pump 882 of the switch mode power supply converter 872, depicted in Figure 2B. As an example, some embodiments of the switch mode power supply converter 872 may be configured to provide a parallel amplifier supply voltage, $V_{SUPPLY\_PARA\_AMP}$, generated from the internal charge pump node parallel amplifier supply 294 or the charge pump output voltage, $V_{CP\_OUTPUT}$, as depicted in Figures 7B-D, to power the parallel amplifier circuit 874 and/or the linear regulator 930, LDO.

The μC charge pump circuit 262, may be configured to provide various power supply voltage levels to power the parallel amplifier 928 as a function of the battery voltage, $V_{BAT}$, the offset voltage across the coupling capacitor 18A, and the an expected envelope characteristics of signal to be transmitted.

For example, in some embodiments, the μC charge pump circuit 262 may generate the μC charge pump output voltage, $V_{\mu C\_OUT}$, as a function of the battery voltage and the modulation mode of operation. For example, in the high power modulation mode, the power management system 870 may configure the μC charge pump circuit 262 to operate in the 1 x $V_{BAT}$ mode or the 4/3 x $V_{BAT}$ mode to generate the μC charge pump output voltage, $V_{\mu C\_OUT}$, substantially equal to either the battery voltage, 1 x $V_{BAT}$, or 4/3 x $V_{BAT}$, respectively, which equates to a charge-pump-ratio of 1 or 4/3, respectively. In the medium power modulation mode, the power management system 870 may configure the μC charge pump circuit 262 to operate in the 1 x $V_{BAT}$ mode or the 2/3 x $V_{BAT}$ mode to generate the μC charge pump output voltage, $V_{\mu C\_OUT}$, substantially equal to either the battery voltage, $V_{BAT}$, or 2/3 x $V_{BAT}$, respectively, which equates to a charge-pump-ratio of 1 or 2/3, respectively. In some embodiments, in the low power modulation mode, the power management system 870 may configure the μC charge pump circuit 262 to operate in the 1/4 x $V_{BAT}$ mode, 1/3 x $V_{BAT}$ mode, or the 1/2 x $V_{BAT}$ mode to generate the μC charge pump output voltage, $V_{\mu C\_OUT}$, substantially equal to 1/4 x $V_{BAT}$, 1/3 x $V_{BAT}$, or 1/2 x $V_{BAT}$, respectively, which equates to a charge-pump-ratio of %, 1/3, or 1/2, respectively.

Figure 2C further depicts that the μC charge pump circuit 262 may be configured to receive a μC charge pump clock 276 from a clock management circuit 260. The clock management circuit 260 may generate the μC charge pump clock 276 based on the oscillator 270 or the switching frequency of the switch mode power supply converter 872. For example, in some embodiments, the switching frequency of the switch mode power supply converter 872 may be controlled by a frequency locked loop circuit, as described with respect to Figure 2B. In some embodiments, the clock management circuit 260 may power down the oscillator 270 when the switch mode power supply converter 872 is enabled. For example, in the high power modulation mode and the medium power modulation mode, the clock management circuit 260 may provide a μC charge pump clock 276 based on the switching frequency of the switch mode power supply converter 872 and disable the oscillator 270. However, in the low power modulation mode, the clock management circuit 260 may enable the oscillator 270 to generate the μC charge pump clock 276.

The power management system 870 may configure the clock management circuit 260 to provide a μC charge pump clock 276 that maximizes the efficiency of the power management system 870 as a function of the expected output power of the radio frequency power amplifier 869. For example, the power management system 870 may configure the clock management circuit 260 to provide a μC charge pump clock 276 between about 0.5 MHz and 3 MHz when operating in the low power modulation mode. In the case where the clock management circuit provides the μC charge pump clock 276 based on the switching frequency of the switch mode power supply converter 872, the clock management circuit may be configured to disable the oscillator 270 to conserve energy drawn from the battery 20.

In some embodiments, a segmented parallel amplifier output stage of the parallel amplifier 928 may be configured based upon the expected output power of the radio frequency power amplifier 869. As an example, the segmentation configuration of the parallel amplifier 928 may be a function of a maximum instantaneous output power, $P_{INST\_MAX}$, to be generated by the radio frequency power amplifier 869 during the data transmission and the expected load line, $R_{RF\_AMP\_EXP}$, of the radio frequency power amplifier 869 during the data transmission. As an example, in some embodiments, a maximum instantaneous output current, $I_{MAX\_PARA\_AMP}$, to be provided by the parallel amplifier 928 during the data transmission may be substantially equal to $(P_{INST\_MAX} / R_{RF\_AMP\_EXP})^{1/2}$. In some embodiments, the parallel amplifier 928 may include a maximum parallel amplifier output current, $I_{PARA\_MAX}$, which is the maximum output current to be generated by the parallel amplifier 928. In some embodiments, the power management system 870 may configure the segmentation configuration of the parallel amplifier 928 based on the maximum parallel amplifier output current, $I_{PARA\_MAX}$, and the maximum instantaneous output current, $I_{MAX\_PARA\_AMP}$.

For example, in some embodiments, the controller may determine the maximum instantaneous output current, $I_{MAX\_PARA\_AMP}$, based on the envelope characteristics of the modulated radio frequency input signal to be transmitted and the expected load line, $R_{RF\_AMP\_EXP}$, of the radio frequency power amplifier 869 during the data transmission. The power management system 870 may determine the maximum instantaneous output power, $P_{INST\_MAX}$, based on the envelope characteristics of the modulated radio frequency input signal. Based on the maximum instantaneous output current, $I_{MAX\_PARA\_AMP}$, the power management system 870 may determine an estimated percentage of output current generation capacity of the parallel amplifier 928 that may be used during the data transmission.

For example, the power management system 870 may calculate the percentage of the output current generation capacity based on the ratio of the maximum instantaneous output current, $I_{MAX\_PARA\_AMP}$, to the maximum parallel amplifier output current, $I_{PARA\_MAX}$. The power management system 870 may determine the number of output stage segments of the parallel amplifier 928 to enable based on the estimated percentage of output current generation capacity of the parallel amplifier 928 to be used. For example, in the case where the parallel amplifier 928 includes two output stage segments that are configured to have a substantially equal output current generation capacity, the power management system 870 may set the segmentation configuration to be 100% when the ratio of the maximum instantaneous output current, $I_{MAX\_PARA\_AMP}$, to the maximum parallel amplifier output current, $I_{PARA\_MAX}$, is substantially equal to or near at least 50%. The power management system 870 may set the segmentation configuration to be 50% when the ratio of the maximum instantaneous output current, $I_{MAX\_PARA\_AMP}$, to the maximum parallel amplifier output current, $I_{PARA\_MAX}$, is at least less than 50%. In the case where the output stage segments of the parallel amplifier 928 are not substantially equal, the controller 50 may determine which of the output stage segments to enable based on the ratio of the maximum instantaneous output current, $I_{MAX\_PARA\_AMP}$, and the current generation capacity of each of the output stage segments.

In some alternative embodiments, the segmentation configuration of the parallel amplifier 928 may be based on the expected peak-to-peak swing of a modulated power supply voltage, $V_{CC\_PKPK}$, and the expected load line, $R_{RF\_AMP\_EXP}$, of the radio frequency power amplifier 869 and 869' during the data transmission.

For example, when operating in the high power modulation mode, the power management system 870 may set the segmentation configuration to be 100%. Alternatively, the power management system 870 may configure the parallel amplifier 928 to use only the first output stage segment or only the second output stage segment while operating in the medium power modulation mode depending on the ratio of the maximum instantaneous output current, $I_{MAX\_PARA\_AMP}$, to the maximum parallel amplifier output current, $I_{PARA\_MAX}$. And in the low power modulation mode, the power management system 870 may disable the parallel amplifier 928 to place the parallel amplifier output 928C in a high impedance mode.

As previously described with respect to Figure 2A, Figure 2C depicts that the parallel amplifier circuit 874 may provide the threshold offset current 42, $I_{THRESHOLD\_OFFSET}$, from an embodiment of the $V_{OFFSET}$ loop circuit 41 to regulate the offset voltage, $V_{OFFSET}$, across the coupling capacitor 18A.

In some embodiments, the $V_{OFFSET}$ loop circuit 41 may be configured to generate the threshold offset current 42, $I_{THRESHOLD\_OFFSET}$, that represents an average or integrated error between the modulated power supply voltage, $V_{CC}$, and a $V_{RAMP}$ signal when the switch mode power supply converter 872 is configured to operate in an average power tracking mode of operation. Some embodiments of the $V_{OFFSET}$ loop circuit 41 may be configured to pre-charge the bypass capacitor 19 and the coupling capacitor 18A while the switch mode power supply converter 872 is configured to operate in the average power tracking mode of operation.

For the sake of simplicity, and not by way of limitation, Figure 2C depicts that the parallel amplifier 928 may provide a scaled parallel amplifier output current estimate, $I_{PARA\_AMP\_SENSE}$, as the parallel amplifier circuit output current estimate 40, $I_{PAWA\_OUT\_EST}$. Although not depicted, for the sake of simplicity and not by way of limitation, some alternative embodiments of the switcher control circuit 880 may also receive a feedback delay compensation signal 854, $I_{FEEDBACK\_TC}$, from an embodiment of the feedback delay compensation circuit 852. In addition, for the sake of simplicity of description and not by way of limitation, Figure 2C depicts that the parallel amplifier 928 is configured to provide the scaled parallel amplifier output current estimate, $I_{PARA\_AMP\_SENSE}$, as the parallel amplifier circuit output current estimate 40, $I_{PAWA\_OUT\_EST}$. Although not depicted in Figure 2C for the sake of simplicity, other example embodiments of the parallel amplifier circuit 874 may include active noise reduction circuit configured to reduce high frequency ripple current and high frequency ripple voltage at the modulated power supply output 876.

One example of an active noise reduction circuit may include an open loop ripple compensation assist circuit 414. As previously described, the open loop ripple compensation assist circuit 414 may generate a high frequency ripple compensation current 416, $I_{COR}$, to substantially reduce high frequency ripple currents present at the modulated power supply output 876. For example, the high frequency ripple currents at the modulated power supply output 876 may induce some embodiments of a parallel amplifier 928 to generate high frequency ripple voltages in modulated power supply voltage, $V_{CC}$, due to a non-ideal output impedance of the parallel amplifier 928. The open loop ripple compensation assist circuit 414 may apply the high frequency ripple compensation current 416, $I_{COR}$, to the modulated power supply output 876 to reduce the electronic noise generated in a receiver band in response to the high frequency ripple currents. The scaled high frequency ripple compensation current estimate 418, $I_{COR\_SENSE}$, may be added to the scaled parallel amplifier output current estimate, $I_{PARA\_AMP\_SENSE}$, to provide the switch mode power supply feedback signal 40A.

In some embodiments, the controller 50 may configure the active noise reduction circuitry to provide a high level of active noise reduction in the high power modulation mode, a medium level of active noise reduction in the medium power modulation mode, and no active noise reduction in the low power modulation mode. Illustratively, some embodiments of the open loop ripple compensation assist circuit 414 may include programmable $I_{COR}$ transconductance value, $Gm_{ICOR}$, that may be configured based on a power level modulation mode of operation. As an example, the open loop ripple compensation assist circuit 414 may include a high power modulation mode $I_{COR}$ transconductance value, $GmI_{COR\_HIGH\_POWER}$, and a medium power modulation mode $I_{COR}$ transconductance value, $Gm_{ICOR\_MEDIUM\_POWER}$. In the high power modulation mode, the controller 50 may set the programmable $I_{COR}$ transconductance, $Gm_{ICOR}$, to the high power modulation mode $I_{COR}$ transconductance value, $Gm_{ICOR\_HIGH\_POWER}$. In contrast, the controller 50 may set the programmable $I_{COR}$ transconductance, $Gm_{ICOR}$, to a medium power modulation mode $I_{COR}$ transconductance value, $Gm_{ICOR\_MEDIUM\_POWER}$, in the medium power modulation mode. And, in the low power modulation mode, the controller 50 may disable the open loop ripple compensation assist circuit 414.

The parallel amplifier circuit 874 may further include a linear regulator 930, LDO. The linear regulator 930, LDO, may be a low dropout voltage linear regulator. The parallel amplifier circuit 874 may also include a parallel amplifier output bypass switch 936, a linear regulator output selection switch 938, and a feedback selection switch 940. The parallel amplifier output bypass switch 936 includes a first terminal 936A coupled to the parallel amplifier output 928C and a second terminal 936B coupled to ground. The power management system 870 may configure the parallel amplifier output bypass switch 936 to close when the parallel amplifier 928 is disabled.

For example, the power management system 870 may configure the parallel amplifier output bypass switch 936 to close based on a determination that the expected output power of the radio frequency power amplifier 869' is less than the low power modulation mode threshold or the parallel amplifier output 928C is disabled and configured to provide a high impedance. Alternatively, the power management system 870 may configure the parallel amplifier output bypass switch 936 to be open when the parallel amplifier 928 is enabled.

The linear regulator output selection switch 938 may include an input terminal 938A coupled to a linear regulator output 930C of the linear regulator 930, LDO, a first output terminal 938B in communication with the modulated power supply output 876, and a second output terminal 938C in communication with the second linear regulator output 874D, $LDO_2$ OUTPUT, in communication with the CMOS logic supply input 869C of the radio frequency power amplifier 869.

The feedback selection switch 940 includes an output terminal 940A in communication with an inverting input 930B of the linear regulator 930, LDO, a first input terminal 940B in communication with the modulated power supply output 876, and a second input terminal 940C in communication with the second linear regulator output 874D, $LDO_2$ OUTPUT, of the parallel amplifier circuit 874. The linear regulator 930, LDO, also includes a linear regulator power supply input 930D configured to receive the μC charge pump output voltage, $V_{μC\_OUT}$. The μC charge pump output voltage, $V_{μC\_OUT}$, may be configured provide a voltage level to the linear regulator power supply input 930D as a function of the battery voltage, $V_{BAT}$, and the expected output power of the radio frequency power amplifier 869.

The linear regulator 930, LDO, may also include a non-inverting input 930A in communication with the non-inverting input 928A of the parallel amplifier. The non-inverting input 930A of the linear regulator 930, LDO, may also be in communication with the differential filter 924, and configured to receive the control signal 926 at the non-inverting input 930A. The linear regulator 930, LDO, may also receive a linear regulator feedback signal, LDO FEEDBACK, from the output terminal 940A of the feedback selection switch 940. Based on the difference between the control signal 926 and the linear regulator feedback signal, LDO FEEDBACK, the linear regulator 930, LDO, may generate a linear regulator output voltage at the linear regulator output 930C. Based on the switch states of the linear regulator output selection switch 938 and the feedback selection switch 940, the linear regulator 930, LDO, may generate a linear regulator output voltage to apply the first linear regulator output current 878A, $I_{LDO}$, to the modulated power supply output 876.

Alternatively, the linear regulator 930, LDO, may generate the second linear regulator output voltage, $V_{LDO2}$, at the second linear regulator output 874D, $LDO_2$ OUTPUT. Although not depicted in Figure 2C, some alternative embodiments of the parallel amplifier circuit 874 may be configured to allow the linear regulator 930 to simultaneously apply the first linear regulator output current 878A, $I_{LDO}$, to the modulated power supply output 876 and generate the second linear regulator output voltage, $V_{LDO2}$. For example, in this case, the controller 50 may configure the linear regulator 930, LDO, to provide a second linear regulator output voltage, $V_{LDO2}$, at least equal to the minimum CMOS logic supply voltage based on a determination by the controller that the battery voltage, $V_{BAT}$, is about or less than the minimum CMOS logic supply voltage. For example, in some embodiments, the controller 50 may obtain a measurement of the battery voltage, $V_{BAT}$, from the battery level sense circuit 264. Based on a determination that the battery voltage, $V_{BAT}$ is less than a minimum CMOS logic supply voltage threshold, the controller 50 may configure the linear regulator 930, LDO, and the μC charge pump circuit 262 to cooperative generate a second linear regulator output voltage, $V_{LDO2}$, at least equal to the minimum CMOS logic supply voltage. In other alternative embodiments, the battery level sense circuit 264 may be configured to automatically detect that the battery voltage, $V_{-BAT}$, is less than the minimum CMOS logic supply voltage threshold, and configure the linear regulator 930, LDO, and the μC charge pump circuit 262 to cooperatively generate a second linear regulator output voltage, $V_{LDO2}$, at least equal to the minimum CMOS logic supply voltage.

Some embodiments of the radio frequency power amplifier 869 may include a CMOS logic 869E. As an example, the embodiment of the radio frequency power amplifier 869' depicted in Figure 8B. The CMOS logic 869E may control the operation of the radio frequency power amplifier 869. In some embodiments, the CMOS logic 869E may be powered by the battery voltage, $V_{BAT}$, received from the battery 20. The CMOS logic 869E may have a minimum CMOS logic supply voltage that corresponds to a minimum CMOS logic supply voltage threshold. Some embodiments of the radio frequency power amplifier 869 may have a minimum CMOS logic supply voltage substantially equal to 2.7 volts. Other embodiments of the radio frequency power amplifier 869 may have a minimum CMOS logic supply voltage substantially equal to 2.5 volts.

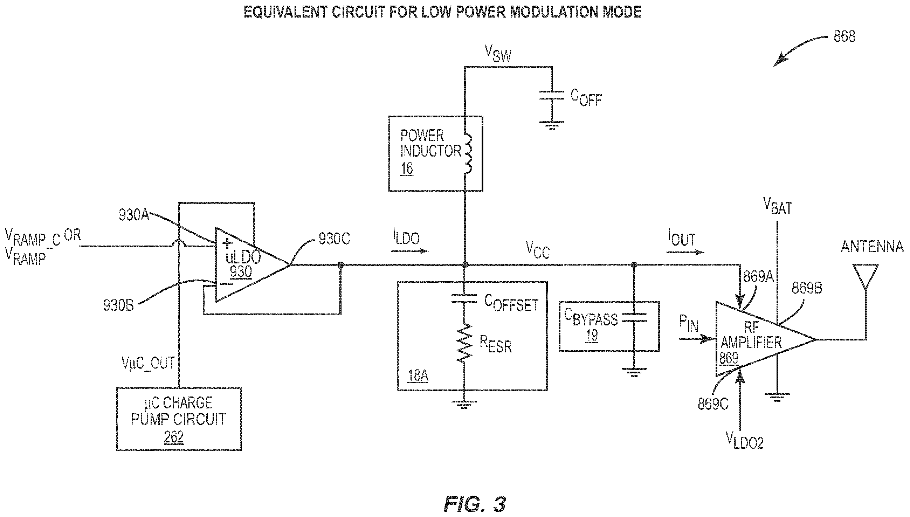

Figure 3 depicts an equivalent circuit of the power management system 870 when configured to operate in a low power modulation mode. The combination of the coupling capacitor 18A with the closed parallel amplifier output bypass switch 936 may be modeled as an impedance having an offset capacitance, $C_{OFFSET}$, and an equivalent series resistance (ESR), $R_{ESR}$. In addition, in the disabled state, the switch mode power supply converter 872 has an effective off state capacitance, $C_{OFF}$, which the linear regulator 930, LDO, must drive when the power management system 870 operates in the low power modulation mode.

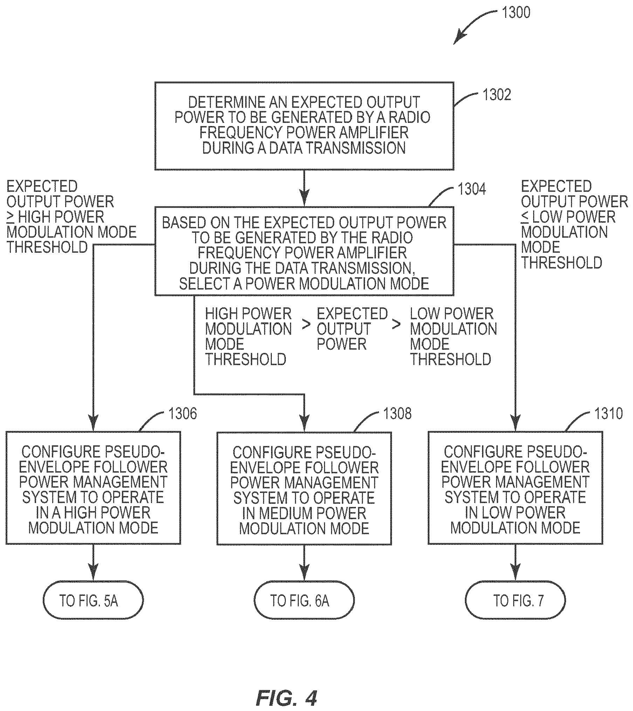

For the sake of convenience, and not by way of limitation, a method 1300, a method 1400, a method 1500, and a method 1600, depicted in Figure 4, Figures 5A-B, Figures 6A-B, and Figure 7, may describe various operations, tasks, functions, firmware, logic operations, hardware, analog logic or digital logic, a digital base band processing circuit, firmware, and/or software, a transceiver/communication device, and/or some combination thereof in terms of the controller 50 and/or the power management system 870. However, this is by way of description and not intended to limit the scope of the method 1300, the method 1400, the method 1500, and the method 1600. In addition, in some embodiments, the operations of the controller 50 and/or various selected portions of the power management system 870 may be incorporated into the hardware, software, and/or firmware of various components or portions of a transceiver/ communication device.

Figure 4 depicts the method 1300 for configuring the operation of the pseudo-envelope tracking modulated power supply system 868 that depends upon the expected output power to be generated by the radio frequency power amplifier 869 during a data transmission. The method 1300 is described with continuing reference to the pseudo-envelope tracking modulated power supply system 868 and the power management system 870, depicted in Figures 2A, 2B, 2C, and 3.

Initially, the pseudo-envelope tracking modulated power supply system 868 may determine an expected output power to be generated by a radio frequency power amplifier 869 during a data transmission. (Step 1302). For example, in some embodiments, the controller 50 may determine the expected output power to be generated by the radio frequency power amplifier 869 based upon the envelope characteristics of a data signal to be transmitted during a data transmission slot. In other embodiments, the digital baseband processing portion of the transceiver or modem that provides the differential $V_{RAMP}$ signal to the parallel amplifier circuit 874 and the modulated radio frequency input signal to be transmitted to the radio frequency power amplifier 869 may determine the expected output power to be generated by the radio frequency power amplifier 869. Based on the expected output power to be generated by the radio frequency power amplifier 869 during the data transmission, the power management system 870 may select a power modulation mode of operation from among a number of power modulation modes of operation. (Step 1304). For example, the power management system 870 depicted in Figure 4 includes a high power modulation mode, a medium power modulation mode, and a low power modulation mode. In the case where the expected output power to be generated by the radio frequency power amplifier 869 is greater than or equal to a high power modulation mode threshold, the power management system 870 configures the pseudo-envelope tracking modulated power supply system 868 to operate in a high power modulation mode. (Step 1306). Alternatively, in the case where the expected output power to be generated by the radio frequency power amplifier 869 is less than the high power modulation mode threshold but greater than a low power modulation mode threshold, the power management system 870 configures the pseudo-envelope tracking modulated power supply system 868 to operate in a medium power modulation mode. (Step 1308). In the case where the expected output power to be generated by the radio frequency power amplifier 869 is less than or equal to the low power modulation mode threshold, the power management system 870 may configure the pseudo-envelope tracking modulated power supply system 868 to operate in the low power modulation mode. (Step 1310).

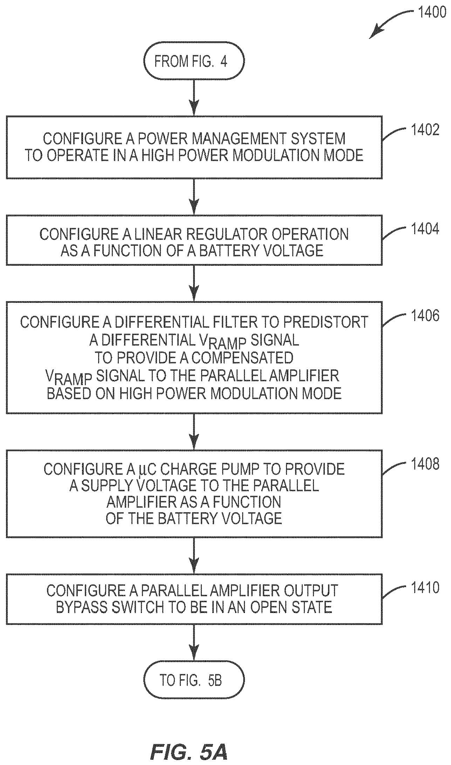

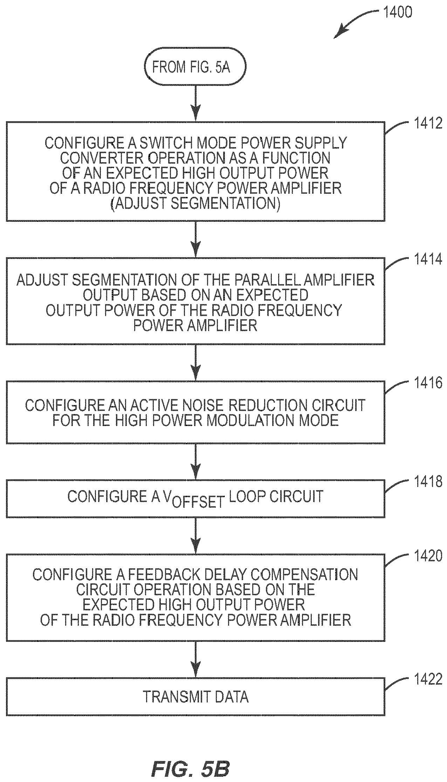

Figures 5A-B depict the method 1400 for configuring the operation of the pseudo-envelope tracking modulated power supply system 868 to operate in a high power modulation mode based on a determination that the expected output power to be generated by the radio frequency power amplifier 869 during a data transmission is greater than the high power modulation mode threshold. The method 1400 is described with continuing reference to the pseudo-envelope tracking modulated power supply system 868 depicted in Figures 2A, 2B, 2C, 3, 6A-B, and 7.

Prior to commencement of the data transmission, in response to the determination that the expected output power of the radio frequency power amplifier 869 will be less than the high power modulation mode threshold, the controller 50 may configure the power management system to operate in the high power modulation mode. (Step 1402). The controller 50 may configure the operation of the linear regulator 930, LDO. (Step 1404). For example, the controller 50 may configure the linear regulator output selection switch 938 and feedback selection switch 940 to disconnect the linear regulator output 930C from the modulated power supply output 876. Based on the battery voltage, $V_{BAT}$, and the minimum CMOS logic supply voltage, the controller 50 may configure the linear regulator 930, LDO, to provide a second linear regulator output voltage, $V_{LDO2}$, to the CMOS logic supply input 869C of the radio frequency power amplifier 869. In addition, the controller 50 may configure the $\mu C$ charge pump circuit 262 to provide a $\mu C$ charge pump output voltage, $V_{\mu C\_OUT}$, at least equal to the minimum CMOS logic supply voltage plus the headroom voltage of the linear regulator 930, LDO. For example, the controller 50 may configure the $\mu C$ charge pump circuit 262 to provide a $\mu C$ charge pump output voltage, $V_{\mu C\_OUT}$, at least sufficient for the linear regulator 930, LDO, to provide a second linear regulator output voltage, $V_{LDO2}$, to the CMOS logic supply input 869C that is substantially equal to the minimum CMOS supply voltage threshold. The controller 50 may determine an operation ratio of the $\mu C$ charge pump, $\mu BB_{RATIO}$, from among the available operation ratios of the $\mu C$ charge pump, $\mu BB_{RATIO}$, that produces a smallest $\mu C$ charge pump output voltage, $V_{\mu C\_OUT}$, to permit generation of the second linear regulator output voltage, $V_{LDO2}$, substantially equal to the minimum CMOS supply voltage threshold.

In addition, the controller 50 may determine an operation ratio of the $\mu C$ charge pump, $\mu BB_{RATIO}$, from among the available operation ratios of the $\mu C$ charge pump, $\mu BB_{RATIO}$, based on the maximum expected power amplifier supply voltage, $V_{CC\_MAX}$. Based on the maximum expected power amplifier supply voltage, $V_{CC\_MAX}$, the controller 50 determines a minimum $\mu C$ output voltage, $V_{\mu C\_OUT\_MIN}$, based on the maximum expected power amplifier supply voltage, $V_{CC\_MAX}$, and any losses between the $\mu C$ charge pump circuit 262 and the parallel amplifier 928. For example, in some embodiments, the parallel amplifier supply voltage input 928D may be switchably coupled to either the battery voltage, $V_{BAT}$, or the $\mu C$ charge pump output voltage, $Y_{\mu C\_OUT}$.

Based on the minimum $\mu C$ output voltage, $V_{\mu C\_OUT\_MIN}$, and the battery voltage, $V_{BAT}$, the controller 50 may determine an operation ratio of the $\mu C$ charge pump, $\mu BB_{RATIO}$, from among the available operation ratios of the $\mu C$ charge pump, $\mu BB_{RATIO}$, that generates a $\mu C$ charge pump output voltage, $V_{\mu C\_OUT}$, at least equal to the minimum $\mu C$ output voltage, $V_{\mu C\_OUT\_MIN}$. The controller 50 determines an operation ratio of the $\mu C$ charge pump, $\mu BB_{RATIO}$, having the smallest magnitude from among the available operation ratios of the $\mu C$ charge pump, $\mu BB_{RATIO}$, that permits the $\mu C$ charge pump circuit 262 to generate a $\mu C$ charge pump output voltage, $V_{\mu C\_OUT}$, at least equal to the minimum $\mu C$ output voltage, $V_{\mu C\_OUT\_MIN}$. The controller may configure the $\mu C$ charge pump circuit 262 to generate a $\mu C$ charge pump output voltage, $V_{\mu C\_OUT}$, sufficient to power both the parallel amplifier 928, and the CMOS logic circuit of the radio frequency power amplifier 869. In some embodiments, the controller 50 may further determine whether the minimum $\mu C$ output voltage, $V_{\mu C\_OUT\_MIN}$, is no more than the battery voltage, $V_{BAT}$. If the minimum $\mu C$ output voltage, $V_{\mu C\_OUT\_MIN}$, is no greater than the battery voltage, $V_{BAT}$, and the battery voltage, $V_{BAT}$, is less than the minimum CMOS supply voltage threshold, the controller 50 may configure the parallel amplifier 928 to be powered by the battery voltage, $V_{BAT}$. In this case, the controller 50 may then configure the $\mu C$ charge pump circuit 262 to generate a $\mu C$ charge pump output voltage, $V_{\mu C\_OUT}$, at least equal to the minimum CMOS supply voltage threshold plus the headroom voltage of the linear regulator 930, LDO. However, if the minimum $\mu C$ output voltage, $V_{\mu C\_OUT\_MIN}$, is greater than the battery voltage, $V_{BAT}$, and the minimum CMOS supply voltage threshold plus the headroom voltage of the linear regulator 930, LDO, the controller 50 may configure the $\mu C$ charge pump circuit 262 to generate a $\mu C$ charge pump output voltage, $V_{\mu C\_OUT}$, at least equal to the minimum $\mu C$ output voltage, $V_{\mu C\_OUT\_MIN}$.

The controller 50 may configure the differential filter 924 to pre-distort the differential $V_{RAMP}$ signal to provide a compensated $V_{RAMP}$ signal to the parallel amplifier 928 based on the magnitude of the expected output power to be generated by the radio frequency power amplifier 869. (Step 1406). The controller may configure the differential filter 924 to provide a maximum level of frequency compensation while operating in the high power modulation mode.

The controller 50 may configure the $\mu C$ charge pump circuit 262 to provide a supply voltage to the parallel amplifier 928 as a function of the battery voltage. (Step 1408). The controller 50 may configure the $\mu C$ charge pump circuit 262 to operate in the $4/3 \times V_{BAT}$ mode or the $1 \times V_{BAT}$ mode.

The controller 50 may configure the parallel amplifier output bypass switch 936 to be in an open state. (Step 1410). The controller 50 may configure the operation of the switch mode power supply converter 872 as a function of the expected high output power of the signal to be transmitted by the radio frequency power amplifier 869. (Step 1412). The controller 50 may compare the expected output power of the radio frequency power amplifier 869 to the maximum average power, $P_{MAX\_AVE}$, to determine the number of sets of series and shunt switches to enable. Based upon determination, the controller 50 configures the switcher control circuit 880. In some embodiments, the controller 50 may configure the switcher control circuit 880 to enable all of the sets of series and shunt switches while operating in the high power modulation mode.

The controller 50 may configure the segmentation configuration of the parallel amplifier 928 based on the expected parallel amplifier output current, $I_{PARA\_AMP}$. (Step 1414). For example, in the high power modulation mode, the controller 50 may set the segmentation configuration of the parallel amplifier 928 to enable all the output stage segments of the segmented parallel amplifier output stage.

The controller 50 may configure the active noise reduction circuit for the high power modulation mode. (Step 1416). The controller 50 may configure the active noise reduction circuit to provide a high level of noise reduction. For example, the controller 50 may set the programmable $I_{COR}$ transconductance value, $Gm_{ICOR}$, of the open loop ripple compensation assist circuit 414 to a high power modulation mode $I_{COR}$ transconductance value, $Gm_{ICOR\_HIGH\_POWER}$.

For example, in the case where the active noise reduction circuit is an open loop ripple compensation assist circuit 414, the controller 50 may configure the open loop ripple compensation assist circuit 414 to generate and apply a high frequency ripple compensation current 416, $I_{COR}$, based on the high power modulation mode $I_{COR}$ transconductance value, $GmI_{COR\_HIGH\_POWER}$, to the modulated power supply output 876 to reduce the noise present in the receive channel of a band of operation.

The controller 50 may configure the operation of the $V_{OFFSET}$ loop circuit 41. (Step 1418). The controller 50 may determine the target offset voltage parameter, $V_{OFFSET\_TARGET}$, of the $V_{OFFSET}$ loop circuit 41 based on the battery voltage, $V_{BAT}$, the expected envelope characteristics of the modulated radio frequency input signal to be transmitted, and the minimum offset voltage, $V_{OFFSET\_MIN}$. In addition, the controller 50 may configure the $V_{OFFSET}$ loop circuit 41 to operate in a pre-charge mode of operation as a function of the target offset voltage parameter, $VO_{FFSET\_TARGET}$, and the offset voltage, $V_{OFFSET}$, across the coupling capacitor 18A.

The controller 50 may configure the operation of the feedback delay compensation circuit 852 as a function of the expected output power of the radio frequency power amplifier 869. (Step 1420). As an example, the controller 50 may enable the feedback delay compensation circuit 852 and set the apparent gain of the feedback delay compensation circuit 852 as a function of the expected output power. For example, as the expected output power of the radio frequency power amplifier 869 increases, the controller may increase the apparent gain of the feedback delay compensation circuit 852.

After the power management system 870 is configured to operate in the medium power modulation mode, the data transmission is commenced. (Step 1422).

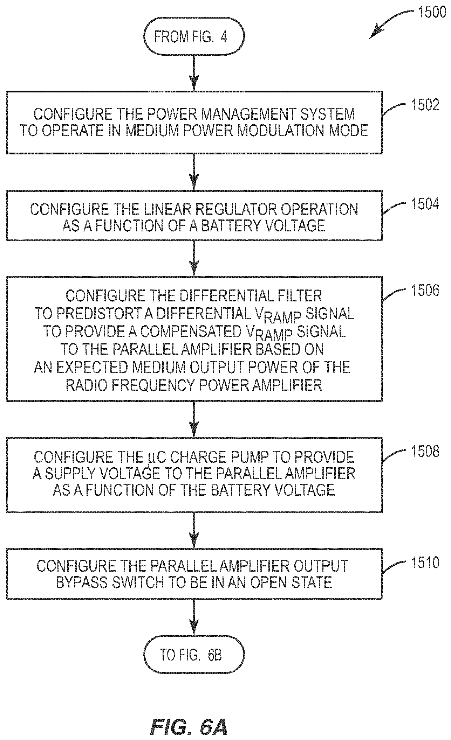

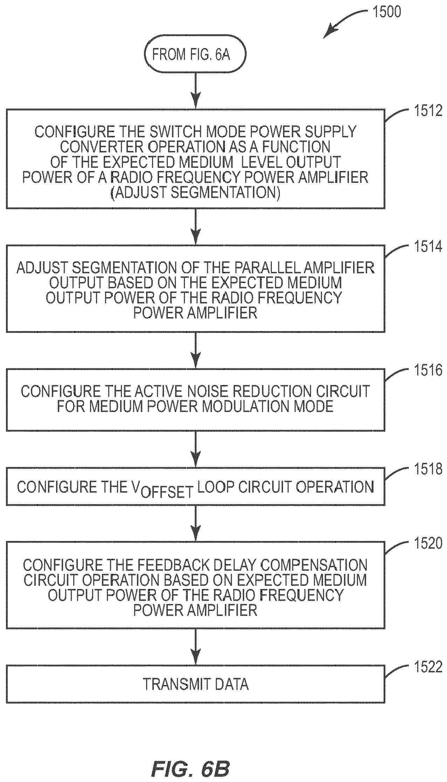

Figures 6A-B depict a method 1500 for configuring the operation of the pseudo-envelope tracking modulated power supply system 868 to operate in a medium power modulation mode based on a determination that the expected output power to be generated by the radio frequency power amplifier 869 during a data transmission is less than the high power modulation mode threshold but greater than a low power modulation mode threshold. The method 1500 is described with continuing reference to the pseudo-envelope tracking modulated power supply system 868 depicted in Figures 2A, 2B, 2C, 3, 5A-B, and 7. For the sake of convenience, and not by way of limitation, description of the method 1500 may refer to the controller 50. However, as discussed above, a digital base band processing portion of the transceiver/communication device and/or a combination of hardware and firmware associated with the power management system 870 may likewise operate in conjunction with the controller 50. In addition, the operations of controller 50 may be incorporated into the hardware and/or firmware of various components or portions of a transceiver/ communication device.

The controller 50 may configure the power management system 870 to operate in a medium power modulation mode based on the determination that the expected output power of the radio frequency power amplifier 969 is less than a high power modulation mode threshold and greater than a low power modulation mode threshold. (Step 1502).

The controller 50 may configure the operation of the linear regulator 930, LDO, to operate in the medium power modulation mode. As in the case where the battery voltage, $V_{BAT}$, is sufficient to power the CMOS logic circuit of the radio frequency power amplifier 869, the controller 50 may disable the linear regulator 930, LDO. Alternatively, in the event the battery voltage, $V_{BAT}$, is insufficient to power the CMOS logic circuit of the radio frequency power amplifier 869, the controller 50 may configure the linear regulator output selection switch 938 and feedback selection switch 940 to disconnect the linear regulator output 930C from the modulated power supply output 876. Based on the battery voltage, $V_{BAT}$, and the minimum operational voltage of the CMOS logic circuit, the controller 50 may configure the linear regulator 930, LDO, to provide the second linear regulator output voltage, $V_{LDO2}$, to the CMOS logic supply input 869C. In addition, the controller 50 may configure the μC charge pump circuit 262 to provide a sufficient charge pump output voltage, $V_{μC\_OUT}$, to permit operation of the radio frequency power amplifier 869. In the case where the battery voltage, $V_{BAT}$, is sufficient to provide the minimum operational voltage and the CMOS logic circuit, the controller 50 may disable the linear regulator 930, LDO, and configure the linear regulator output 930C to provide a high impedance load.

The controller 50 may configure the differential filter 924 to pre-distort the differential $V_{RAMP}$ signal used to provide a compensated $V_{RAMP}$ signal as the control signal 926 to the non-inverting input 928A, of the parallel amplifier 928. (Step 1506). The controller 50 may configure the differential filter 924 to provide a medium level of pre-distortion filtering to compensate for the frequency response of the parallel amplifier 928 and the parasitic impedances associated with of the radio frequency power amplifier 869.

The controller 50 may configure the μC charge pump circuit 262 to provide a supply voltage to the parallel amplifier 928 as a function of the battery voltage, $V_{BAT}$. (Step 1508). For example, the controller 50 may configure the μC charge pump circuit 262 to operate in the $1 \times V_{BAT}$ mode or the $2/3 \times V_{BAT}$ mode of operation.

The controller 50 may configure the parallel amplifier output bypass switch 936 to be in an open state. (Step 1510). The controller 50 may configure the operation of the switch mode power supply converter 872 as a function of the expected medium level output power of the signal to be transmitted by the radio frequency power amplifier 869.

(Step 1512). The controller 50 may compare the expected output power of the radio frequency power amplifier 869 to the maximum average power, $P_{MAX\_AVE}$, to determine the number of sets of series switch and shunt switch pairs to enable. Based upon determination, the controller 50 may configure the switcher control circuit 880 to enable the determined number of sets of series switches and shunt switches. In some embodiments, the controller 50 may configure the switcher control circuit 880 to enable either 75% or 50% of the sets of series switches and shunt switches while operating in the medium power modulation mode as a function of the expected output power of the radio frequency power amplifier 869. In addition, in some embodiments of the medium power modulation mode, the controller 50 may configure the switcher control circuit 880 to disabled the 2 x $V_{BAT}$ boost mode of the multi-level charge pump 882. In other embodiments, the controller 50 may configure the switcher control circuit 880 to configure the switch mode power supply converter 872 to further provide a switching voltage, $V_{SW}$, substantially equal to one of 3/2 x $V_{BAT}$, 1 x $V_{BAT}$, 1/2 x $V_{BAT}$, or 0 volts. In addition, in some embodiments, the controller 50 may configure the switcher control circuit 880 to decrease the number of sets of series and shunt switch pairs used to generate the switching voltage, $V_{SW}$, as a function of the magnitude of the expected output power of the radio frequency power amplifier 869 with respect to the maximum average power, $P_{MAX\_AVE}$.

The controller 50 may configure the parallel amplifier output stage segmentation of the parallel amplifier 928 based on the expected parallel amplifier output current, $I_{PARA\_AMP}$. (Step 1514). For example, in the medium power modulation mode, the controller 50 may determine the ratio of the maximum instantaneous output current, $I_{MAX\_PARA\_AMP}$, to the maximum parallel amplifier output current, $I_{PARA\_MAX}$. Based on the ratio of the maximum instantaneous output current, $I_{MAX\_PARA\_AMP}$, to the maximum parallel amplifier output current, $I_{PARA\_MAX}$, the controller 50 sets the segmentation configuration of the segmented parallel amplifier output stage of the parallel amplifier 928. For example, for the case where the parallel amplifier 928 includes two output stage segments with substantially equal current generation capacity, the controller 50 may set the segmentation configuration to 50% provided the ratio of the maximum instantaneous output current, $I_{MAX\_PARA\_AMP}$, to the maximum parallel amplifier output current, $I_{PARA\_MAX}$, is less than 50%. Otherwise, the controller 50 may set the segmentation configuration to be 100%.

The controller 50 may configure the active noise reduction circuit for the medium power modulation mode. (Step 1516). The controller 50 may configure the active noise reduction circuit to provide a medium level of noise reduction. For example, the controller 50 may set the programmable $I_{COR}$ transconductance value, $Gm_{ICOR}$, of the open loop ripple compensation assist circuit 414 to a medium power modulation mode $I_{COR}$ transconductance value, $Gm_{ICOR\_MEDIUM\_POWER}$.

For example, in the case where the active noise reduction circuit is an open loop ripple compensation assist circuit, the controller 50 may configure the open loop ripple compensation assist circuit 414 to generate and apply a high frequency ripple compensation current 416, $I_{COR}$, to the modulated power supply output 876 to reduce the noise present in the receive channel of a band of operation due to high frequency ripple current. The controller 50 may reduce the programmable $I_{COR}$ transconductance of the open loop ripple compensation assist circuit 414 as the expected output power of the radio frequency power amplifier 869 decreases to reduce the degree of active noise reduction.

The controller 50 may configure the operation of the $V_{OFFSET}$ loop circuit 41. (Step 1518). Based on the battery voltage, $V_{BAT}$, the expected envelope characteristics of the modulated radio frequency input signal to be transmitted, and the minimum offset voltage, $V_{OFFSET\_MIN}$, the controller 50 may configure the target offset voltage parameter, $V_{OFFSET\_TARGET}$, of the $V_{OFFSET}$ loop circuit 41. In addition, the controller 50 may configure the $V_{OFFSET}$ loop circuit 41 to operate a pre-charge mode of operation as a function of the target offset voltage parameter, $V_{OFFSET\_TARGET}$, and the offset voltage, $V_{OFFSET}$, across the coupling capacitor 18A.

The controller 50 may configure the operation of the feedback delay compensation circuit 852 as a function of the expected output power of the radio frequency power amplifier 869. (Step 1520). As an example, the controller 50 may enable the feedback delay compensation circuit 852 and set the apparent gain of the feedback delay compensation circuit 852 as a function of the expected output power. For example, as the expected output power of the radio frequency power amplifier 869 decreases, the controller 50 may decrease the apparent gain the feedback delay compensation circuit 852. After the power management system 870 is configured to operate in the medium power modulation, the data transmission is commenced. (Step 1522).

Figure 7 depicts the method 1600 for configuring the operation of the pseudo-envelope tracking modulated power supply system 868 to operate in a low power modulation mode based on a determination that the expected output power to be generated by the radio frequency power amplifier 869 during a data transmission is less than the high power modulation mode threshold but greater than a low power modulation mode threshold. The method 1600 is described with continuing reference to the pseudo-envelope tracking modulated power supply system 868 depicted in Figures 2A, 2B, 2C, 3, 5A-B, and 6A-B. For the sake of convenience, and not by way of limitation, description of the method 1600 may refer to the controller 50. However, as discussed above, a digital base band processing portion of the transceiver/communication device and/or a combination of hardware and firmware associated with the power management system 870 may likewise operate in conjunction with the controller 50. In addition, the operations of controller 50 may be incorporated into the hardware and/or firmware of various components or portions of a transceiver/ communication device.

The controller 50 may configure the power management system to operate in a low power modulation mode in response to a determination that the expected output power of the radio frequency power amplifier 869 is less than the low power modulation mode threshold. (Step 1602). The controller 50 may disable the parallel amplifier 928 and configure the parallel amplifier output 928C to be a high impedance load with respect to the parallel amplifier circuit output 874A. (Step 1604). In addition, the controller 50 may enable the parallel amplifier output bypass switch 936 to be in a closed state. (Step 1606). As a result, the negative terminal of the coupling capacitor 18A may short to ground.

The controller 50 may disable the switch mode power supply converter 872. For example, the switching circuit 884 may be disabled and configured to provide a high impedance path to ground at the switching voltage output 26. In addition, in some embodiments, the multi-level charge pump 882 may be disabled and configured to provide a high impedance path to ground at the charge pump output 64. In some alternative embodiments, as discussed above, the multi-level charge pump 882 may be configured to provide a high impedance path to ground at the charge pump output 64, but may be configured to generate a charge pump output voltage, $V_{CP\_OUTPUT}$ or generate the parallel amplifier supply voltage, $V_{SUPPLY\_PARA\_AMP}$, with the internal charge pump node parallel amplifier supply 294. (Step 1608). The controller 50 may also disable the active noise reduction circuit while the power management system 870 is configured to operate in low power modulation mode. For example, the controller 50 may disable the open loop ripple compensation assist circuit 414. In addition, the controller 50 may disable the $V_{OFFSET}$ loop circuit 41 and the feedback delay compensation circuit 852 while in the low power modulation mode. (Step 1610). The controller 50 may obtain an estimate of the battery voltage, $V_{BAT}$, from the battery level sense circuit 264. In addition, the controller 50 may obtain or determine the maximum expected power amplifier supply voltage, $V_{CC\_MAX}$. based on an envelope characteristic of the modulated radio frequency signal to be transmitted by the radio frequency power amplifier 869. Based on the maximum expected power amplifier supply voltage, $V_{CC\_MAX}$, the battery voltage, $V_{BAT}$, and the maximum headroom voltage of the linear regulator 930, LDO, the controller 50 may select a minimum value of the operational ratio of the μC charge pump, $\mu BB_{RATIO}$, to permit the linear regulator 930, LDO, to generate the maximum expected power amplifier supply voltage, $V_{CC\_MAX}$. during the data transmission. For example, the μC charge pump circuit 262 may typically operate in one of the 1/4 x $V_{BAT}$ mode, 1/3 x $V_{BAT}$ mode, or the 1/2 x $V_{BAT}$ mode when the power management system 870 is configured to operate in the low power modulation mode. (Step 1612).

In some alternative embodiments, not depicted in Figure 2C, the linear regulator 930, LDO, may also switchably provide a supply voltage to the CMOS logic supply input 869C. In this case, the controller 50 may further determine whether the battery voltage, $V_{BAT}$, is less than the minimum CMOS logic supply voltage. Based on a determination that the battery voltage, $V_{BAT}$, is less than the minimum CMOS logic supply voltage, the controller 50 may determine a minimum value of the operational ratio of the μC charge pump, $\mu BB_{RATIO}$, necessary to generate a second linear regulator output voltage, $V_{LDO2}$, at least equal to the minimum CMOS logic supply voltage. Thereafter, the controller 50 may configure the μC charge pump circuit 262 to generate a μC charge pump output voltage, $V_{\mu C\_OUT}$, having the lowest voltage level that is sufficient to generate the maximum expected power amplifier supply voltage, $V_{CC\_MAX}$. and at least equals the minimum CMOS logic supply voltage plus the headroom voltage of the linear regulator 930. In some embodiments, the controller 50 may configure the μC charge pump circuit 262 to provide a second linear regulator output voltage, $V_{LDO2}$, to provide at least a second linear regulator output voltage, $V_{LDO2}$, at least equal to the minimum CMOS logic supply voltage.

The controller 50 may select the linear regulator mode of operation based on the tracking mode of the power management system 870. (Step 1614). In response to an indication that the to be transmitted modulated radio frequency input signal will produce a substantially fixed DC reference voltage, the power management system 870 may be configured for a no tracking mode of operation. In the no tracking mode of operation, the power management system may configure the differential filter 924 to provide no frequency response compensation. (Step 1616). Thereafter, the data transmission commences. (Step 1622). However, based on a determination that the tracking mode of the power management system 870 is set to operate in a slow tracking mode, the digital base band processing portion of a transceiver/communication device may be configured to provide a differential $V_{RAMP}$ signal that provides for a slow tracking mode (Step 1618). The controller may configure the differential filter 924 to provide a low amount of frequency response compensation or correction based on the expected output power of the radio frequency power amplifier 869. (Step 1620). Thereafter, the data transmission commences. (Step 1622).

Figures 8A-B depict an embodiment of a pseudo-envelope tracking modulated power supply system 868A that includes a radio frequency power amplifier 869'. The radio frequency power amplifier 869' may be powered by various embodiments of a power management system 870A. The various embodiments of the pseudo-envelope tracking modulated power supply system 868A and the power management system 870A may be similar to the respective embodiments of the pseudo-envelope tracking modulated power supply system 868 and the power management system 870, which are depicted in Figures 2A-B and Figure 3. An example embodiment of a number of power level modulation modes of the power management system 870 are depicted in Figures 4, 5A-B, 6A-B, and 7.

The power management system 870A may include the switch mode power supply converter 872 and a parallel amplifier circuit 874'. In addition to the parallel amplifier circuit output 874A, the first linear regulator output 874B, LDO₁

26

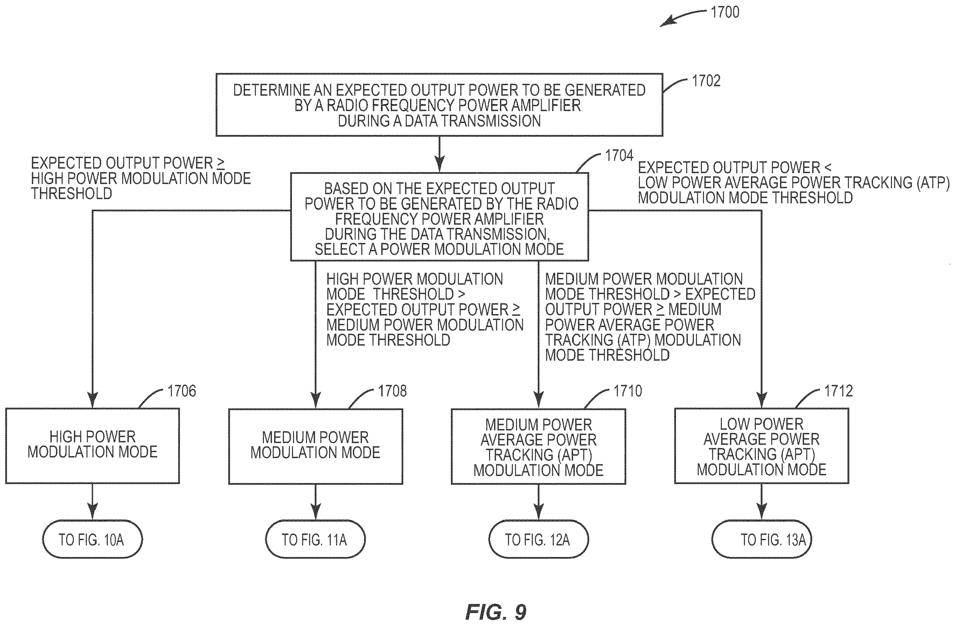

OUTPUT, and the second linear regulator output 874D, LDO$_2$ OUTPUT, the embodiments of a pseudo-envelope tracking modulated power supply system 868A may include a radio frequency power amplifier 869'. The power management system 870A may be configured to power the radio frequency power amplifier 869' as a function of the expected output power to be generated by the radio frequency power amplifier 869' in a data transmission of a modulated radio frequency input signal provided to the radio frequency power amplifier for transmission. Figure 9, Figures 10A-B, Figures 11A-B, Figures 12A-B, and Figure 13 depict embodiments of a number of power level modulation modes of the power management system 870A.

Some embodiments of the power management system 870A may include a parallel amplifier circuit 874'. Similar to the parallel amplifier circuit 874, depicted in Figure 2C, the parallel amplifier circuit 874' may include the parallel amplifier circuit output 874A, the first linear regulator output 874B, LDO$_1$ OUTPUT, and the second linear regulator output 874D, LDO$_2$ OUTPUT, the switch mode power supply converter control output 874E, and the modulated power supply voltage feedback input 874F. In addition, the parallel amplifier circuit 874' may further include a V$_{CMOS}$ output 874C configured provide a CMOS logic supply voltage 878C, V$_{CMOS}$, to the CMOS logic supply input 869C of the radio frequency power amplifier 869' as a function of the battery voltage, V$_{BAT}$.

The parallel amplifier circuit output 874A may be in communication with the modulated power supply output 876. In some embodiments, the parallel amplifier circuit output 874A may be coupled to the modulated power supply output 876 via the coupling capacitor 18A. The first linear regulator output 874B, LDO$_1$ OUTPUT, may be in communication with the modulated power supply output 876. The V$_{CMOS}$ OUTPUT, 874C may be in communication with the CMOS logic supply input 869C of the radio frequency power amplifier 869'. The second linear regulator output 874D, LDO$_2$ OUTPUT, may be in communication with the driver supply voltage input 869D of the radio frequency power amplifier 869'. The switch mode power supply converter control output 874E may be in communication with the switch mode power supply converter 872, and configured to provide a switch mode power supply feedback signal 40A to the switcher control circuit 880. The modulated power supply voltage feedback input 874F may be in communication with the modulated power supply output 876. In some embodiments, the parallel amplifier circuit 874' may also provide the threshold offset current 42, I$_{THRESHOLD\_OFFSET}$, to the switch mode power supply converter 872 as a function of the power level modulation mode to govern the operation of the switch mode power supply converter 872.

Some embodiments of the power management system 870A may be configured to operate in a number of power level modulation modes. In addition, in some embodiments, the power management system 870A may be configured to operate based on various sets of the number of power level modulation. For example, in some embodiments, the power management system 870A may be configured to operate in a set of power level modulation modes that includes a high power modulation mode, a medium power modulation mode, a medium power average power tracking modulation mode, and a low power average power tracking modulation mode, depicted in Figure 9, Figure 10A-B, Figure 11A-B, Figure 12A-B, and Figure 13. In addition, the power management system 870 may be configured to operate in a set of power level modulation modes that include a high power modulation mode, a medium power modulation mode, and a low power average power tracking modulation mode that may be similar to the operation of the power management system 870 and the low power modulation mode, described with respect to the Figures 2A-C, 3, 4, and 7.

In the high power modulation mode and the medium power modulation, the power management system 870A may configure the parallel amplifier circuit 874' to generate a parallel amplifier output current, I$_{PAWA\_OUT}$, from the parallel amplifier circuit output 874A to regulate the modulated power supply voltage, V$_{CC}$. The parallel amplifier output current, I$_{PAWA\_OUT}$, may be applied to the modulated power supply output 876 to regulate generation of the modulated power supply voltage, V$_{CC}$, as a function of the differential V$_{RAMP}$ signal. The modulated power supply voltage, V$_{CC}$, may be provided to the collector voltage supply input 869A to power the final output stage 869G of the radio frequency power amplifier 869'. In the medium power average power tracking modulation mode and the low power average power tracking modulation mode, the power management system 870A may configure the parallel amplifier circuit 874' to provide a low impedance path to ground at the parallel amplifier circuit output 874A in order to provide additional bypass capacitance for the modulated power supply output 876. For example, configuring the parallel amplifier circuit output 874A to provide a low impedance path to ground effectively puts the coupling capacitor 18A in parallel with the bypass capacitor 19.

In the high power modulation mode and the medium power modulation mode, the power management system 870A may configure the parallel amplifier circuit 874' to apply the parallel amplifier output current, I$_{PAWA\_OUT}$ to the modulated power supply output 876.

In some embodiments, in the high power modulation mode, the medium power modulation mode, and the medium power average power modulation mode, the power management system may configure the first linear regulator output 874B to provide a high impedance path to ground. In the low power average power tracking modulation mode, the power management system 870A may configure the parallel amplifier circuit 874' to generate a first linear regulator output current 878B, I$_{LDO}$, at the first linear regulator output 874B, LDO$_1$ OUTPUT, a function of the differential V$_{RAMP}$ signal. The first linear regulator output current 878B, I$_{LDO}$, may be applied to the modulated power supply output 876 to generate the modulated power supply voltage, V$_{CC}$. The modulated power supply voltage, V$_{CC}$, generated by the first linear regulator output current 878B, I$_{LDO}$, may be provided to the collector voltage supply input 869A to power the final output stage 869G of the radio frequency power amplifier 869'.

In each of the high power modulation mode, the medium power modulation mode, the medium power average power tracking modulation mode and the low power average power tracking modulation mode, the power management system 870A may configure the parallel amplifier circuit 874' generate a CMOS logic circuit supply voltage, $V_{CMOS}$, at the $V_{CMOS}$ OUTPUT, 874C as a function of the battery voltage, $V_{BAT}$.

In some embodiments, the parallel amplifier circuit 874' may selectively provide a CMOS logic circuit supply voltage, $V_{CMOS}$, substantially equal to the battery voltage, $V_{BAT}$, based on a determination that the battery voltage, $V_{BAT}$, is at least equal to a minimum CMOS logic supply voltage threshold. Based on a determination that the battery voltage, $V_{BAT}$, is near or below the minimum CMOS logic supply voltage threshold, the parallel amplifier circuit 874' may provide a CMOS logic circuit supply voltage, $V_{CMOS}$, at least equal to the minimum CMOS logic supply voltage as a function of the battery voltage, $V_{BAT}$, and the minimum CMOS logic supply voltage threshold. In some alternative embodiments, the power management system 870A may configure the parallel amplifier circuit 874' to generate the CMOS logic circuit supply voltage, $V_{CMOS}$, at least equal to the minimum CMOS logic supply voltage only based on the determination that the battery voltage, $V_{BAT}$, is less than the minimum CMOS logic supply voltage threshold.

In the high power modulation mode, the medium power modulation mode, the medium power average power tracking modulation mode, and the low power modulation mode, the power management system 870A may configure the parallel amplifier circuit 874' to generate a second linear regulator output voltage, $V_{LDO2}$, at the second linear regulator output 874D, $LDO_2$ OUTPUT. The second linear regulator output voltage, $V_{LDO2}$, may be provided to the driver supply voltage input 869D of the radio frequency power amplifier 869'. In some embodiments, the power management system 870A may configure the parallel amplifier circuit 874' to generate the second linear regulator output voltage, $V_{LDO2}$, as a function of the differential $V_{RAMP}$ signal in the medium power average power tracking modulation mode and the low power average power tracking mode.

In the high power modulation mode and the medium power modulation mode, the power management system 870A may configure the parallel amplifier circuit 874' to generate the switch mode power supply feedback signal 40A to govern the generation of the switching voltage, $V_{SW}$, as a function of the parallel amplifier circuit output current, $I_{PAWA\_AMP}$.

In the medium power average power tracking modulation mode, the power management system 870A may configure the parallel amplifier circuit 874' to generate the switch mode power supply feedback signal 40A to govern the generation of the switching voltage, $V_{SW}$, as a function of the differential $V_{RAMP}$ voltage.

In the embodiments of a pseudo-envelope tracking modulated power supply system 868A that include the coupling capacitor 18A, the power management system 870A may configure the parallel amplifier circuit 874' to generate a threshold offset current, $I_{THRESHOLD\_OFFSET}$, to regulate an offset voltage, $V_{OFFSET}$, across the coupling capacitor 18A when configured to operate in the high power modulation mode and the medium power modulation mode. For some alternative embodiments of the parallel amplifier circuit 874', the power management system 870A may configure the parallel amplifier circuit 874' to generate a threshold offset current, $I_{THRESHOLD\_OFFSET}$, to govern generation of the switching voltage, $V_{SW}$, and regulate the modulated power supply voltage, $V_{CC}$. In this case, the power management system 870A may configure the parallel amplifier circuit 874' to generate the threshold offset current, $I_{THRESHOLD\_OFFSET}$, to govern the generation of the switching voltage, $V_{SW}$, as a function of the differential $V_{RAMP}$ voltage.

Figure 8B depicts a parallel amplifier circuit 874' that is similar in form and function to the parallel amplifier circuit 874 depicted in Figure 2C. However, the parallel amplifier circuit 874' may further include a low power differential to single-ended converter 942, an average power tracking controller circuit 944, a first parallel amplifier feedback impedance 946 having a first impedance, $Z_1$, and a second parallel amplifier feedback impedance 948 having a second impedance, $Z_2$.

Figure 8B depicts that the low power differential to single-ended converter 942 including a non-inverting input that is configured to receive the differential $V_{RAMP}$ signal. Operationally, the non-inverted $V_{RAMP}$ signal component, $V_{RAMP+}$, is provided to the non-inverting input 942A and the inverted $V_{RAMP}$ signal component, $V_{RAMP-}$, is provided to the inverting input 942B of the low power differential to single ended converter 942. Based on the difference between the non-inverting input 942A and the inverting input 942B, the low power differential to single ended converter 942 generates the $V_{RAMP}$ signal at the single ended output 942C. In the medium power average power tracking mode and the low power average power tracking mode, some embodiments of the power management system 870A may disable the differential filter 924 and enable the low power differential to single-ended converter 942 to generate the $V_{RAMP}$ signal as a function of the differential $V_{RAMP}$ signal.

The average power tracking controller circuit 944 may include a non-inverting input 944A configured to receive the $V_{RAMP}$ signal from the single ended output 942C, an inverting input 944B configured to receive the modulated power supply voltage, $V_{CC}$, and an average power tracking control signal output 944C configured to generate an average power tracking control signal 966. The average power tracking controller circuit 944 may be configured to generate the average power tracking control signal at the average power tracking controller signal output 944C as a function of a difference between the $V_{RAMP}$ signal and the modulated power supply voltage, $V_{CC}$.

For example, some embodiments of the average power tracking controller circuit 944 may include a front-end stage (not depicted) that is similar in form and/or function to a differential amplifier. As an example, in some embodiments, the average power tracking controller circuit 994 may use a front-end stage similar to the parallel amplifier front-end stage. The average power tracking controller circuit 944 may generate a current substantially equal to the product of the difference between the $V_{RAMP}$ signal and the modulated power supply voltage, $V_{CC}$, multiplied by a programmable average power tracking transconductance, $Gm_{APT}$, as the average power tracking control signal 966. For example, in some embodiments, the average power tracking control signal 966 may be a current substantially equal to $Gm_{APT}$ x $(V_{RAMP} - V_{CC})$.

Accordingly, in some embodiments, the magnitude of the average power tracking control signal 966 may represent a difference between a target output voltage for the modulated power supply voltage, $V_{CC}$, provided by the $V_{RAMP}$ signal and the modulated power supply voltage, $V_{CC}$, at the modulated power supply output 876. The average power tracking control signal 966 may provide an indication of an instantaneous error voltage between a target voltage for the modulated power supply output 876 and the modulated power supply voltage, $V_{CC}$.

In the case where the power management system 870A is configured to operate in an average power tracking modulation mode, the average power tracking control signal 966 may be provided to the switcher control circuit 880, depicted in Figure 2B, as an error signal to control the generation of the switching voltage, $V_{SW}$, at the switching voltage output 26. In the case where the switcher control circuit 880 uses the average power tracking control signal 966 as a composite control signal while operating in an average power tracking mode, the controller 50 may configure a magnitude of the programmable average power tracking transconductance, $Gm_{APT}$, to adjust the frequency of operation of the switch mode power supply converter 872 in the average power tracking modes of operation. In addition, the controller 50 may also adjust the programmable average power tracking transconductance, $Gm_{APT}$, as a function of a ripple voltage at the modulated power supply output 876.

For example, in some embodiments, the controller 50 may increase the magnitude of the programmable average power tracking transconductance, $Gm_{APT}$, to increase a loop gain of the switch mode power supply converter 872 when operating in the average power tracking mode in order to reduce the ripple voltage at the modulated power supply output 876.

As another example, in some embodiments, the controller 50 may increase the magnitude of the programmable average power tracking transconductance, $Gm_{APT}$, as a function of the average expected output power, $P_{OUT\_AVE}$. For example, as the average expected output power, $P_{OUT\_AVE}$, increases, the controller 50 may increase the magnitude of the programmable average power tracking transconductance, $Gm_{APT}$, in order to minimize the ripple voltage generated at the modulated power supply output 876. In other words, as the load placed on the switch mode power supply converter 872 is increased, the loop gain may be increased to minimize the ripple voltage at the modulated power supply output 876. Similarly, the controller 50 may decrease the magnitude of the programmable average power tracking transconductance, $Gm_{APT}$, as the average expected power, $P_{OUT\_AVE}$, decreases to ensure stability of the switch mode power supply converter 872 and minimize the ripple voltage generated at the modulated power supply output 876.

In some embodiments, the power management system 870A may further adjust the programmable average power tracking transconductance, $Gm_{APT}$, as a function of the expected output power to be generated by the radio frequency power amplifier 869' to adjust the gain of the control loop of the switch mode power supply converter 872. In addition, the average power tracking controller circuit 944 may include a number of expected output power thresholds that may be used to adjust the programmable average power tracking transconductance, $Gm_{APT}$, as a function of the expected output power of the radio frequency power amplifier 869'.

For example, as the expected output power of the radio frequency power amplifier 869' increases, the power management system 870A may increase the magnitude of the programmable average power tracking transconductance, $Gm_{APT}$, to increase switching frequency of the switch mode power supply converter 872. As a result, the modulated power supply output 876 may provide additional current to the collector voltage supply input 869A of the radio frequency power amplifier 869' while maintaining a target voltage for the modulated power supply voltage, $V_{CC}$, determined by the differential $V_{RAMP}$ signal.

In some embodiments, when the expected output power of the radio frequency power amplifier 869' decreases below an output power threshold level, the power management system 870A may decrease the magnitude of the programmable average power tracking transconductance, $Gm_{APT}$, to decrease the gain of the control system and ensure stability of the switch mode power supply converter 872 or reduce the switching frequency of the switch mode power supply converter 872. In some embodiments, the power management system 870A may increase the programmable average power tracking transconductance, $Gm_{APT}$, for an initial period of time to pre-charge the modulated power supply voltage, $V_{CC}$, to a desired level and then decrease the programmable average power tracking transconductance, $Gm_{APT}$, to a normal operational level to ensure system stability.

The power management system 870A may enable the average power tracking controller circuit 944 when the expected output power of the radio frequency power amplifier 869' is less than the medium power modulation mode threshold. In the case where the expected output power of the radio frequency power amplifier 869' is least equal to the medium power modulation mode threshold, the low power differential to single ended converter 942 and the average power tracking controller circuit 944 may be disabled. In addition, the power management system 870A may disable the average power tracking controller circuit 944 when the switch mode power supply converter 872 is disabled. For example, in some embodiments of the low power average power tracking modulation mode, the power management system 870A may disable the switch mode power supply converter and the average power tracking controller circuit 944.

The first parallel amplifier feedback impedance 946, $Z_1$, may be coupled between the inverting input 928B of the parallel amplifier 928 and the modulated power supply voltage feedback input 874F. The second parallel amplifier feedback impedance 948, $Z_2$, may be coupled between the inverting input 928B of the parallel amplifier 928 and ground. The impedance of the first parallel amplifier feedback impedance 946, $Z_1$, and the impedance of the second parallel feedback impedance 948, $Z_2$, may be programmable impedances. For example, the first parallel amplifier feedback impedance 946, $Z_1$, may include a programmable resistor array, a programmable capacitor array, and/or a combination thereof. In addition, the impedance of the second parallel feedback impedance 948, $Z_2$, may include a programmable resistor array, a programmable capacitor array, and/or a combination thereof. The controller 50 may be configured to adjust the programmable impedances of the first parallel amplifier feedback impedance 946, $Z_1$, and the second parallel feedback impedance 948, $Z_2$, to adjust the gain and the frequency response of the parallel amplifier 928. For example, in some embodiments, the controller 50 may adjust the first parallel amplifier feedback impedance 946, $Z_1$, and the second parallel feedback impedance 948, $Z_2$, to configure the frequency response or the gain of the parallel amplifier 928 as a function of the expected output power of the radio frequency power amplifier 869'. For example, the controller 50 may configure the first parallel amplifier feedback impedance 946, $Z_1$, and the second parallel feedback impedance 948, $Z_2$, to provide additional frequency compensation based on a determination to configure the power management system 870A is operating in a high power modulation mode. Alternatively, the controller 50 may configure the first parallel amplifier feedback impedance 946, $Z_1$, and the second parallel feedback impedance 948, $Z_2$, to provide less frequency compensation based on a determination to configure the power management system 870A in the medium power modulation mode of operation.

The parallel amplifier circuit 874' may include a first linear regulator 950, $LDO_1$, configured to provide the linear regulator output current 878B, $I_{LDO}$, to the first linear regulator output 874B, $LDO_1$ OUTPUT, and a second linear regulator 952, $LDO_2$, configured to generate the second linear regulator output voltage, $V_{LDO2}$, at the second linear regulator output 874D, $LDO_2$ OUTPUT. In some embodiments, the first linear regulator 950, $LDO_1$, and the second linear regulator 952, $LDO_2$, may be low drop out voltage linear regulators. In addition, the parallel amplifier circuit 874' may further include a (DAC) programmable digital to analog converter 954, and a second signal control multiplexer 956 configured to provide a second linear regulator control voltage, $V_{CONTROL\_LDO2}$, to the second linear regulator 952, $LDO_2$.

The first linear regulator 950, $LDO_1$, may include a non-inverting input 950A configured to receive the $V_{RAMP}$ signal, an inverting input 950B coupled to the first regular regulator output 950C, which is configured to provide a first linear regulator output, $LDO_1$ Output, to the modulated power supply output 876. The first linear regulator 950, $LDO_1$, further includes a power supply input 950D configured to receive the $\mu$C charge pump output voltage, $V_{\mu C\_OUT}$, from the $\mu$C charge pump circuit 262. The $\mu$C charge pump output voltage, $V_{\mu C\_OUT}$, is also provided to a noise filter 958. The noise filter 958 may be a passive low pass filter configured to remove switching noise on the $\mu$C charge pump output voltage, $V_{\mu C\_OUT}$.

The second signal control multiplexer 956 may include a first input 956A configured to receive the $V_{RAMP}$ signal, a second input 956B configured to receive a programmable reference voltage from a programmable digital to analog converter 954, and a multiplexer output 954C configured to provide a second linear regulator control voltage, $V_{CONTROL\_LDO2}$, to the non-inverting input 952A of a second linear regulator 952, $LDO_2$. In the high power modulation mode and the medium power modulation mode, the power management system 870A may configure the programmable digital to analog converter (DAC) 954 to provide the programmable reference voltage as a target voltage to be generated by the second linear regulator 952, $LDO_2$. The second signal control multiplexer 956 may be configured to provide the programmable reference voltage as the second linear regulator control voltage, $V_{CONTROL\_LDO2}$, to the non-inverting input 952A of a second linear regulator 952, $LDO_2$. In the medium power average power tracking modulation mode, the low power modulation mode modulation mode, and the low power modulation mode, the power management system 870A may configure the second signal control multiplexer 956 to provide the $V_{RAMP}$ signal as the second linear regulator control voltage, $V_{CONTROL\_LDO2}$, to the non-inverting input 952A of a second linear regulator 952, $LDO_2$.

The second linear regulator 952 further includes an inverting input 952B coupled to the second linear regulator output 952C of the second linear regulator 952, $LDO_2$. The second linear regulator 952, $LDO_2$ may be configured to provide a second linear regulator output, $LDO_2$ OUTPUT, to the radio frequency power amplifier 869' as a function of the battery voltage, $V_{BAT}$. The controller 50 may configure the programmable digital to analog converter (DAC) 954 to provide the target voltage to be generated by the second linear regulator 952, $LDO_2$. In response to receipt of the second linear regulator control voltage, $V_{CONTROL\_LDO2}$, the second linear regulator 952, $LDO_2$, provides a second linear regulator output voltage, $V_{LDO2}$, to the driver supply voltage input 869D to power the driver 869F.

The parallel amplifier circuit 874' may further include a noise filter 958 including an input terminal configured to receive the $\mu$C charge pump output voltage, $V_{\mu C\_OUT}$, and an output terminal configured to provide a filtered $\mu$C

charge pump output voltage, $Y_{\mu C\_FILTERED}$, to a first input terminal 960A of a first power supply selection switch 960. In some embodiments, the noise filter 958 includes a PI network filter. In some embodiments, the PI network filter may be a PI LC filter or a PI CLC Filter. In some alternative embodiments, the noise filter 958 may include one or more bypass capacitors coupled between the input terminal of the noise filter 958 and ground, one or more bypass capacitor coupled between the output terminal of the noise filter 958 and ground, and the inductor or inductive having a first terminal in communication with the input terminal of the noise filter 958 and a second terminal in communication with the output terminal of the noise filter 958. Some embodiments of the noise filter 958 may be implemented in an integrated circuit (IC) while other portions of the noise filter 958 are external to the integrated circuit. For example, the noise filter 958 may include one or more of a discrete inductive component and one or more of a discrete capacitor that are external to the integrated circuit and couple to or between the input terminal and the output terminal of the noise filter 958.

The first power supply selection switch 960 may include a second input terminal 960B configured to receive the battery voltage, $V_{BAT}$, and an output terminal 960C configured to provide a selected supply voltage, $V_{DD\_SELECTED}$, to the second linear regulator power supply input 952D.

Depending on the minimum driver supply voltage, the power supply selection switch 960 may be configured to provide either the filtered $\mu C$ charge pump output voltage, $V_{\mu C\_FILTERED}$, or the battery voltage, $V_{BAT}$, to the second linear regulator power supply input 952D. For example, as described above, the controller 50 may determine the minimum driver supply voltage threshold as a function of the expected output power to be generated by the radio frequency power amplifier 869'. If the minimum driver supply voltage threshold is more than the battery voltage, $V_{BAT}$, less the headroom of the power supply selection switch 960 and headroom of the second linear regulator 952, $LDO_2$, the controller 50 configures the power supply selection switch 960 to provide the filtered $\mu C$ charge pump output voltage, $Y_{\mu C\_FILTERED}$, to the second linear regulator power supply input 952D. In addition, the controller 50 may configure the $\mu C$ charge pump output voltage, $V_{\mu C\_OUT}$, to be at least equal to the headroom of the power supply selection switch 960 and headroom of the second linear regulator 952, $LDO_2$, plus the minimum driver supply voltage threshold and any voltage drop that occurs in the noise filter 958. However, in the case where the minimum driver supply voltage threshold is less than the battery voltage, $V_{BAT}$, the controller 50 may configure the power supply selection switch 960 to provide the lesser of the filtered $\mu C$ charge pump output voltage, $V_{\mu C\_FILTERED}$, and the battery voltage, $V_{BAT}$, that permits the second linear regulator 952, $LDO_2$, to provide a second linear regulator output voltage, $V_{LDO2}$, at least equal to the minimum driver supply voltage threshold to the driver supply voltage input 869D in order to power the driver 869F.

The parallel amplifier circuit 874' may include an embodiment of the open loop ripple compensation assist circuit 414 as an active noise reduction circuit. In the high power modulation mode and the medium power modulation mode, the open loop ripple compensation assist circuit 414 may generate a high frequency ripple compensation current 416, $I_{COR}$. The high frequency ripple compensation current 416, $I_{COR}$, may be applied to the modulated power supply output 876 to reduce the voltage ripple generated at the modulated power supply output 876 by the switching action of switch mode power supply converter 872. In the high power modulation mode, the controller 50 may configure the open loop ripple compensation assist circuit 414 to generate the high frequency ripple compensation current 416, $I_{COR}$, as a function of a high power modulation mode $I_{COR}$ transconductance value, $Gm_{ICOR\_HIGH\_POWER}$. In the medium power modulation mode, the controller 50 may configure the open loop ripple compensation assist circuit 414 to generate the high frequency ripple compensation current 416, $I_{COR}$, as a function of a medium power modulation mode $I_{COR}$ transconductance value, $GM_{ICOR\_MEDIUM\_POWER}$. In the high power modulation mode, the controller 50 may set the programmable $I_{COR}$ transconductance, $Gm_{ICOR}$, to the high power modulation mode $I_{COR}$ transconductance value, $Gm_{ICOR\_HIGH\_POWER}$. The open loop ripple compensation assist circuit 414 may generate the scaled high frequency ripple compensation current estimate 418, $I_{COR\_SENSE}$, that is proportional to the high frequency ripple compensation current 416, $I_{COR}$.

In contrast, the controller 50 may disable the open loop ripple compensation assist circuit 414 in the low power modulation mode, the medium power average power tracking modulation mode, and the low power average power tracking modulation mode. Instead, the power management system 870A may depend on the additional decoupling capacitance of the relatively large capacitance value of the coupling capacitor 18A, which is switchably couple between the modulated power supply output 876 and ground in the medium power average power tracking modulation mode and the low power average power tracking modulation mode.

Also, in some modes of operation in the medium power modulation mode, the power management system 870A may disable all active noise reduction circuits as a function of the expected output power to be generated by the radio frequency power amplifier 869' during a data transmission, a band of operation in which the data transmission will take place, a bandwidth of the band of operation in which the data transmission will take place, the of modulation used in the data transmission, the peak-to-average ratio characteristic of the waveform to be generated, and/or some combination thereof that provides an indication that the electronic noise generated at the modulated power supply output 876 is within acceptable limits. For example, the power management system may disable the open loop ripple compensation assist circuit 414 based on a determination that the data transmission does not require active noise reduction as a function of the expected output power to be generated by the radio frequency power amplifier 869'.

The parallel amplifier circuit 874' may also include a first signal control multiplexer 964 having a first input 964A configured to receive the parallel amplifier circuit output current estimate 40, $I_{PAWA\_OUT\_EST}$, which is generated by summing the scaled parallel amplifier output current estimate, $I_{PARA\_AMP\_SENSE}$, and the scaled high frequency ripple compensation current estimate 418, $I_{COR\_SENSE}$. The first signal control multiplexer 964 also includes a second input configured to receive an average power tracking control signal 966 from the average power tracking controller circuit 944. The first signal control multiplexer 964 also includes a multiplexer output 964C in communication with the switch mode power supply converter control output 874E. The first signal control multiplexer 964 may provide the switch mode power supply feedback signal 40A to the switch mode power supply converter 872 as a function of the expected output power to be generated by the radio frequency power amplifier 869' in a data transmission.

For example, in the high power modulation mode and the medium power modulation mode, the first signal control multiplexer 964 may be configured to provide the parallel amplifier circuit output current estimate 40, $I_{PAWA\_OUT\_EST}$, as the switch mode power supply feedback signal 40A. In the medium power average power tracking mode, first signal control multiplexer may provide the average power tracking control signal 966 as the switch mode power supply feedback signal 40A.

The power management system 870A may configure the parallel amplifier circuit 874' to use the $V_{RAMP}$ single at the single ended output 942C or the control signal 926 as a function of the expected output power to be generated by the radio frequency power amplifier 869' during the data transmission. As an example, in the medium power average power tracking modulation mode and the low power average power tracking modulation mode, some embodiments of the power management system 870A may disabled the differential filter 924 and enable the differential to single ended converter 942 to reduce the battery current, $I_{BAT}$, drawn from the battery 20. In the high power modulation mode and the medium power modulation mode, the power management system 870A may enable the differential filter 924 and disable the differential to single ended converter 942 to provide a desired level of frequency response compensation or correction to the differential $V_{RAMP}$ signal. The differential filter 924 may generate the control signal 926 that is to the non-inverting input of the parallel amplifier 928 as a function of the expected output power to be generated by the radio frequency power amplifier 869' during a data transmission. The differential filter 924 may provide a compensated $V_{RAMP}$ signal to the parallel amplifier 928 as the control signal 926 to compensate for the non-ideal output impedance of the parallel amplifier 928 and the parasitic impedances associated with the modulated power supply output 876 and the radio frequency power amplifier

In the high power modulation mode, the differential filter 924 may be configured to provide a maximum level of frequency response compensation or correction. In the medium power modulation mode, the differential filter 924 may be configured to provide a medium level of frequency response compensation or correction. In some embodiments of the medium power average power tracking modulation mode and the low power average power tracking mode, the power management system 870A may disable the differential filter 924.

As an example, in the high power envelope power tracking modulation mode, the power management system 870A may configure to differential filter 924 to apply maximum peaking to the differential $V_{RAMP}$ signal to generate the control signal 926. Alternatively, in the medium power envelope tracking power modulation mode, the power management system 870A may configure the differential filter 924 to apply a medium level peaking to the differential $V_{RAMP}$ signal to generate the control signal 926. In other words, based on a determination that the expected output power of the radio frequency power amplifier 869' is less than the high power modulation mode threshold, the power management system 870A may configure the differential filter 924 to provide less frequency response compensation as a function of the expected output power of the radio frequency power amplifier

The parallel amplifier circuit 874' further includes a first signal control multiplexer 964. The first signal control multiplexer 964 may be configured to receive the parallel amplifier circuit output current estimate 40, $I_{PAWA-OUT-EST}$, at a first input 964A and the average power tracking controller signal 966 at a second input 964B. The controller 50 configures the first signal control multiplexer 964 to provide the parallel amplifier circuit output current estimate 40, $I_{PAWA\_OUT\_EST}$, to the switch mode power supply converter 872 as a switch mode power supply feedback signal 40A when the expected output power of the radio frequency power amplifier 869' is greater than the medium power modulation mode threshold. Otherwise, the controller 50 configures the first signal control multiplexer 964 to provide the average power tracking control signal 966 to the switch mode power supply converter 872 as the switch mode power supply control signal.

In the medium power average power tracking modulation mode, the controller 50 disables the parallel amplifier 928, the feedback delay compensation circuit 852, and the $V_{OFFSET}$ loop circuit 41. In addition, as a nonlimiting example, the controller 50 also disables any active noise reduction circuit of the parallel amplifier circuit 874'. For example, as depicted in Figure 8B, the controller 50 may disable the open loop ripple compensation assist circuit 414. In addition, the switch mode power supply feedback signal 40A is provided by the average power tracking controller circuit 944. The first power supply selection switch 960 may provide either the battery voltage, $V_{BAT}$, or the $\mu C$ charge pump output voltage, $Y_{\mu C\_FILTERED}$, the second linear regulator power supply input 952D. An optional second power supply selection switch 962 may be configured to provide either the battery voltage, $V_{BAT}$, or the $\mu C$ charge pump output voltage, $V_{\mu C\_OUT}$,

to the $V_{CMOS}$ Output, which is configured to provide a CMOS logic supply voltage 878C, $V_{CMOS}$, to the CMOS logic supply input 869C as a function of the battery voltage, $V_{BAT}$. For example, in some embodiments, the controller 50 obtains a measurement of the battery voltage, $V_{BAT}$, from the battery level sense circuit 264. The controller 50 compares the measured voltage level of the battery 20 to the CMOS logic supply voltage threshold. Based on a determination that the battery voltage, $V_{BAT}$, is less than the CMOS logic supply voltage threshold, the controller 50 configures the second supply selection switch 962 to provide the $\mu$C charge pump output voltage, $V_{\mu C\_OUT}$, to the CMOS logic supply voltage 878C, $V_{CMOS}$. In addition, the controller 50 configures the $\mu$C charge pump circuit 262 to generate a $\mu$C charge pump output voltage, $V_{\mu C\_OUT}$, at least equal to the minimum CMOS logic circuit supply plus any voltage loss across the supply selection switch 962.

Similar to the power management system 870, depicted in Figures 2A-C, Figures 8A-B depict the power management system 870A to operate in various radio frequency output power level modulation modes. For example, some embodiments of the power management system 870A may be configured by the controller 50 to operate in a high power modulation mode, a medium power modulation mode, a medium power average power tracking modulation mode, a lower power average power tracking modulation mode, and/or some combination thereof.

Returning to the description of Figure 8B, while operating in either the high power modulation mode or the medium power modulation mode, the power management system 870A may be configured to generate the modulated power supply voltage, $V_{CC}$, as a function of the envelope characteristics of the modulate radio frequency input signal to the radio frequency power amplifier And other words, the power management system 870A generates the modulated power supply voltage, $V_{CC}$, by substantially tracking the envelope of the modulate radio frequency input signal to be transmitted is a function of the differential $V_{RAMP}$ signal during a data transmission in a data transmission slot. The power management system 870A may configure the parallel amplifier 928 to regulate the modulated power supply voltage, $V_{CC}$, based on the compensated $V_{RAMP}$ signal, $V_{RAMP\_C}$, generated by the differential filter 924. In addition, the power management system 870A may configure the switch mode power supply converter 872 to generate the switching voltage, $V_{SW}$, as a function of the switch mode power supply feedback signal 40A is generated by an embodiment of the parallel amplifier circuit 874', the threshold offset current 42, $I_{THRESHOLD\_OFFSET}$, generated by an embodiment of the $V_{OFFSET}$ loop circuit 41, the differential $V_{RAMP}$ signal, and/or some combination thereof.

Based on a determination of an expected output power to be generated by the radio frequency power amplifier 869', the controller 50 may configure the power management system 870A to operate in one of the high power modulation mode, the medium power modulation mode, the medium power average power tacking modulation mode, and the low power average power tracking mode. As an example, the controller 50 may configure the power management system 870A to operate in the high power modulation mode based on a determination that the expected output power to be generated by the radio frequency power amplifier 869' is at least equal to a high power modulation mode threshold. The controller 50 may configure the power management system 870A to operate in the medium power modulation mode based on a determination that the expected output power to be generated by the radio frequency power amplifier 869' is less than the high power modulation mode threshold and at least equal to a medium power modulation mode threshold. The controller 50 may configure the power management system 870A to operate in a medium power average power tracking modulation mode based on a determination that the expected output power to be generated by the radio frequency power amplifier 869' is less than the medium power modulation mode threshold and either greater than a low power average power tracking mode threshold or at least equal to a medium power modulation average power tracking mode threshold. The controller 50 may configured the power management system 870A to operate in the low power average power tracking modulation mode based on a determination that the expected output power to be generated by the radio frequency power amplifier 869' is less than the low power average tracking modulation mode threshold.

Similar to the power management system 870, depicted in Figures 2A-C, the some embodiments of the power management system 870A may be configured to operate in a tracking mode. For example, in some embodiments, the power management system 870A may be configured to operate in a no tracking mode of operation. In addition, in some embodiments, the power management system 870A may be configured to operate in a slow tracking mode of operation. While operating in a slow tracking mode, some embodiments of the power management system 870A may provide a minimum amount of frequency response compensation sufficient to compensate for parasitic capacitances and parasitic inductances between the modulated power supply output 876 and the collector voltage supply input 869A of the radio frequency power amplifier However, while operating in the no tracking mode, the power management system 870A may be configured to provide no frequency response compensation to the differential $V_{RAMP}$ signal or the $V_{RAMP}$ signal generated by the low power differential to single ended converter 942.

In some embodiments of the high power modulation mode, the power management system 870A may configure the switch mode power supply converter 872 and the parallel amplifier circuit 874' to operate in the pseudo-envelope power tracking mode. In mode, the multi-level charge pump 882 may be enabled and configured to generate either a first boost output voltage substantially equal to $3/2 \times V_{BAT}$ or a second boost output voltage substantially equal to $2 \times V_{BAT}$. In addition, the power management system 870A may enable the differential filter 942, the feedback delay compensation circuit 852, and an embodiment of an active noise reduction circuit. For example, in some embodiments of the power management system 870A, the active noise reduction circuit may be an open loop ripple compensation assist circuit 414 configured to apply the high frequency ripple compensation current 416, $I_{COR}$, to the modulated power supply output 876. In addition, the $\mu$C charge pump circuit 262 may be configured to provide a $\mu$C charge pump output voltage, $V_{\mu C\_OUT}$, to the parallel amplifier supply voltage input 928D as a function of the battery voltage, $V_{BAT}$. In some embodiments, the power management system 870A determine the operational ratio of the $\mu$C charge pump, $\mu BB_{RATIO}$, based on the battery voltage, $V_{BAT}$, the minimum CMOS logic supply voltage threshold, and the peak to peak swing of the power amplifier supply voltage, $V_{CC\_PKPK}$. For example, the power management system 870A may obtain a measurement of the battery voltage, $V_{BAT}$, from the battery level sense circuit 264. The power management system 870A may compare the measured value of the battery voltage, $V_{BAT}$, to the minimum CMOS logic voltage supply threshold to determine whether the battery voltage, $V_{BAT}$, is sufficient to power the CMOS logic 869C of the radio frequency power amplifier Based on the determination that the battery voltage is less than the minimum CMOS logic voltage supply threshold, a smallest available value of the operational ratios of the $\mu$C charge pump, $\mu BB_{RATIO}$, sufficient to provide a CMOS logic circuit supply voltage, $V_{CMOS}$, may be determined. The power management system 870A may also determine a smallest available value of the operational ratios of the $\mu$C charge pump, $\mu BB_{RATIO}$, that generates a $\mu$C charge pump output voltage, $V_{\mu C\_OUT}$, sufficient to generate the maximum expected power amplifier supply voltage, $V_{CC\_MAX}$. with the parallel amplifier 928 as a function of the peak to peak swing of the power amplifier supply voltage, $V_{CC\_PKPK}$, the battery voltage, $V_{BAT}$, and minimum offset voltage, $V_{OFFSET\_MIN}$, to be maintained across the coupling capacitor 18A. Based on the predefined operational ratios of the $\mu$C charge pump, the power management system 870A configures the $\mu$C charge pump circuit 262 to generate the $\mu$C charge pump output voltage, $V_{\mu C\_OUT}$, that is sufficient to power the parallel amplifier 928, and provide a CMOS logic supply voltage, $V_{CMOS}$, that is at least equal to the minimum CMOS logic supply voltage. Based on the $\mu$C charge pump output voltage, $V_{\mu C\_OUT}$, and the peak to peak swing of the power amplifier supply voltage, $V_{CC-PKPK}$, the power management system 870A configures the $V_{OFFSET}$ loop circuit 41 to generate a target offset voltage, $V_{OFFSET-\_TARGET}$, across the coupling capacitor 18A.

The clock management circuit 260 may disable the oscillator 270 and generate the $\mu$C charge pump clock 276 based on the switching frequency of the switch mode power supply converter 872 in the high power modulation mode, the medium power modulation mode, and the medium power average power tracking modulation mode. In the low power modulation mode and the low power average power tracking mode, the clock management system may enable the oscillator 270 to generate the $\mu$C charge pump clock 276.

In some embodiments of the high power modulation mode and the medium power modulation mode, the power management system 870A may enable the $V_{OFFSET}$ loop circuit 41 to regulate the offset voltage, $V_{OFFSET}$, between the parallel amplifier circuit output 874A and the modulated power supply output 876. In some embodiments of the medium power average power tracking modulation mode, the low power average power tracking modulation mode, and the low power modulation mode, the power management system 870A may be configured to disable the $V_{OFFSET}$ loop circuit 41. When the $V_{OFFSET}$ loop circuit 41 is enabled, some embodiments of the $V_{OFFSET}$ loop circit 41 may be configured to pre-charge the coupling capacitor 18A prior to commencement of a data transmission for a predetermined time.

While operating in either the medium power average power tracking modulation mode or the low power average power tracking mode, the power management system 870A may be configured to generate the modulated power supply voltage, $V_{CC}$, substantially based on a function of the average power generated by the radio frequency power amplifier 869' during a data transmission in a data transmission slot. The power management system 870A may be configured to generate the modulated power supply voltage, $V_{CC}$, as a function of the $V_{RAMP}$ signal generated by the low power differential to single ended converter 942. In some alternative embodiments, the power management system 870A may be further configured to generate the modulated power supply voltage, $V_{CC}$, as a function of the $V_{RAMP}$ signal generated by the low power differential to single ended converter 942 and the threshold offset current 42, $I_{THRESHOLD\_OFFSET}$, generated by some alternative embodiments of the $V_{OFFSET}$ loop circuit 41.

In the medium power average power tracking mode, the average power tracking control circuit 944 may be enabled to generated the average power tracking control signal 966 based on a $V_{RAMP}$ signal generated by the low power differential to signal ended converter 942. In addition, the power management system 870A may disable the parallel amplifier 928 and the differential filter 924 in order to save energy stored in the battery 20. The power management system 870A may regulate the modulated power supply voltage, Vcc, generated by the switch mode power supply converter 872 as a function of the average power tracking control signal 966.

In the medium power average power tracking modulation mode, the first control signal multiplexer 964 may be configured to provide the average power tracking control signal 966 as the switch mode power supply feedback signal 40A. Otherwise, the first control signal multiplexer 964 may be configured to provide the parallel amplifier circuit output current estimate 40, $I_{PAWA\_OUT\_EST}$, as the switch mode power supply feedback signal 40A.

As an alternative embodiment, the parallel amplifier 928 may be configured in a similar fashion as the parallel amplifier 2200 depicted in Figure 46C. In this case, the parallel amplifier 928 may be configured to operate in the medium power average power tracking mode to generate a modulation mode feedback signal that is substantially similar or equivalent to the average power tracking control signal 966. For example, the parallel amplifier output 928C may be disabled while the parallel amplifier feedback output 928E is configured to generate the average power tracking control signal as a function of the difference voltage between the $V_{RAMP}$ signal and the modulated power supply voltage, $V_{CC}$. In these embodiments, the average power tracking control circuit 944 may be removed.

Figure 8C depicts an embodiment of a parallel amplifier 2200 configured to combine the functionality of the average power tracking control circuit 944 and the parallel amplifier 928, depicted in Figure 8B. The embodiments of the parallel amplifier 2200 may be configured to operate in a number of modulation mode feedback signal modes as a function of the expected output power to be generated by the embodiments of the radio frequency power amplifiers 869 and 869'. As a non-limiting example, the modulation mode feedback signal modes may include a parallel amplifier mode and an average power tracking controller mode.

Some embodiments of the parallel amplifier 2200 may effectively combine the functionality of the parallel amplifier 928, the average power tracking control circuit 944, and the first signal control multiplexer 946. As described below in further detail, the parallel amplifier 2200 may include a parallel amplifier feedback output 928E' configured to provide a modulation mode feedback signal. The parallel amplifier feedback output 928E' may generate a modulation mode feedback signal substantially equivalent to one of a scaled parallel amplifier output current estimate, $I_{PARA\_AMP\_SENSE}$, and the average power tracking control signal 966 as a function of the power level modulation mode in which the power management system 870A is configured to operate. For example, in a pseudo-envelope tracking mode, the parallel amplifier 2200 may generate the scaled parallel amplifier output current estimate, $I_{PARA\_AMP\_SENSE}$. In the medium power average power tracking mode, the parallel amplifier 2200 may generate the average power tracking control signal 966 at the parallel amplifier feedback output 928E', and disable the parallel amplifier output 928C. For example, when disabled, the parallel amplifier 2200 may configure the parallel amplifier output 928C to provide a high impedance path to ground.

In addition, the parallel amplifier 2200 may also include a feedback transconductance, $Gm_{FEEBACK}$. In some embodiments, the controller 50 or the power management system 870A may configure the magnitude of the average power tracking control signal 966. In the medium power average power tracking modulation mode, the power management system 870A may set the feedback transconductance, $Gm_{FEEDBACK}$, to substantially equal the programmable average power tracking transconductance, $Gm_{APT}$, that average power tracking controller circuit 944 may use to generate the average power tracking control signal 966.

The parallel amplifier 2200 may configure the parallel amplifier feedback output 928E to provide a modulation mode feedback signal substantially equal to a product of the programmable average power tracking transconductance, $Gm_{APT}$, and a difference voltage substantially equal to the $V_{RAMP}$ signal less the modulated power supply voltage, $V_{CC}$: The modulation mode feedback signal may substantially equal $Gm_{APT} \times (V_{RAMP} - V_{CC})$. The controller 50 may configure the parallel amplifier 2200 to generate the scaled parallel amplifier output current estimate, $I_{PARA\_AMP\_SENSE}$, in response to the differential $V_{RAMP}$ signal when the power management system 870A operates in either the high power modulation mode or the medium power envelope tracking modulation. In addition, the feedback transconductance, $Gm_{FEEBACK}$, may be configured to set the fractional relationship between the scaled parallel amplifier output current estimate, $I_{PARA\_AMP\_SENSE}$, and the parallel amplifier output current, $I_{PARA\_AMP}$.

Figure 8C depicts an example embodiment of a parallel amplifier 2200 that includes a segmented parallel amplifier output driver stage. Some embodiments of the parallel amplifier 2200 may include various segmentation configurations. The description of the parallel amplifier 2200 will be carried out with continuing reference to the embodiments of the power management system 870, the power management system 870A, the parallel amplifier circuit 874, the parallel amplifier circuit 874', and the embodiments of the parallel amplifier 928, 928' and 928", which are depicted in Figures 2A-E and 8A-C and 8E-H.

Similar to the parallel amplifier 928, the parallel amplifier 2200 may include a non-inverting input 928A configured to receive a first control signal, an inverting input 928B, a parallel amplifier output 928C, a parallel amplifier supply voltage input 928D configured to receive a supply voltage to power the parallel amplifier 2200, and a parallel amplifier feedback output 928E' configured to provide a modulation mode feedback signal. Some embodiments of the parallel amplifier 2200 may further include a parallel amplifier front-end stage 2202 and a parallel amplifier output stage 2204. The parallel amplifier output stage 2204 may include a segmented output stage 2206 and a feedback output stage 2208. In some embodiments, the segmented output stage 2206 may include two or more segments. For example, the segmented output stage may include a first output driver segment 2206D including a first output driver segment output and a second output driver segment 2206E including a second output driver segment operably coupled to the first output driver segment output to form the parallel amplifier output 928C. In some embodiments of the parallel amplifier 2200, the first output driver segment 2206D may be enabled or disabled by a first segment control signal 980A. The second output driver segment 2206E may be enabled or disabled by a second segment control signal 980B. In addition, in some embodiments of the parallel amplifier 2200, the feedback output stage 2208 may also be divided into two or more segments, where each of the two or more segments of the feedback output stage 2208 correspond to a respective one of the two or more segments of the segmented output stage 2206. As an example, the feedback output stage 2208 may include a first feedback output driver segment 2208D having a first feedback output driver segment output and a second feedback output driver segment 2208E having a second feedback output driver segment output operably coupled to the first output driver segment output to form the parallel amplifier feedback output 928E'. The first feedback output driver segment and the second feedback output driver segment may be enabled or disabled by the first segment control signal 980A and the second segment control signal 980B, respectively. The first feedback output driver segment 2208D corresponds to the first output driver segment 2206D and the second feedback output driver segment 2208E corresponds to the second output driver segment 2206E. For example, in the parallel amplifier mode of operation, the first feedback output driver segment 2208D may generate an output current that is fractionally related to an output current generated by the first output driver segment 2206D, and the second feedback output driver segment 2208E may generate an output current that is fractionally related to an output current generated by the second output driver segment 2206E. The parallel amplifier 2200 may be configured to generate a modulation mode feedback signal that is substantially equivalent to the sense parallel amplifier output current estimate, $I_{PARA\_AMP\_SENSE}$, which is fractionally related to the parallel amplifier output current, $I_{PARA\_AMP}$.

In addition, the parallel amplifier 2200 may include a parallel amplifier mode of operation and an average power tracking controller mode of operation. In the parallel amplifier mode of operation, the parallel amplifier 2200 may be configured to generate a parallel amplifier output current, $I_{PARA\_AMP}$ to generate a parallel amplifier output voltage, $V_{PARA\_AMP}$ at the parallel amplifier output 928C. In addition, the parallel amplifier 2200 may configure the parallel amplifier feedback output 928E' to provide a modulation mode feedback signal that is substantially the same as the scaled parallel amplifier output current estimate, $I_{PARA\_AMP\_SENSE}$. In the average power tracking controller mode of operation, the parallel amplifier 2200 may disable the parallel amplifier output 928C to provide a high impedance load. In addition, in the average power tracking controller mode of operation, the parallel amplifier 2200 may configure the parallel amplifier feedback output 928E' to provide a modulation mode feedback output signal that is substantially the same as the average power tracking control signal 966, depicted in Figure 8B.

The parallel amplifier 2200 may be in communication with the controller 50 via a control bus 44. The controller 50 may configure various parameters or control signal to configure the parallel amplifier 2200 to operate in either the parallel amplifier mode of operation or the average power tracking mode of operation. As an example, Figure 8C depicts an embodiment of the parallel amplifier 2200 that includes a segmented output stage 2206 divided into a first output driver segment 2206D and a second output driver segment 2206E. The parallel amplifier 2200 may receive a first segment control signal 980A and a second segment control signal 980B from the controller 50. As an example, the first segment control signal 980A may be asserted to enable the first output driver segment 2206D and the second segment control signal 980B may be asserted to enable the second output driver segment 2206E. As further depicted in Figure 8G, some embodiments of the parallel amplifier 2200 may include an embodiment of the feedback output stage 2208 that is segmented into a first feedback output driver segment 2208D and a second feedback output driver segment 2208E. As an example, the first segment control signal 980A may be asserted to enable the first feedback output driver segment 2208D and the second segment control signal 980B may be asserted to enable the second feedback output driver segment 2208E. In some embodiments, the parallel amplifier may be further configured to receive a feedback stage enable 2214 and a feedback transconductance signal 2216 from the controller 50. The controller 50 may configure the feedback stage enable 2214 to enable and disable the feedback output stage 2208. As an example, the controller 50 may de-assert the feedback stage enable 2214 to disable the feedback output stage 2208.

As an example, the controller 50 may assert the feedback stage enable 2214 to enable the feedback output stage 2208. In some embodiments, the feedback output stage 2208 may switch into the average power tracking controller mode of operation when the first segment control signal 980A and the second segment control signal 980B are disabled and the feedback stage enable 2214 is asserted. In this case, the feedback output stage 2208 may enable the first feedback output driver segment 2208D and the second feedback output driver segment 2208E to operate in the average power tracking mode of operation. In addition, in some embodiments, the controller 50 may provide a feedback transconductance signal 2216 to the parallel amplifier 2200 to configure the transconductance of the feedback output stage as a function of being in either the parallel amplifier mode of operation or the average power tracking mode of operation. As an example, the controller 50 may assert the feedback transconductance signal 2216 to configure the feedback output stage 2208 to use the programmable average power tracking transconductance, $Gm_{APT}$, to generate the modulation mode feedback signal. The controller 50 may de-assert the feedback transconductance signal 2216 to configure the feedback output stage 2208 to use the feedback output stage transconductance, $Gm_{FBS}$, in the parallel amplifier mode of operation.

Alternatively, some embodiments of the parallel amplifier 2200 may include one or more control registers that may receive and store an operational mode parameter, a segmentation configuration parameter, a feedback output stage enable parameter, a segmented output stage transconductance, $Gm_{SEG}$, parameter, and a feedback output stage transconductance, $Gm_{FBS}$, parameter. The operational mode parameter may be set to configure the parallel amplifier 2200 to operate in either parallel amplifier mode of operation or the average power tracking mode of operation. The feedback output stage enable parameter may be set to enable or disable the operation of the feedback output stage. The controller 50 may set the segmented output stage transconductance, $Gm_{SEG}$, parameter to configure a segmented output stage transconductance, $Gm_{SEG}$, of the segmented output stage 2206. The controller 50 may set the feedback output stage transconductance, $Gm_{FBS}$, parameter to configure a feedback output stage transconductance, $Gm_{FBS}$, of the feedback output stage 2208.

As an alternative non-limiting example, in still other embodiments of the parallel amplifier 2200, a segmentation configuration parameter may be used to configure the operation of each of the segments of the segmented output stage 2206. The segmentation configuration parameter may also be used to configure the operation of each of the segments of the feedback output stage 2208. As a non-limiting example, the segmentation configuration parameter may be used to set the first segment control signal 980A and the second segment control signal 980B provided to the segmented output stage 2206 and the feedback output stage 2208. The parallel amplifier 2200 may enable or disable the first output driver segment 2206D and the second output driver segment 2206E of the segmented output stage 2206 as a function of the segmentation configuration parameter. Similarly, the parallel amplifier 2200 may enable or disable the first feedback output driver segment 2208D and the second feedback output driver segment 2208E of the feedback output stage 2208 as a function of the segmentation configuration parameter. Some embodiments of the parallel amplifier 2200 may include a parallel amplifier disable parameter to disable the parallel amplifier 2200 and /or place the parallel amplifier 2200 into low power standby state of operation. The segmented output stage 2206 may be disabled and provide a high impedance load when the parallel amplifier parameter is set to disable the parallel amplifier 2200.

The parallel amplifier front-end stage 2202 may include a non-inverting input 2202A in communication with the non-inverting input 928A, and configured to receive a first input signal. The parallel amplifier front-end stage 2202 may also include an inverting input 2202B configured to receive a second input signal from the inverting input 928B. The parallel amplifier front-end stage 2202 may further include a PFET control output 2202C configured to generate a PFET control signal and a NFET control output 2202D. The parallel amplifier front-end stage 2202 may be configured as a high impedance differential input configured to drive the segmented output stage 2206 and the feedback output stage 2208 as a function of a voltage difference between the non-inverting input 2202A and the inverting input 2202B. In response to the difference voltage developed across the non-inverting input 2202A and the inverting input 2202B, the parallel amplifier front-end stage 2202 may be configured to generate the PFET control signal 2210 from the PFET control output 2202C and a NFET control signal 2212 from the NFET control output 2202D to drive the segmented output stage 2206 and the feedback output stage 2208. The PFET control signal 2210 and the NFET control signal 2212 may be provided to the segmented output stage 2206 to generate the parallel amplifier output current, $I_{PARA\_AMP}$, and the feedback output stage 2208 to generate a modulation mode feedback signal from the parallel amplifier feedback output 928E'. In some embodiments, the PFET control signal 2210 and the NFET control signal 2212 may be further configured to independently drive each segment of the segmented output stage 2206. In some embodiments described below, embodiments of the feedback output stage 2208 may also be divided into segments substantially proportional to the segments of the segmented output stage 2206. In this case, the PFET control signal 2210 and the NFET control signal 2212 may be further configured to independently drive each segment of the feedback output stage 2208.

In the case where the voltage difference between the non-inverting input 2202A and the inverting input 2202B is substantially equal to zero, the PFET control signal 2210 and the NFET control signal 2212 may provide a balanced output to the segmented output stage 2206 such that the parallel amplifier output current, $I_{PARA\_AMP}$, is substantially equal to zero. Similarly, in some embodiments, the PFET control signal 2210 and the NFET control signal 2212 may be configured to provide a balance output to the feedback output stage 2208 such that the modulation mode feedback signal generated at the parallel amplifier feedback output 928E' is substantially equal to zero when the voltage difference between the non-inverting input 2202A and the inverting input 2202B is substantially equal to zero.

Figure 8C further depicts an alternative embodiment of the parallel amplifier 2200 as a parallel amplifier 928' that includes a second non-inverting input 928F configured to receive a second control signal. The alternative configuration of parallel amplifier 928' will be described with respect to the operation of the parallel amplifier 2200 with reference to Figure 8B. The parallel amplifier 2200 may further include a control signal selection switch 2220 having a first input 2220A configured to receive the first input signal from the non-inverting input 928A, a second input 2220B configured to receive a second input signal from the second non-inverting input 928F, and a control signal output 2220C in communication with the non-inverting input 2202A of the parallel amplifier front-end stage 2202. In some embodiments, the parallel amplifier 2200 configure the control signal selection switch 2220 to select the first input 2220A in the parallel amplifier mode of operation and the second input 2220B in the average power tracking controller mode of operation. As an example, referring to Figure 8B, in the average power tracking controller mode, the parallel amplifier 2200 may be configured to select the $V_{RAMP}$ signal generated by the low power differential to signal ended converter 952 at the second non-inverting input 928F. In the parallel amplifier mode of operation, the parallel amplifier 2200 may be configured to select the control signal 926 generated by the differential filter 924.

Returning to Figure 46C, the segmented output stage 2206 may have a segmented output stage transconductance, $Gm_{SEG}$, which may be adjusted by the controller 50. The segmented output stage transconductance, $Gm_{SEG}$, may also be a function of the segmentation configuration of the parallel amplifier 2200. For example, the segmented output stage transconductance, $Gm_{SEG}$, may have a maximum value in the case where all the segments of the segmented output driver are enabled. Also, the segmented output stage transconductance may depend on the relative current carrying capacity of each segment that is enabled. In addition, in some embodiments, the feedback output stage 2208 may also be divided into the same number of segments as the segmented output stage. In this case, each segment of the feedback output stage 2208 may be substantially matched to a corresponding segment in the segmented output stage 2206 with respect to current carrying capacity to maintain a fractional relationship between the parallel amplifier output current, $I_{PARA\_AMP}$, and the modulation mode feedback signal generated at the parallel amplifier feedback output 928E'.

For example, in the parallel amplifier mode of operation, the parallel amplifier 2200 may be configured to generate a parallel amplifier output current, $I_{PARA\_AMP}$, from the parallel amplifier output 928C to produce a parallel amplifier output voltage, $V_{PARA\_AMP}$. In addition, the parallel amplifier 2200 may be configured to generate a modulation mode feedback signal that is fractionally related to the parallel amplifier output current, $I_{PARA\_AMP}$. In this case, the parallel amplifier generates the modulation mode feedback signal to be substantially equivalent to the sense parallel amplifier output current estimate, $I_{PARA\_AMP\_SENSE}$. In some embodiments, the fractional ratio between the modulation mode feedback signal and the parallel amplifier output current, $I_{PARA\_AMP}$, may be programmable. In other embodiments, the fractional ratio between the modulation mode feedback signal and the parallel amplifier output current, $I_{PARA\_AMP}$, may be fixed. In still other embodiments, the fractional ratio between the modulation mode feedback signal and the parallel amplifier output current, $I_{PARA\_AMP}$, is based on a maximum parallel amplifier output current, $I_{PARA\_MAX}$. In still other embodiments, the fractional ratio between the modulation mode feedback signal and the parallel amplifier output current, $I_{PARA\_AMP}$, may be automatically adjusted based on the segmentation configuration of the parallel amplifier 2200.

In the average power tracking controller mode of operation, the parallel amplifier 2200 may be configured to generate a modulation mode feedback signal that is substantially the equivalent to the average power tracking control signal. For example, referring briefly to Figure 8B, the various embodiments of the parallel amplifier 2200 may be configured in a similar fashion as the average power tracking controller circuit 944 to generate the modulation mode feedback signal based on a difference between the $V_{RAMP}$ signal generated by the low power differential to single ended converter 942 and the modulated power supply voltage, $V_{CC}$. In this case, the feedback output stage transconductance, $Gm_{FBS}$, parameter may be adjusted to equal the programmable average power tracking transconductance, $Gm_{APT}$, of the average power tracking controller circuit 944. In some embodiments, the parallel amplifier 2200 may include a programmable average power tracking transconductance, $Gm_{APT}$, parameter that may be configured by the controller 50. In this case, parallel amplifier 2200 may selectively configure the feedback output stage 2208 to use the programmable average power tracking transconductance, $Gm_{APT}$, parameter in the average power tracking mode of operation and the feedback output stage transconductance, $Gm_{FBS}$, in the parallel amplifier mode of operation.

In addition, in the average power tracking control mode of operation, the parallel amplifier 2200 may be configured to place the parallel amplifier output 928C in a high impedance mode by disabling each of the segments of the segmented output stage 2206. For example, the controller may de-assert the first segment control signal 980A and the second segment control signal 980B to place the segmented output stage 2206 in a high impedance mode. The controller 50 may enable the feedback output stage 2208 by asserting the feedback stage enable 2214. In some embodiments, in the case where the first segment control signal 980A and the second segment control signal 980B are de-asserted and the feedback stage enable 2216 is enabled, the parallel amplifier 2200 may be configured to operate in the average power tracking controller mode of operation.

In some alternative embodiments, the parallel amplifier circuits 974 and 974' may further include an multiplexer, switch, or shared signaling configuration (not depicted) to selectively provide the $V_{RAMP}$ signal generated by the low power differential to single ended converter 942 or the control signal 926 generated by the differential filter 924 to the non-inverting input 928A of the parallel amplifier 2200.

A non-inverting input 928A may receive a first input signal. An inverting input 928B may receive a second input signal. A parallel amplifier output 928C may generate the parallel amplifier output current, $I_{PARA\_AMP}$, as a function of a difference between the first input signal and the second input signal. A parallel amplifier supply voltage input 928D may receive a μC charge pump output voltage, $V\mu_{C\_OUT}$. The parallel amplifier feedback output 928E' However, unlike the parallel amplifier 928, the parallel amplifier 2200 is configured to provide a modulation mode feedback signal from the parallel amplifier feedback output 928E'. In addition, some embodiments of the parallel amplifier 2200 may further include a second non-inverting input 928F.

Figure 8D depicts an embodiment of a $V_{OFFSET}$ loop circuit 41C. The description of the $V_{OFFSET}$ loop circuit 41C will be carried out with continuing reference to the parallel amplifier circuit 874, depicted in Figure 2C, and the parallel amplifier circuit 874', as depicted in Figure 8B, the switch mode power supply converter 872, depicted in Figures 2A-B and Figure 8A, the power management systems 870A-B and the respective parallel amplifier circuits 872B'-872C', depicted in Figures 2D-E, the power management systems 870E-H and the respective parallel amplifier circuits 872E'-872H', depicted in Figures 8E-H

The $V_{OFFSET}$ loop circuit 41C may be configured to generate a threshold offset current 42, $I_{THRESHOLD\_OFFSET}$, in the high power modulation mode and the low power modulation mode of the power level modulation modes to regulate an offset voltage, $V_{OFFSET}$, across a coupling circuit configured to operably couple a parallel amplifier circuit output 874A to the modulated power supply output 876. In addition, the $V_{OFFSET}$ loop circuit 41C may be further configured to generate a threshold offset current 42, $I_{THRESHOLD\_OFFSET}$, in the medium power average power modulation mode to regulate the modulated power supply voltage, $V_{CC}$, as a function of the differential $V_{RAMP}$ signal. In the medium power average power tracking modulation mode, the power management systems 870, 870A-870C, and 870E-870H may selectively configure the some embodiments of the $V_{OFFSET}$ loop circuit 41C to generate a threshold offset current 42, $I_{THRESHOLD\_OFFSET}$, to provide an indication of an instantaneous error voltage between a target voltage for the modulated power supply output 876 and the modulate power supply voltage, $V_{CC}$, and/or an indication of a weighted error voltage between a target voltage for the modulated power supply output 876 and the modulate power supply voltage, $V_{CC}$. In medium power average power tracking modulation mode, some embodiments of the $V_{OFFSET}$ loop circuit 41 may receive the target voltage for the modulated power supply output 876 from differential filter 924 and/or the low power differential to single ended converter 942. For example, the target voltage for the modulated power supply output 876 may be the $V_{RAMP}$ signal generated by the low power differential to single ended converter 942. As another example, the target voltage for the modulated power supply output 876 may be the control signal 926 generated by the differential filter 924 with either no frequency response compensation or correction or a low level of frequency response compensation or correction.

The $V_{OFFSET}$ loop circuit 41C may include an offset multiplexer 2222, a target multiplexer 2224, and a summing circuit 2226 in cooperative communication with a threshold offset generation circuit 2228 to generate a threshold offset current 42, $I_{THRESHOLD\_OFFSET}$. Some embodiments of the $V_{OFFSET}$ loop circuit 41C may further include a programmable reference 2230 configured to generate a reference voltage, $V_{REF}$. The controller 50 may be configured to control and configure the $V_{OFFSET}$ loop circuit 41C via control bus 44. For example, the controller 50 may be in operable communication with the offset multiplexer 2222, the target multiplexer 2224, the summing circuit 2226, the threshold offset generation circuit 2228, and the programmable reference 2230 via the control bus 44.

The summing circuit 2226 may include a non-inverting input 2226A, a first inverting input 2226B, and a second inverting input 2226C. In some embodiments, the summing circuit 2226 may be configured as summing amplifier. The non-inverting input 2226A may receive the modulated power supply voltage, $V_{CC}$, from the modulated power supply output 876. In addition, the first inverting input 2226B may receive an offset signal 2234 from an offset multiplexer output 2222D of the offset multiplexer 2222. The second inverting input 2226C may receive a target signal 2236 from a target multiplexer output 2224D of the target multiplexer 2224. The summing circuit 2226 subtracts the offset signal 2234 and target signal 2236 from the modulated power supply voltage, $V_{CC}$, to generate a loop circuit error signal 2238. The summing circuit 2226 may provide the loop circuit error signal 2238 to the threshold offset generation circuit 2228. In response to the loop circuit error signal 2238, the threshold offset generation circuit 2228 generates the threshold offset current 42, $I_{THRESHOLD\_OFFSET}$, based on the loop circuit error signal 2238 as a function of the power level modulation mode.

The offset multiplexer 2222 may include a first input 2222A configured to receive a parallel amplifier output voltage, $V_{PARA\_AMP}$, a second input 2222B coupled to a ground reference, and a third input 2222C configured to receive a reference voltage signal 2232, $V_{REF}$, from the programmable reference 2230. The controller 50 may configure the offset multiplexer 2222 to provide an offset signal 2234 from the offset multiplexer output 2222D to the first inverting input 2226B of the summing circuit 2226, which is selected from among the parallel amplifier output voltage, $V_{PARA-AMP}$, the ground reference, and the reference voltage signal, $V_{REF}$.

The target multiplexer 2224 may include a first input 2224A configured to receive a target offset voltage, $V_{TARGET\_OFFSET}$, a second input 2224B configured to receive a $V_{RAMP}$ signal, and a third input configured to receive a filtered $V_{RAMP}$ signal from a pre-filter 313. The pre-filter 313 may be configured to provide a degree of frequency compensation or pre-distortion to compensate for the frequency response of the $V_{OFFSET}$ loop circuit 41C and the switch mode power supply converter 872. As an example, the pre-filter may include the programmable pole time constant, Taup, and the programmable zero time constant, $Tau_Z$. The controller 50 may adjust the values of the programmable pole time constant, Taup, and the programmable zero time constant, $Tau_Z$, to adjust the frequency response of the pre-filter 313. The filtered $V_{RAMP}$ signal generated by the pre-filter 313 may be similar to a compensated $V_{RAMP}$ signal, $V_{RAMP\_C}$, where the pre-filter 313 has applied a degree of signal pre-distortion or frequency response compensation or correction to the $V_{RAMP}$ signal to compensate for the frequency response of the control loop of the switch mode power supply converter 872 in the medium power average power tracking mode.

For example, in medium power average power tracking modulation mode, the controller 50 may configure the $V_{OFFSET}$ loop circuit 41C to regulate the modulated power supply voltage, $V_{CC}$, as a function of the $V_{RAMP}$ signal, where the $V_{RAMP}$ signal provides a target voltage for the modulated power supply output 876. The controller 50 may configure the values of the programmable pole time constant, $Tau_P$, and the programmable zero time constant, $Tau_Z$, to pre-distort the $V_{RAMP}$ signal to provide a selected amount of frequency response compensation to improve the response or stability of the control loop of the switch mode power supply converter 872.

As an example, the controller 50 may configure the target multiplexer 2224 to provide a target signal 2236 from the target multiplexer output 2224D to the second inverting input 2226C of the summing circuit 2226. The target signal 2236 may be selected from among the target offset voltage, $V_{TARGET\_TRESHOLD}$, the $V_{RAMP}$ signal, and the filtered $V_{RAMP}$ signal. In some alternative embodiments, the $V_{OFFSET}$ loop circuit 41C may be configured to receive the control signal 926 from the differential filter 924. The differential filter 924 may apply a level of frequency response compensation, peaking, or signal distortion to the differential $V_{RAMP}$ signal to generate a compensated $V_{RAMP}$ signal as a function of the power level modulation mode.

Referring to Figures 2A-E and Figures 8A-H, Figure 2D depicts an embodiment of a power management system 870B that is similar to the embodiments of the power management system 870, depicted in Figures 2A-C. The power management system 870A includes an embodiment of a parallel amplifier circuit 874B' having an embodiment of the $V_{OFFSET}$ loop circuit 41C. The $V_{OFFSET}$ loop circuit 41C may be configured to receive the control signal 926 from differential filter 924 in the medium power average power tracking mode of operation.

In this case, the third input 2224C may receive the control signal 926 from the differential filter 924. In the medium power average power tracking mode, the differential filter 924 may be configured to provide the $V_{RAMP}$ signal to the second input 2224B of the target multiplexer 2224 in the medium power average power tracking modulation mode. As another alternative, in some embodiments, the second input 2224B may selectively receive the $V_{RAMP}$ signal from either the single ended output 942C of the low power differential to single ended converter 942 or the control signal 926 from the differential filter 924. As still another alternative, some embodiments of the target multiplexer 2224 may further include a fourth input 2224E configured to receive the control signal 926 from the differential filter 924.

In the high power modulation mode and the medium power envelope tracking mode, the controller 50 may configure the target multiplexer 2224 and the offset multiplexer to operate in a $V_{OFFSET}$ loop control configuration to regulate the offset voltage, $V_{OFFSET}$, between the parallel amplifier circuit output 874A and the modulated power supply output 876.

In the $V_{OFFSET}$ loop control configuration, the controller 50 may configure the target multiplexer 2224 to provide the target offset voltage, $V_{TARGET-OFFSET}$, as the target signal 2236. In addition, the controller 50 may configure the offset multiplexer 2222 to provide the parallel amplifier output voltage, $V_{PARA-AMP}$, as the offset signal 2234. The summing circuit 2226 may generate a loop circuit error signal 2238 substantially equal to the modulated power supply voltage, $V_{CC}$, less a sum of the target offset voltage, $V_{TARGET-OFFSET}$, and the parallel amplifier output voltage, $V_{PARA-AMP}$, which may be expressed mathematically as $Error_{LOOP\_CIRCUIT} = [V_{CC} - V_{TARGET\_OFFSET} - V_{PARA\_AMP}]$.

In the medium power average power tracking modulation mode, the controller 50 may configure to the $V_{OFFSET}$ loop circuit 41C to regulate the generation of the switching voltage, $V_{SW}$, as a function of the differential $V_{RAMP}$ signal. In this case, the controller 50 may configure the parallel amplifier circuit 874' to disable the generation of the switch mode power supply feedback signal 40A. In addition, the controller may configure the offset multiplexer 2222 and the target multiplexer 2224 to operate in a switch mode power supply converter control loop configuration.

As an example, the controller 50 may configure the target multiplexer 2224 to provide the $V_{RAMP}$ signal as the target signal 2236. In some alternative embodiments, the controller 50 may configure the target multiplexer 2224 to provide the control signal 926 as a target signal 2236. The controller 50 may configure the offset multiplexer 2222 to provide the ground voltage from the second input 2222B as a target signal 2236. In response, the summing circuit 2226 may generate a loop circuit error signal 2238 that is substantially equal to the modulated power supply voltage, $V_{CC}$, less the $V_{RAMP}$ signal.

For the sake of convenience, and not by way of limitation, a method 1700, a method 1800, a method 1900, a method 2000, and method 2100, depicted in Figure 9, Figures 10A-B, Figures 11A-B, Figures 12A-B, and Figure 13, may describe various operations, tasks, functions, firmware, logic operations, hardware, analog logic or digital logic, a digital base band processing circuit, firmware, and/or software, a transceiver/communication device, and/or some combination thereof in terms of the controller 50 and/or the power management system 870. However, this is by way of description and not intended to limit the scope of the method 1700, the method 1800, the method 1900, the method 2000, and the method 2100. In addition, in some embodiments, the operations of the controller 50 and/or various selected portions of the power management system 870 may be incorporated into the hardware, software, and/or firmware of various components or portions of a transceiver/ communication device.

Figure 9 depicts the method 1700 for configuring of the operation of the pseudo-envelope tracking modulated power supply system 868A that depends upon the expected output power to be generated by the radio frequency power amplifier 869' during a data transmission. The method 1700 is described with continuing reference to the pseudo-envelope tracking modulated power supply system 868A depicted in Figures 8A-B, 10A-B, 11A-B, 12A-B, and 13A. In addition, method 1700 is further described with continuing reference to Figures 2A-C, 3, 4, 5A-B, 6A-B, and 7.

The pseudo-envelope tracking modulated power supply system 868A may determine an expected output power to be generated by a radio frequency power amplifier 869' during a data transmission. (Step 1702). For example, in some embodiments, the controller 50 may determine the expected output power to be generated by the radio frequency power amplifier 869' a based upon the envelope characteristics of data signal to be transmitted during a data transmission slot. In other embodiments, the digital baseband processing portion of the transceiver or modem that provides the differential $V_{RAMP}$ signal to the parallel amplifier circuit 874' may determine the expected output power to be generated by the radio frequency power amplifier 869'. Based on the expected output power to be generated by the radio frequency power amplifier 869' during the data transmission, the power management system 870A may select a power modulation mode of operation from among a number of power level modulation modes of operation. (Step 1704). For example, the power management system 870 depicted in Figure 4 includes a high power modulation mode, a medium power modulation mode, and a low power modulation mode. In the case where the expected output power to be generated by the radio frequency power amplifier 869 is greater than or equal to a high power modulation mode threshold, the power management system 870 configures the pseudo-envelope tracking modulated power supply system 868A to operate in a high power modulation mode. (Step 1706). Alternatively, in the case where the expected output power to be generated by the radio frequency power amplifier 869 is less than the high power modulation mode threshold but greater than a low power modulation mode threshold, the power management system 870 configures the pseudo-envelope tracking modulated power supply system 868A to operate in a medium power modulation mode. (Step 1708). In the case where the expected output power to be generated by the radio frequency power amplifier 869 is less than or equal to the low power modulation mode threshold, the power management system 870 may configure the pseudo-envelope tracking modulated power supply system 868A to operate in the medium power average power tracking modulation mode. (Step 1710). In the case where the expected output power to be generated by the radio frequency power amplifier 869 is less than or equal to the low power modulation mode threshold, the power management system 870 may configure the pseudo-envelope tracking modulated power supply system 868A to operate in the low power average power tracking modulation mode. (Step 1712).

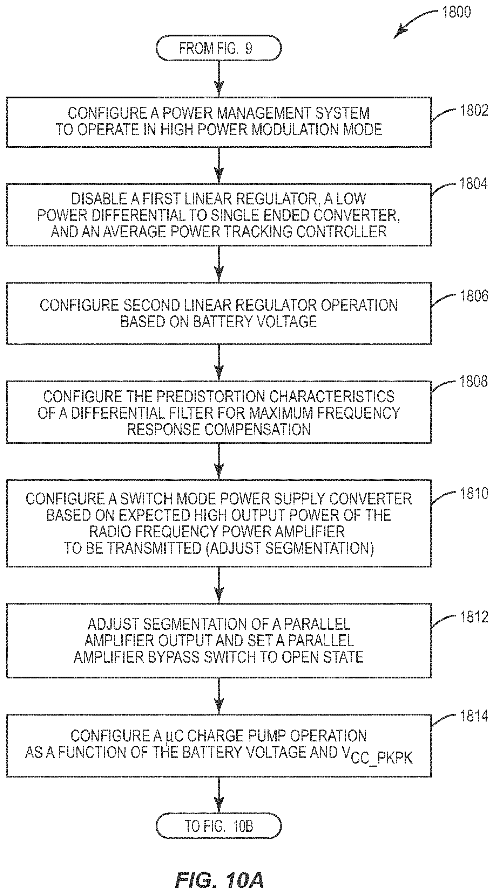

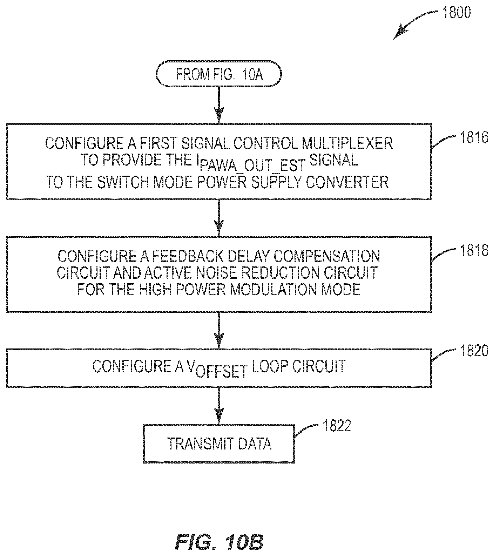

Figures 10A-B depict a method 1800 for configuring the pseudo-envelope tracking modulated power supply system 868A to operate in a high power modulation mode based on a determination that the expected output power to be generated by the radio frequency power amplifier 869' to during a data transmission at least equal to the high power modulation mode threshold. Some aspect of the method 1800 may be similar to the method 1400, depicted in Figures 5A-B. Figure 5A-B depict the method 1400 for configuring the pseudo-envelope tracking modulated power supply system 868 and the power management system 870 to operate in a high power modulation mode. Accordingly, without intent to limit the scope of the method 1800, the description of the method 1800 may be described with continuing reference to the method 1400. In addition, the method 1800 is described with continuing reference to the various embodiments of the pseudo-envelope tracking modulated power supply system 868A, the power management system 870A, the switch mode power supply converter 872, and parallel amplifier circuit 874', depicted in Figures 8A-B, Figure 9, Figure 10A-B, Figure 11A-B, Figure 12A-B, and Figure 13. For the sake of convenience, and not by way of limitation, description of the method 1800 may refer to the controller 50. However, as discussed above, a digital base band processing portion of the transceiver/communication device and/or a combination of hardware and firmware associated with the power management system 870A may likewise operate in conjunction with the controller 50. In addition, the operations of controller 50 may be incorporated into the hardware and/or firmware of various components or portions of a transceiver/communication device.

To configure the power management system 870A to operate in the high power modulation mode, the controller 50 may determine or receive envelope characteristics data that describe the modulated radio frequency signal to be transmitted by the radio frequency power amplifier 869'. In other embodiments, the envelope characteristics data may further include parameters to configure the $\mu$C charge pump circuit 262 and the $V_{OFFSET}$ control circuit 41. In some embodiments the power management system 870A or the controller 50 may receive a segmentation mode for configuring the switching circuit 884, a segmentation configuration for configuring the parallel amplifier 928, an average expected output power, $P_{OUT\_AVE}$, to be generated by the radio frequency power amplifier 869', and the segmentation mode for the switching circuit 884. For example, a digital modem or a digital baseband circuit configured to operate with the power management system 870A may have a look-up table, LUT, that maps the average expected output power, $P_{OUT\_AVE}$, to segmentation mode of the switching circuit 884 and the segmentation configuration for the parallel amplifier 928. Based on the mapping between the average expected output power, $P_{OUT\_AVE}$, to the segmentation mode of the switching circuit 884 and the segmentation configuration for the parallel amplifier 928, the digital modem or the digital baseband circuit may provide the segmentation mode and segmentation configuration information the power management system 870A. For example, in some embodiments, the control 50 may provide the segmentation mode and segmentation configuration information via the data bus 44. Based on the envelope characteristic data, the controller 50 may configure the power management system 870A to operate in a high power modulation mode. (Step 1802).

In the high power modulation mode, the controller 50 may disable the first linear regulator 952, the low power differential to single ended converter 942, and the average power tracking controller circuit 944. (Step 1804).

The controller 50 may enable the programmable digital to analog converter 954 to generate a programmable reference voltage. The second linear regulator 952 may generate a second linear amplifier output voltage, $V_{LDO2}$, as a function of the programmable reference voltage and the battery voltage, $V_{BAT}$. (Step 1806).

The controller 50 may enable the digital filter 824 to generate the control signal 926. The controller 50 may configure the predistortion characteristics of a differential filter 824 to apply a maximum level of frequency response compensation to the differential $V_{RAMP}$ signal to generate the control signal 926. (Step 1808).

The controller 50 may configure a switch mode power supply converter 872 based on expected high output power of the radio frequency power amplifier 869' to be transmitted. In the high power modulation mode, the switcher control circuit 880 enables the multi-level charge pump 882 and the driving circuit 842 to generate the switching voltage, $V_{SW}$. In some embodiments, the switcher control circuit 880 configures the multi-level charge pump 882 to generate all available "buck" level voltages and all available "boost" voltage levels. To improve efficiency in the high power modulation mode, the switcher control circuit 880 may inhibit the generation of "buck" voltage levels that are between the battery voltage, $V_{BAT}$, and ground to preserve the charge stored on a first flying capacitor 100 and a second flying capacitor 102 of the multi-level charge pump 882 for generation of the first boost voltage and the second boost voltage. Average expected output power, $P_{OUT\_AVE}$, the switcher control circuit 880 may determine a segmentation mode for the switching circuit 884. In some embodiments, the power management system 870A may receive a segmentation mode from a digital baseband processing portion of the transceiver or modem that provides the differential $V_{RAMP}$ signal. The switcher control circuit 880 may generate a segmentation control signal 880A to enable operation of all the sets of series switch and shunt switch pairs of the switching circuit 884 as a function of the segmentation mode. In some embodiments, the switcher control circuit may adjust the programmable delay period of the programmable delay circuitry 432 to offset at least a portion of any change in the temporal relationship between application of a current induced by the switching voltage, $V_{SW}$, and application of the high frequency ripple compensation current 416, $I_{COR}$, to the modulated power supply output 876. (Step 1810).

The power management system 870A may adjust the segmentation of a parallel amplifier output 928C and enable the parallel amplifier circuit output 872A. The power management system 870A may determine the segmentation configuration for the parallel amplifier 928. If the parallel amplifier includes an unsegmented output driver stage, the power management system 870A may not determine the segmentation configuration. To enable the parallel amplifier circuit output, the power management system 870A may set a parallel amplifier bypass switch 936 to open state. As a result, the coupling capacitor is decoupled from the ground. In addition, in some embodiments, the power management system 870A may set a first impedance, $Z_1$, of a first parallel amplifier feedback impedance 946 and a second impedance, $Z_2$ of a second parallel amplifier feedback impedance 948 to adjust a gain and a frequency response of the parallel amplifier 928 in order to compensate for the frequency response of the parallel amplifier 928 in the high power modulation mode. (Step 1812).

The power management system 870A may configure a $\mu C$ charge pump circuit 262 to generate $\mu C$ charge pump output voltage, $V_{\mu C\_OUT}$, as a function of the battery voltage, $V_{BAT}$, the peak-to-peak swing of the power amplifier supply voltage, $V_{CC\_PKPK}$. (Step 1914). In addition, the power management system 870A may configure the $\mu C$ charge pump circuit 262 to generate $\mu C$ charge pump output voltage, $V_{\mu C\_OUT}$, to generate a target offset voltage, $V_{OFFSET\_TARGET\_EXPECTED}$. If the battery voltage, $V_{BAT}$, is less than the minimum CMOS logic supply voltage threshold, the power management system 870A may further configure the $\mu C$ charge pump circuit 262 to generate a $\mu C$ charge pump output voltage, $V_{\mu C\_OUT}$, sufficient to provide a minimum CMOS logic supply voltage threshold, the power management system 870 may be configured to provide a CMOS logic circuit supply voltage, $V_{CMOS}$, to the CMOS logic supply input 869C that is at least equal to the minimum CMOS logic supply voltage. The controller may configure the supply selection switch 962 to provide the $\mu C$ charge pump output voltage, $V_{\mu C\_OUT}$, to the CMOS logic supply input 869C. In some embodiments, the controller 50 may configure the supply selection switch 962 to provide the battery voltage to the CMOS logic supply input 869C when the battery voltage, $V_{BAT}$ is at least equal to the minimum CMOS logic supply voltage threshold. (Step 1814).

The power management system 870A may configure a first signal control signal multiplexer 964 to prove the parallel amplifier circuit output current estimate 40, $I_{PAWA\_OUT\_EST}$, to the switch mode power supply converter 876 as the switch mode power supply feedback signal 40A. (Step 1816).

The power management system 870A may configure a feedback delay compensation circuit 862 and active noise reduction circuit for the high power modulation mode. (Step 1818). As an example, in the high power modulation mode, the power management system 870A may configure the feedback delay compensation circuit 852 to operate as a function of a high power mode apparent gain to increase the aggressiveness of the feedback compensation provided by the feedback delay compensation signal 854, $I_{FEEDBACK\_TC}$. In addition, in some embodiments, the power management system may configure the active noise reduction circuit to provide a maximum level of noise reduction. As an example, the controller 50 may configure the open loop ripple compensation assist circuit 414 to generate and apply a medium frequency ripple compensation current 416, $I_{COR}$, based on the high power modulation mode $I_{COR}$ transconductance value, $Gm_{ICOR\_HIGH\_POWER}$, to the modulated power supply output 876 to reduce the noise present in the receive channel of a band of operation. (Step 1820).

The $V_{OFFSET}$ loop circuit 41 may be configured to determine whether the coupling capacitor 18A to operate in a pre-charge mode of operation prior to the commencement of the data transmission. The $V_{OFFSET}$ loop circuit 41 may compare the $V_{OFFSET}$ error signal 304 to a maximum $V_{OFFSET}$ error threshold parameter to determine whether to operate in a pre-charge mode for a predetermined period of time. (Step 1822).

After the power management system 870A is configured to operate in the high power modulation mode, the modulated radio frequency input signal is provided to the radio frequency power amplifier 869' and the differential $V_{RAMP}$ signal is provide to the switch mode power supply converter 872 and the parallel amplifier circuit 784'. In response to the differential $V_{RAMP}$ signal and the modulated radio frequency input signal, the data transmission commences. The data may be transmitted in a data transmission slot. (Step 1824).

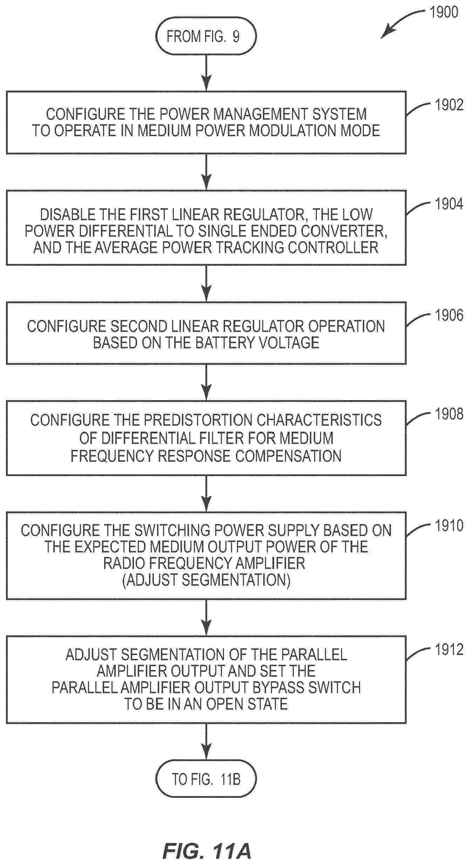

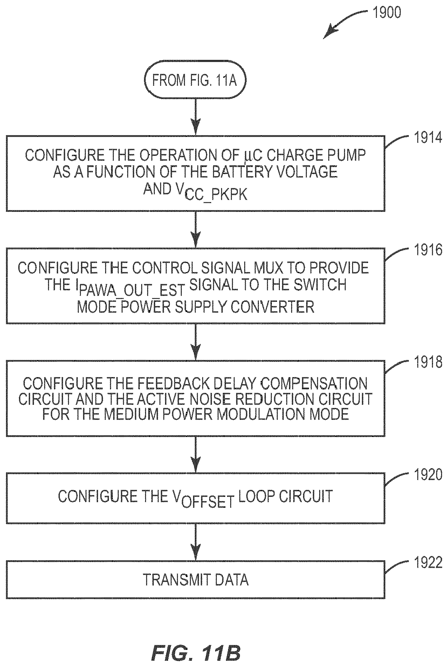

Figures 11A-B depict a method 1900 for configuring the pseudo-envelope tracking modulated power supply system 868A to operate in a medium power modulation mode based on a determination that the expected output power to be generated by the radio frequency power amplifier 869' to during a data transmission at less than the high power modulation mode threshold and at least substantially equal to a medium power modulation mode threshold. Some aspect of the method 1900 may be similar to the method 1500, depicted in Figures 6A-B, which depict a method for configuring the pseudo-envelope tracking modulated power supply system 868 and the power management system 870 to operate in a medium power modulation mode. Accordingly, and without intent to limit the scope of the method 1900, the description of the method 1900 may be described with continuing reference to the method 1500. In addition, the method 1900 is described with continuing reference to the various embodiments of the pseudo-envelope tracking modulated power supply system 868A, the power management system 870A, the switch mode power supply converter 872, and parallel amplifier circuit 874', depicted in Figures 8A-B, Figure 9, Figure 10A-B, Figure 11A-B, Figure 12A-B, and Figure 13.

Controller 50 may configure the power management system 870A to operate in a medium power modulation mode based on the determination that the expected output power of the radio frequency power amplifier 869' is less than a high power modulation mode threshold and low power modulation mode threshold.

To configure the power management system 870A to operate in the medium power modulation mode, the controller 50 may determine or receive envelope characteristics data that describe the modulated radio frequency signal to be transmitted by the radio frequency power amplifier 869'. In other embodiments, the envelope characteristics data may further include parameters to configure the μC charge pump circuit 262 and the $V_{OFFSET}$ control circuit 41. In some embodiments the power management system 870A or the controller 50 may receive a segmentation mode for configuring the switching circuit 884, a segmentation configuration for configuring the parallel amplifier 928, an average expected output power, $P_{OUT\_AVE}$, to be generated by the radio frequency power amplifier 869'. In addition, based on the expected average expected output power, $P_{OUT\_AVE}$, the power management system 870A determine whether to inhibit the operation of the multi-level charge pump 882 to only generate a first boost mode output voltage substantially equal to $3/2 \times V_{BAT}$. In addition, in some embodiments, the power management system 870A may further determine whether to inhibit the generation of the first buck mode output voltage substantially equal to $1/2 \times V_{BAT}$ based on the average expected output power, $P_{OUT\_AVE}$. Based on the envelope characteristic data, the power management system 870A may further determine whether to configure the power management system 870A to operate in the medium power modulation mode. (Step 1902).

The power management system 870A may enable the programmable digital to analog converter 954 to generate a programmable reference voltage. The second linear regulator 952 may generate a second linear amplifier output voltage, $V_{LDO2}$, as a function of the programmable reference voltage and the battery voltage, $V_{BAT}$. (Step 1904)

In the medium power modulation mode, the controller may disable the first linear regulator 952, the low power differential to single ended converter 942, and the average power tracking controller circuit 944. (Step 1906)

The power management system 870A may enable the digital filter 824 to generate the control signal 926. The power management system 870A may configure the predistortion characteristics of a differential filter 824 to apply a medium level of frequency response compensation to the differential $V_{RAMP}$ signal to generate the control signal 926. (Step 1908).

The power management system 870A may configure the switch mode power supply converter 872 based on the expected medium output power to be generated by the radio frequency amplifier during the data transmission. (Step 1910). As an example, in the medium power modulation mode, the switcher control circuit 880 may enable the multi-level charge pump 882 and the driving circuit 842 to generate the switching voltage, $V_{SW}$. In some embodiments, the switcher control circuit 880 may only operate the multi-level charge pump 882 to generate a first boost level voltage substantially equal to $3/2 \times V_{BAT}$ based on the average expected output power, $P_{OUT\_AVE}$. In addition, the switcher control circuit 880 may configure the segmentation mode of the switching circuit 884 as a function of the average expected output power, $P_{OUT\_AVE}$. In some embodiments, the power management system 870A may receive a segmentation mode from a digital baseband processing portion of the transceiver or modem that provides the differential $V_{RAMP}$ signal. As an example, in some embodiments, the power management system 870A may compare the average expected output power, $P_{OUT\_AVE}$, to set of switcher output power thresholds to determine the segmentation mode. The switcher control circuit 880 may generate a segmentation control signal 880A to enable operation of some or all of the sets of series switch and shunt switch pairs of the switching circuit 884 as a function of the segmentation mode. In some embodiments, the switcher control circuit may adjust the programmable delay period of the programmable delay circuitry 432 to offset at least a portion of any change in the temporal relationship between application of a current induced by the switching voltage, $V_{SW}$, and application of the high frequency ripple compensation current 416, $I_{COR}$, to the modulated power supply output 876 as a function of the segmentation mode. In some embodiments, the power management system 870A may configure the switcher control circuit 880 to enable either 75% or 50% of the sets of series switches and shunt switches while operating in the medium power modulation mode as a function of the expected output power of the radio frequency power amplifier 869'.

The power management system 870A may adjust the segmentation of a parallel amplifier output 928C and enable the parallel amplifier circuit output 872A. (Step 1912). For example, the power management system 870A may determine the segmentation configuration for the parallel amplifier 928. If the parallel amplifier includes an unsegmented output driver stage, the power management system 870A may not determine the segmentation configuration. To enable the parallel amplifier circuit output, the power management system 870A may set a parallel amplifier bypass switch 936 to open state. As a result, the coupling capacitor is decoupled from the ground. In addition, in some embodiments, the power management system 870A may set a first impedance, $Z_1$, of a first parallel amplifier feedback impedance 946 and a second impedance, $Z_2$ of a second parallel amplifier feedback impedance 948 to adjust a gain and a frequency response of the parallel amplifier 928 in order to compensate for the frequency response of the parallel amplifier 928 in the high power modulation mode.

The power management system 870A may configure a $\mu$C charge pump circuit 262 to generate $\mu$C charge pump output voltage, $V_{\mu C\_OUT}$, as a function of the battery voltage, $V_{BAT}$, the peak-to-peak swing of the power amplifier supply voltage, $V_{CC\_PKPK}$. (Step 1914). In addition, the power management system 870A may configure the $\mu$C charge pump circuit 262 to generate $\mu$C charge pump output voltage, $V_{\mu C\_OUT}$, to generate a target offset voltage, $V_{OFFSET\_TARGET\_EXPECTED}$. If the battery voltage, $V_{BAT}$, is less than the minimum CMOS logic supply voltage threshold, the power management system 870A may further configure the $\mu$C charge pump circuit 262 to generate a $\mu$C charge pump output voltage, $V_{\mu C\_OUT}$, sufficient to provide a minimum CMOS logic supply voltage threshold, the power management system 870 may be configured to provide a CMOS logic circuit supply voltage, $V_{CMOS}$, to the CMOS logic supply input 869C that is at least equal to the minimum CMOS logic supply voltage. The controller may configure the supply selection switch 962 to provide the $\mu$C charge pump output voltage, $V_{\mu C\_OUT}$, to the CMOS logic supply input 869C. In some embodiments, the power management system 870A may configure the supply selection switch 962 to provide the battery voltage to the CMOS logic supply input 869C when the battery voltage, $V_{BAT}$ is at least equal to the minimum CMOS logic supply voltage threshold.

The power management system 870A may configure a first signal control signal multiplexer 964 to prove the parallel amplifier circuit output current estimate 40, $I_{PAWA\_OUT\_EST}$, to the switch mode power supply converter 876 as the switch mode power supply feedback signal 40A. (Step 1916).

The power management system 870A may configure a feedback delay compensation circuit 862 and active noise reduction circuit for the medium power modulation mode. (Step 1918). As an example, in the medium power modulation mode, the power management system 870A may configure the feedback delay compensation circuit 852 to operate as a function of a medium power mode apparent gain to increase the aggressiveness of the feedback compensation provided by the feedback delay compensation signal 854, $I_{FEEDBACK\_TC}$. In addition, in some embodiments, the power management system may configure the active noise reduction circuit to provide a maximum level of noise reduction. As an example, the power management system 870A may configure the open loop ripple compensation assist circuit 414 to generate and apply a medium frequency ripple compensation current 416, $I_{COR}$, based on the medium power modulation mode $I_{COR}$ transconductance value, $Gm_{ICOR\_MEDIUM\_POWER}$, to the modulated power supply output 876 to reduce the noise present in the receive channel of a band of operation.

The $V_{OFFSET}$ loop circuit 41 may be configured to determine whether the coupling capacitor 18A to operate in a pre-charge mode of operation prior to the commencement of the data transmission. The $V_{OFFSET}$ loop circuit 41 may compare the $V_{OFFSET}$ error signal 304 to a maximum $V_{OFFSET}$ error threshold parameter to determine whether to operate in a pre-charge mode for a predetermined period of time. (Step 1920).

After the power management system 870A is configured to operate in the medium power modulation mode, the modulated radio frequency input signal is provided to the radio frequency power amplifier 869' and the differential $V_{RAMP}$ signal is provide to the switch mode power supply converter 872 and the parallel amplifier circuit 784'. In response to the differential $V_{RAMP}$ signal and the modulated radio frequency input signal, the data transmission commences. The data may be transmitted in a data transmission slot. (Step 1922).

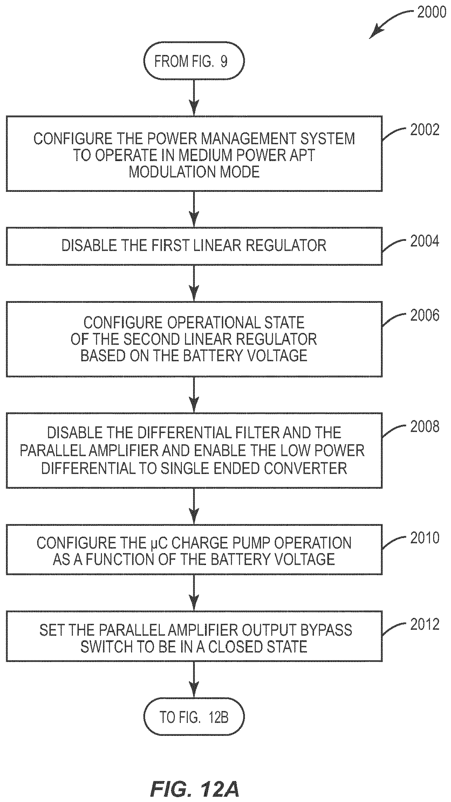

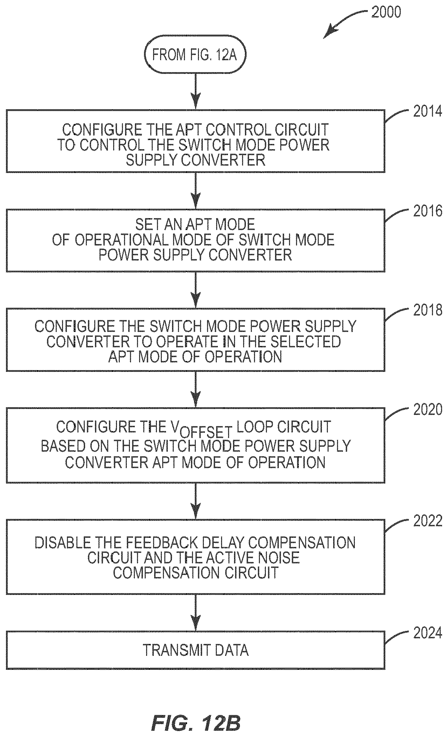

Figures 12A-B depict a method 2000 for configuring the pseudo-envelope tracking modulated power supply system 868A to operate in a medium power average power tracking modulation mode based on a determination that the expected output power to be generated by the radio frequency power amplifier 869' to during a data transmission at less than the medium power modulation mode threshold and at least substantially equal to a medium power average power tracking modulation mode threshold. The method 2000 is described with continuing reference to the various embodiments of the pseudo-envelope tracking modulated power supply system 868A, the power management system 870A, the switch mode power supply converter 872, and parallel amplifier circuit 874', depicted in Figures 8A-B, Figure 9, Figures 10A-B, Figures 11A-B, and Figure 13. For the sake of convenience, and not by way of limitation, description of the method 2000 may refer to the power management system 870A.

To configure the power management system 870A to operate in the medium power average power tracking modulation mode, the power management system 870A may determine or receive envelope characteristics data that describe the modulated radio frequency signal to be transmitted by the radio frequency power amplifier 869'. In other embodiments, the envelope characteristics data may further include parameters to configure the μC charge pump circuit 262. For example, the envelope characteristics data may include the maximum expected power amplifier supply voltage, $V_{CC\_MAX}$. Based on the envelope characteristic data, the power management system 870A may further determine whether to configure the power management system 870A to operate in the medium power average power tracking modulation mode. (Step 2002).

The power management system 870A may disable the first linear regulator 950, $LDO_1$, and configure the first linear regulator output 874B to provide a high impedance path to ground. (Step 2004).

The power management system 870A may disable the programmable digital to analog converter 954. The power management system 870A may configure the second signal control multiplexer 956 to provide the $V_{RAMP}$ signal to the non-inverting input of the second linear regulator 952, $LDO_2$. In response to the $V_{RAMP}$ signal, the second linear regulator 952, $LDO_2$, may generate a second linear amplifier output voltage, $V_{LDO2}$, that is at least equal to the minimum driver supply voltage threshold as a function of the battery voltage, $V_{BAT}$, as described above. (Step 2006).

In the medium power average power tracking modulation mode, the power management system 870A may disable differential filter 942 and the parallel amplifier 928. The power management system 870A may configure the parallel amplifier output 928C to provide a high impedance path to ground. The power management system 870A may also enable the low power differential to single ended converter 942 to generate the $V_{RAMP}$ signal as a function of the differential $V_{RAMP}$ signal. (Step 2008)

The power management system 870A may configure the μC charge pump circuit 262 to generate μC charge pump output voltage, $V_{\mu C\_OUT}$, as a function of the battery voltage, $V_{BAT}$. The power management system 870A may determine whether the battery voltage, $V_{BAT}$, is greater than a minimum CMOS logic supply voltage threshold. In response to a determination that the battery voltage, $V_{BAT}$, is at least equal to the minimum CMOS logic supply voltage threshold, the power management system 870A may configure the supply selection switch 962 to provide the battery voltage, $V_{BAT}$, to the CMOS logic supply input 869C. In response to a determination that the battery voltage, $V_{BAT}$, is near or less than the minimum CMOS logic supply voltage threshold, the power management system 870A may configure the supply selection switch 962 to provide the μC charge pump output voltage, $V_{\mu C\_OUT}$, to the CMOS logic supply input 869C. Based on the battery voltage, $V_{BAT}$, and the minimum CMOS logic supply voltage threshold, the power management system 870A configures the μC charge pump circuit 262 to generate μC charge pump output voltage, $V_{\mu C\_OUT}$, having a lowest possible voltage that is at least equal to the minimum CMOS logic supply voltage threshold after accounting for losses between the μC charge pump circuit 262 and the CMOS logic supply input 869C. The clock management circuit 260 may disable the oscillator 270, and generate a μC charge pump clock 276 based on the switching frequency of the switch mode power supply converter. (Step 2010).

The power management system 870A may set a parallel amplifier bypass switch 936 to a closed state to provide a low impedance path to ground. (Step 2012).

The power management system 870A may be configured to average power tracking circuit to control the switch mode power supply converter 2014. The power management system 870 may set the average power tracking transconductance, $Gm_{APT}$. (Step 2014).

The power management system 870A may set the average power tracking mode of operation as a function of the battery voltage, $V_{BAT}$, and the expected output power to be generated by the radio frequency power amplifier 869'. As an example, the power management system 879A may determine the maximum power amplifier supply voltage, $V_{CC\_MAX}$, is expected to be generated based on the envelope characteristics of the modulate radio frequency input signal to be transmitted by the radio frequency power amplifier 869'. Based on a determination that the maximum power amplifier supply voltage, $V_{CC\_MAX}$, is not greater than the battery voltage, $V_{BAT}$, less the headroom of the switching circuit 884, the power management system 870 may select an average power tracking "buck-buck" mode of operation to provide the modulated power supply voltage, $V_{CC}$, at the modulate power supply output 876. As an example, the head room of the headroom of the switching circuit 884 may be between 100mV and 300mV. On the other hand, based on a determination that the maximum power amplifier supply voltage, $V_{CC\_MAX}$, is greater than the battery voltage, $V_{BAT}$, less the headroom of the switching circuit 884, but maximum power amplifier supply voltage, $V_{CC\_MAX}$, is does not exceed the battery voltage, $V_{BAT}$. The power management system 870 may select an average power tracking "buck-boost" mode of operation to provide the modulated power supply voltage, $V_{CC}$, at the modulate power supply output 876. As an example, the power management system 870 may select the First "Buck-Boost" Mode, where the first "bang-bang" switching voltage, $V_{SW\_BB1}$, is substantially equal to zero volts and the second "bang-bang" switching voltage, $V_{SW\_BB2}$, is substantially equal to 3/2 x $V_{BAT}$. In this case, the power management system 870 to operate in a low duty cycle. Yet, as another example, based on a determination that the maximum power amplifier supply voltage, $V_{CC\_MAX}$, is exceeds the battery voltage, $V_{BAT}$, the power management system 870 may select the second "buck-boost" mode in order to benefit from a lower voltage change between the first "bang-bang" switching voltage, $V_{SW\_BB1}$, and the second "bang-bang" switching voltage, $V_{SW-BB2}$, which will tend to reduce the ripple voltage or ripple currents generated at the modulated power supply output 867 and improve efficiency of the switch mode power supply converter 872. (Step 2016)

The power management system 870A configure the first control signal multiplexer 964 to provide the average power tracking control signal 966 as the switch mode power supply feedback signal 40A. (Step 2018).

The power management system 870A may configure the switch mode power supply converter 872 to operate in the selected average power tracking mode of operation. The power management system 870A may configure the switcher control circuit 880 to operate in a segmentation mode as a function of the average expected output power, $P_{OUT\_AVE}$, a set of switcher output power thresholds. The set of switcher output power thresholds may be a function of the expected load line, $R_{RF\_AMP\_EXP}$, of the radio frequency power amplifier 869' and the selected the average power tracking mode of operation. In response, the switch mode power supply converter 872 may generate the switching voltage, $V_{SW}$, in one of the average power tracking "buck-buck" modes and the average power tracking "buck-boost" modes based on the selected average power tracking "bang-bang" mode of operation. (Step 2020).

The power management system 870A may disable the $V_{OFFSET}$ loop circuit 41 and any active noise reduction circuitry. (Step 2022).

After the power management system 870A is configured to operate in the medium power average power tracking modulation mode, the modulated radio frequency input signal may be provided to the radio frequency power amplifier 869', the switch mode power supply converter 872, and the parallel amplifier circuit 784'. In response to the differential $V_{RAMP}$ signal and the modulated radio frequency input signal, the data transmission commences. The data may be transmitted in a data transmission slot. (Step 2024).

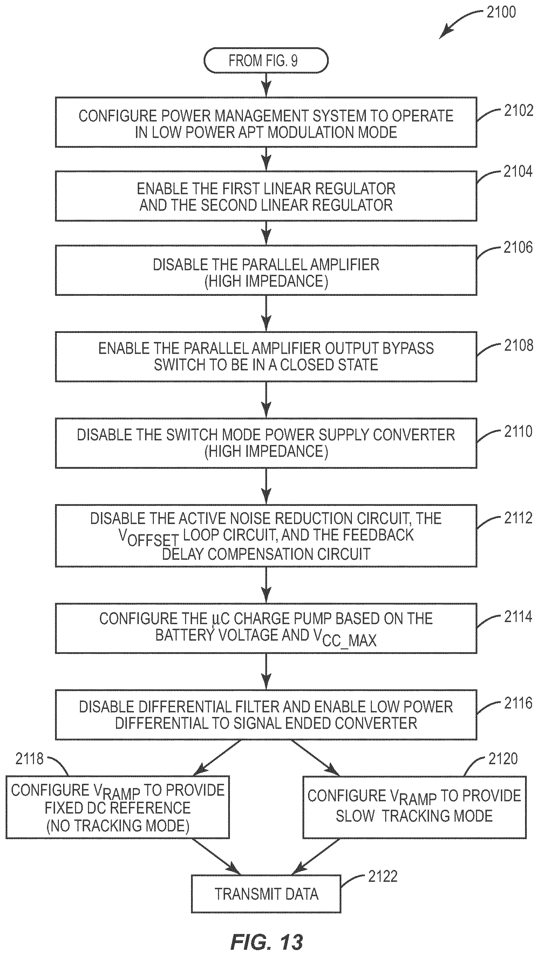

Figure 13 depicts a method 2100 for configuring the pseudo-envelope tracking modulated power supply system 868A to operate in a low power average power tracking modulation mode based on a determination that the expected output power to be generated by the radio frequency power amplifier 869' during a data transmission at less than the high power modulation mode threshold and at least substantially equal to a medium power modulation mode threshold. The method 2100 is described with continuing reference to the various embodiments of the pseudo-envelope tracking modulated power supply system 868A, the power management system 870A, the switch mode power supply converter 872, and parallel amplifier circuit 874', depicted in Figures 8A-B, Figure 9, Figures 10A-B, Figures 11A-B, and Figures 12A-B.

The power management system 870A may configure the power management system to operate in a low power average power tracking modulation mode in response to a determination that the expected output power of the radio frequency power amplifier 869 is less than the low power average power tracking modulation mode threshold. To configure the power management system 870A to operate in the low power modulation mode, the power management system 870A may determine or receive envelope characteristics data that describe the modulated radio frequency signal to be transmitted by the radio frequency power amplifier 869'. In other embodiments, the envelope characteristics data may further include parameters to configure the $\mu$C charge pump circuit 262. (Step 2102).

The power management system 870A may enable the first parallel amplifier 950, $LDO_1$, to regulate the modulated power supply voltage, $V_{CC}$, as a function of the differential $V_{RAMP}$ signal. The power management system 870A may configure the second signal control multiplexer 956 to provide the $V_{RAMP}$ signal to the non-inverting input of the second linear regulator 952, $LDO_2$. In response to the $V_{RAMP}$ signal, the second linear regulator 952, $LDO_2$, may generate a second linear amplifier output voltage, $V_{LDO2}$, as a function of the battery voltage, $V_{BAT}$. (Step 2104).

The power management system 870A may disable the parallel amplifier 928, and configure the parallel amplifier output 928C to provide a high impedance mode to ground. (Step 2106).

The power management system 870A may set the parallel amplifier output bypass switch 936 to be in a closed state. As a result, the negative terminal of the coupling capacitor 18A as short to ground. (Step 2108).

The power management system 870A may disable the switch mode power supply converter 872. For example, the switcher control circuit 880 may disable the multi-level charge pump 882 and the switching circuit 884. The switching voltage output 26 may provide a high impedance path to ground. (Step 2110).

The power management system 870A may also disable any active noise reduction circuit while the power management system 870A is configured to operate in low power average power tracking modulation mode. For example, the power management system 870A may disable the open loop ripple compensation assist circuit 414. In addition, the power management system 870A may disable the $V_{OFFSET}$ loop circuit 41 and the feedback delay compensation circuit 852 while in the low power average power tracking modulation mode. (Step 2112).

The power management system 870A may obtain an estimate of the battery voltage, $V_{BAT}$, from the battery level sense circuit 264. In addition, the power management system 870A may obtain or determine the maximum expected power amplifier supply voltage, $V_{CC\_MAX}$, based on an envelope characteristic of the modulated radio frequency signal to be transmitted by the radio frequency power amplifier 869'. Based on the maximum expected power amplifier supply voltage, $V_{CC\_MAX}$, the battery voltage, $V_{BAT}$, and the maximum headroom voltage of the first linear regulator 950, $LDO_1$, the power management system 870A may select a minimum value of the operational ratio of the $\mu$C charge pump, $\mu BB_{RATIO}$, to permit the first linear regulator 950, $LDO_1$, to generate the maximum expected power amplifier supply voltage, $V_{CC\_MAX}$, during the data transmission. For example, the $\mu C$ charge pump circuit 262 may typically operate in one of the 1/4 x $V_{BAT}$ mode, 1/3 x $V_{BAT}$ mode, or the 1/2 x $V_{BAT}$ mode when the power management system 870A is configured to operate in the low power average power tracking modulation mode. (Step 2112). In addition, the power management system 870A may further determine whether the battery voltage, $V_{BAT}$, is less than the minimum CMOS logic supply voltage. Based on a determination that the battery voltage, $V_{BAT}$, is less than the minimum CMOS logic supply voltage, power management system 870A may determine a minimum value of the operational ratio of the $\mu C$ charge pump, $\mu BB_{RATIO}$, from among the available operational ratios of the $\mu C$ charge pump, $\mu BB_{RATIO}$, that would be at least equal to any losses through the power supply selection switch 962 to the CMOS logic supply input 869C plus the minimum CMOS logic supply voltage threshold. Thereafter, the power management system 870A configures the $\mu C$ charge pump circuit 262 to generate a $\mu C$ charge pump output voltage, $V_{\mu C\_OUT}$, having the lowest voltage level that is sufficient to generate the maximum expected power amplifier supply voltage, $V_{CC\_MAX}$, and at least equals the minimum CMOS logic supply voltage threshold plus any losses through the power supply selection switch 962 to the CMOS logic supply input 869C. The power management system 870A configures the power supply selection switch 962 to provide the $\mu C$ charge pump output voltage, $V_{\mu C\_OUT}$, to the CMOS logic supply input 869C. The clock management system may enable the oscillator 270 to generate the $\mu C$ charge pump clock 276. (Step 2114).

The power management system 870A may disable the differential filter 924, and configure the low power differential to single ended converter 942 to generate a $V_{RAMP}$ signal configured for a no tracking mode of operation. (Step 2116). The digital base band processing portion of a transceiver/communication device may be configured to provide a differential $V_{RAMP}$ signal that is substantially fixed direct current (DC) reference voltage to the power management system 870A. (Step 2118). Thereafter, the data transmission commences. (Step 2122). However, in some alternative embodiments of the power management system, such as those depicted in Figures 2D-E, and Figures 8H, the power management system 870A may enable the differential filter 924 to provide the control signal 926 with a low level of frequency response compensation or correction in the low power average tracking modulation mode. In this case, the power management system 870A may configure the differential filter 924 to provide the control signal 926, (Alternate Step 2116). The digital base band processing portion of a transceiver/communication device may be configured to provide a differential $V_{RAMP}$ signal that provides for a slow tracking mode substantially fixed direct current (DC) reference voltage to the power management system 870A. (Step 2118). Thereafter, the data transmission commences. (Step 2122).

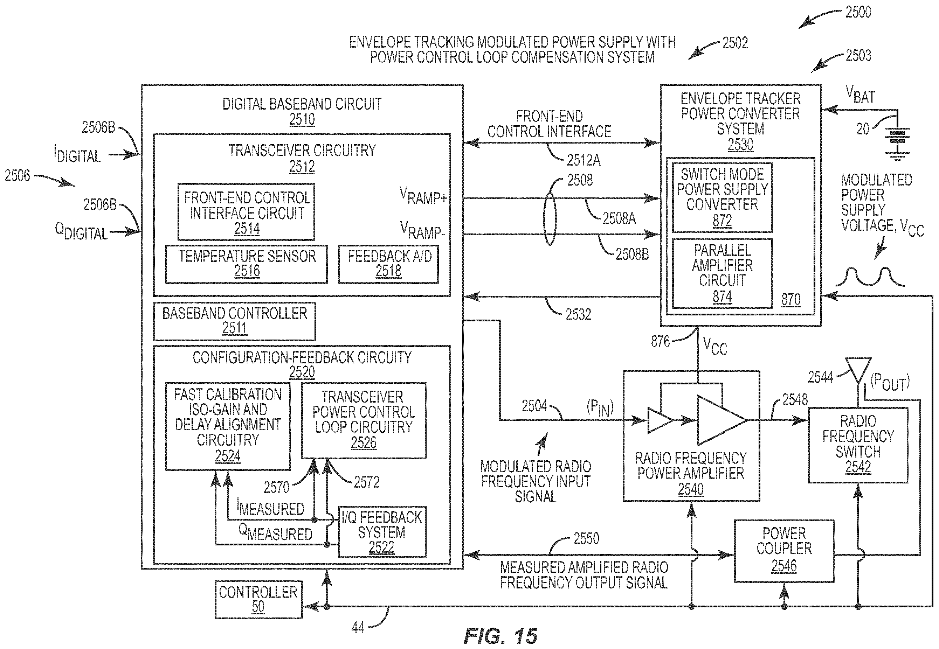

Figure 15 depicts a portion of a communication device including various embodiments of an envelope tracking modulated power supply system 2500 with transceiver power control loop compensation. For the purposes of illustration and not by way of limitation, the envelope tracking modulated power supply system 2500 with transceiver power control loop compensation may be described with continuing reference to a number of the embodiments the pseudo-envelope tracking modulated power supply system 868 and the pseudo-envelope tracking modulated power supply system 868A, depicted in Figures 2A-E, and Figures 8A-B and Figure 8E-H, and the embodiments of the parallel amplifier 2200 depicted in Figure 8C, respectively.

The envelope tracking modulated power supply system 2500 with transceiver power control loop compensation may include a transceiver power control loop 2502 and an envelope tracking control system 2503. The transceiver power control loop 2502 may include a transmit-target power setting parameter 2502A and a transmit-gain setting parameter 2502B. The transceiver power control loop 2502 may adjust a drive level or an input power $P_{IN}$ of a modulated radio frequency input signal 2504 provided to a radio frequency power amplifier 2540 based on the values of the transmit-target power setting parameter 2502A and the transmit-gain setting parameter 2502B as a function of the output power $P_{OUT}$ generated by the radio frequency power amplifier 2540.

In some embodiments, the modulated radio frequency input signal 2504, $P_{IN}$, may be a test signal. As an example, the modulated radio frequency input signal 2504, $P_{IN}$, may be a carrier wave having a desired frequency.

In some embodiments of the communication device, the transmit-target power setting parameter 2502A may be based on network control information provided by a communication network in which the communication device is configured to operate. For example, the communication network may provide the communication device with network control information to configure the operation of the communication device within the communication network. In some embodiments, the transmit-target power setting parameter 2502A used by a communication device may be a function of the different wireless transmissions generated by the communication device. The transmit-target power setting parameter 2502A of the communication device may also be based on a data rate of the transmission, the resource blocks to be used during the transmission, a frequency band allocated for the transmission, the relative location of the transmission band to other bands of operation in the communication network, and/or a combination thereof. As another example, the transmit-target power setting parameter 2502A may be a function of the distance between the communication device and a nearest base station of the communication network. For example, the communication device may use an initial value of the transmit-target power setting parameter 2502A based on a target base station to receive an initial transmission. Thereafter, the communication network may configure the communication device to use a new value of the transmit-target power setting parameter 2502A based on a serving base station.

In some embodiments, the transceiver power control loop 2502 may adjust the transmit-gain setting parameter 2502B in response to changes in bias settings of the transceiver circuitry 2512, a temperature change of the digital baseband circuit 2510, and/or changes in the voltage standing wave ratio, VSWR, for a particular transmit frequency.

As an example, the transceiver power control loop 2502 may be configured to adjust a transmit-gain setting parameter 2502B to provide a modulated radio frequency input signal 2504 to a radio frequency power amplifier 2540. In some embodiments, the transmit-gain setting parameter 2502B may be adjusted as a function of the output power $P_{OUT}$ of the amplified radio frequency output signal 2548 provided to the antenna 2544 and the transmit-target power setting parameter 2502A.

For example, in some embodiments, the transceiver power control loop 2502 may increase the transmit-gain setting parameter 2502B used to set the input power $P_{IN}$ of the modulated radio frequency input signal 2504 provided to the radio frequency power amplifier 2540 in response to a decrease in the output power $P_{OUT}$ of an amplified radio frequency output signal 2548 provided to the antenna 2544. In response to the increase of the transmit-gain setting parameter 2502B, the transceiver circuitry 2512 may increase the drive level of the modulated radio frequency input signal 2504 provided to the radio frequency power amplifier 2540. In other words, the transceiver circuitry 2512 may increase the input power $P_{IN}$ of the modulated radio frequency input signal 2504 to increase the output power $P_{OUT}$ of the amplified radio frequency output signal 2548. To avoid gain compression due to the increase drive level of the modulated radio frequency input signal 2504, the envelope tracking control system 2503 may be configured to increase the amplitude of the modulated power supply voltage, $V_{CC}$, provided to the collector of the radio frequency power amplifier 2540. Otherwise, the modulated power supply voltage, $V_{CC}$, may be insufficient to support the increased output power $P_{OUT}$ to be generated by the radio frequency power amplifier 2540. Gain compression may result in degradation of the spectrum performance and the error vector magnitude (EVM) performance of the transmitted signal as measured at the output of the radio frequency power amplifier 2540.

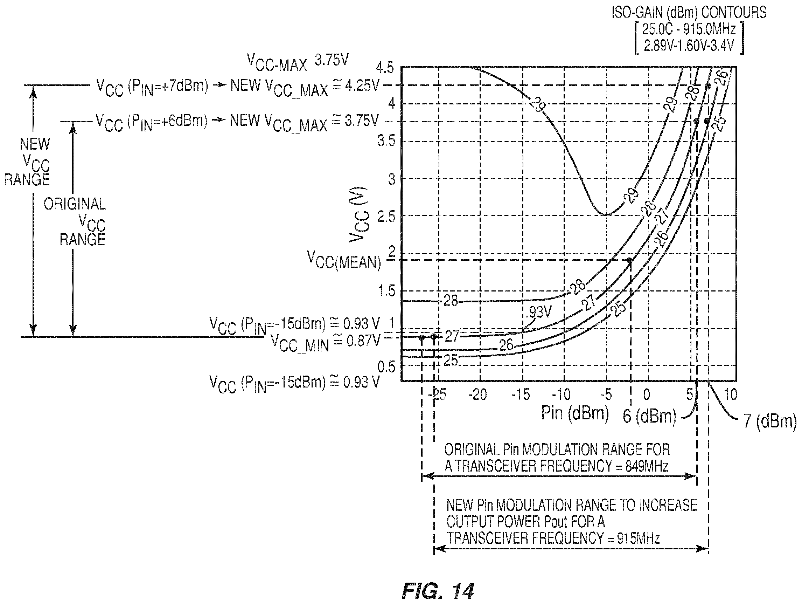

For example, Figure 14 depicts a set of iso-gain contours of the radio frequency power amplifier 2540 that may be stored in a $V_{CC}$ look up table 2586, and used to generate the modulated power supply voltage, $V_{CC}$, provided to the collector of the radio frequency power amplifier 2540. For example, the sets of iso-gain contours may depict an iso-gain curve for the power gains 28dBm, 27dBm, 26dBm, and 25dBm. In addition, Figure 14 depicts an original input power $P_{IN}$ or drive level of a modulated radio frequency input signal provided as an input to the radio frequency power amplifier 2540 to transmit a data signal. Figure 14 further depicts an original range of the modulated power supply voltage, $V_{CC}$, generated by the envelope tracking power converter system 2530 as a function of the digital I/Q signal 2506 provided to a digital baseband circuit 2510 for transmission. The modulated radio frequency input signal 2504 may also be generated based on the digital I/Q signal 2506. Figure 14 further depicts a new range of the modulated power supply voltage, $V_{CC}$, that should be generated by the envelope tracking power converter system 2530 in response to the input power $P_{IN}$ of a modulated radio frequency input signal being increased by 1dBm while maintaining the same modulation range. As shown in Figure 14, if the envelope tracking power converter system 2530 is not configured to generate a modulated power supply voltage, $V_{CC}$, greater than 3.75 volts, the modulated radio frequency input signal may cause the radio frequency power amplifier 2540 to change from the iso-gain contour for 27dBm of power gain to the iso-gain contour for 26dBm for an input power $P_{IN}$ or drive level above 6dBm. As a result, the radio frequency power amplifier 2540 may operate in a non-linear mode and jump from one iso-gain contour to another during the data transmission. This may result in gain compression. To avoid this problem, the envelope tracking control system 2503 may determine whether the transceiver power control loop 2502 has increased the drive level of the modulated radio frequency input signal, such that the envelope tracking power converter system 2530 may not be able to provide a sufficient range for the modulated power supply voltage, $V_{CC}$, to support the increase in drive level. In that case, the envelope tracking control system 2503 may configure the digital baseband circuit 2510 to generate a control signal 2508 that will support the new range of the modulated power supply voltage, $V_{CC}$, necessary to prevent gain compression.

As an example, to avoid gain compression, the transceiver power control loop 2502 may be further configured to cooperatively operate with the envelope tracking control system 2503. The envelope tracking control system 2503 may provide the control signal 2508 to the envelope tracking power converter system 2530 as a function of the digital I/Q signal 2506 provided to the digital baseband circuit 2510 for transmission. The digital I/Q signal 2506 may include a digital in-phase component $I_{DIGITAL}$ 2506A and a digital quadrature component $Q_{DIGITAL}$ 2506B. In addition, the envelope tracking control system 2503 may be configured to adjust the control signal 2508 as a function of the transmit-gain setting parameter 2502B, the transmit-target power setting parameter 2502A, a temperature measurement of the digital baseband circuit 2510, and/or some combination thereof. In still other embodiments, the envelope tracking control system 2503 may be further configured to adjust the control signal 2508 as a function of the transmit frequency of the transmitter channel for the band of operation in which the communication device is configured to operate. As an example, in some embodiments, the envelope tracking control system 2503 may adjust the generation of a modulated power supply voltage, $V_{CC}$, as a function of a transmit-target power setting parameter 2502A and a transmit-gain setting parameter 2502B, and a transmit frequency of the transmitter channel.

Figure 15 may further depict an embodiment of a system, circuitry, and methods for providing a transceiver power control loop 2502 configured to regulate the output power $P_{OUT}$ of an amplified radio frequency output signal 2548 provided to the antenna 2544 in response to the modulated radio frequency input signal 2504.

Figure 15 depicts the envelope tracking modulated power supply system 2500 with transceiver power control loop compensation including a digital baseband circuit 2510, an envelope tracking power converter system 2530, a radio frequency power amplifier 2540, a radio frequency switch 2542 in combination with an antenna 2544 and power coupler 2546. The digital baseband circuit 2510, the envelope tracking power converter system 2530, the radio frequency power amplifier 2540, and radio frequency switch 2542 may be in communication with a controller 50 via a control bus 44. The controller 50 may control and/or provide parameters to govern the function of the digital baseband circuit 2510, the envelope tracking power converter system 2530, the radio frequency power amplifier 2540, and the radio frequency switch 2542 by selectively setting parameters and settings in the various devices. In addition, as will be discussed, the controller 50 may also provide a transmit-target power setting parameter 2502A to the digital baseband circuit 2510 as output power level control information received by the envelope tracking modulated power supply system 2500 from a base station of a communication network in which the envelope tracking modulated power supply system 2500 is configured to operate. The transmit-target power setting parameter 2502A may configure the digital baseband circuit 2510 to provide a modulated radio frequency input signal 2504 having an input power $P_{IN}$ to the radio frequency power amplifier 2540. The digital baseband circuit 2510 may be configured to receive the digital I/Q signal 2506 to be transmitted by the radio frequency power amplifier 2540 during a data transmission The digital I/Q signal 2506 may include a digital in-phase component $I_{DIGITAL}$ 2506A and a digital quadrature component $Q_{DIGITAL}$ 2506B. The digital baseband circuit 2510 may include transceiver circuitry 2512 and configuration-feedback circuitry 2520. The transceiver circuitry 2512 may include a front-end control interface circuit 2514 configured to communicate via a front-end control interface 2514A to the envelope tracking power converter system 2530. In addition, the digital baseband circuit 2510 may also configure various operational parameters of the envelope tracking power converter system 2530 via the front-end control interface 2514A. As an example, in some embodiments, the digital baseband circuit 2510 may provide various operational parameters via the front-end control interface 2514A to the envelope tracking power converter system 2530 as a function of a regulated time period.

In addition, the transceiver circuitry 2512 may provide a control signal 2508 to the envelope tracking power converter system 2530. In some embodiments, the control signal 2508 may be a differential control signal having a non-inverted control signal component 2508A and an inverted control signal component 2508B. For example, the control signal 2508 may be a differential $V_{RAMP}$ signal having a non-inverted $V_{RAMP}$ signal component and an inverted $V_{RAMP}$ signal component. The control signal 2508 may provide a target voltage for the modulated power supply voltage, $V_{CC}$, at the modulated power supply output 876. Based on the control signal 2508, the envelope tracking power converter system 2530 may generate a modulated power supply voltage, $V_{CC}$, at the modulated power supply output 876. The transceiver circuitry 2512 may further include a temperature sensor 2516 configured to provide a temperature measurement of the digital baseband circuit 2510.

The transceiver circuitry 2512 may also include a feedback analog-to-digital converter 2518 configured to receive a measurement signal 2532 from the envelope tracking power converter system 2530. The measurement signal 2532 in combination with the feedback analog-to-digital converter 2518 may provide information such as the temperature and supply voltage of the envelope tracking power converter system 2530.

The feedback analog-to-digital converter 2518 may receive the measurement signal 2532 from the envelope tracking power converter system 2530. The feedback analog-to-digital converter 2518 may convert the measurement signal 2532 into digital data, which may be provided to the controller 50 or other portions of the digital baseband circuit 2510. For example, in some embodiments, the envelope tracking power converter system 2530 may provide various types of measurements, including an analog temperature signal, an analog power supply voltage signal, and a measurement of the battery voltage, $V_{BAT}$.

For example, via the front-end control interface 2514A, the digital baseband circuit 2510 may request the envelope tracking power converter system 2530 to provide a measurement of the battery voltage, $V_{BAT}$, from a battery 20. In response, the envelope tracking power converter system 2530 may provide a measurement of the battery voltage, $V_{BAT}$, to the feedback analog-to-digital converter 2518 via the measurement signal 2532. In a similar fashion, the digital baseband circuit 2510 may obtain a measurement of the temperature of the envelope tracking power converter system 2530 via the measurement signal 2532.

Based on the digital in-phase component $I_{DIGITAL}$ 2506A and the digital quadrature component $Q_{DIGITAL}$ 2506B, the transceiver circuitry 2512 may generate a control signal 2508 to provide a target voltage for generation of a modulated power supply voltage, $V_{CC}$. As previously described, in some embodiments the control signal 2508 may be a differential $V_{RAMP}$ signal. The envelope tracking power converter system 2530 may configure the digital baseband circuit 2510 to generate the control signal 2508 as a function of the modulated radio frequency input signal 2504 provided to the radio frequency power amplifier 2540 for transmission. The envelope tracking power converter system 2530 may generate the modulated power supply voltage, $V_{CC}$, at the modulated power supply output 876 in response to the control signal 2508. The envelope tracking power converter system 2530 may provide the modulated power supply voltage, $V_{CC}$, to the radio frequency power amplifier 2540.

The radio frequency power amplifier 2540 may generate an amplified radio frequency output signal 2548 as a function of the input power $P_{IN}$ of the modulated radio frequency input signal 2504 and the modulated power supply voltage $V_{CC}$. The radio frequency power amplifier 2540 may provide the amplified radio frequency output signal 2548 to the antenna 2544 via a radio frequency switch 2542.

In response to the amplified radio frequency output signal 2548, the power coupler 2546 may obtain a measurement of the amplified radio frequency output signal 2548. In some embodiments, the power coupler 2546 may also obtain a measurement of the output power of the amplified radio frequency output signal 2548, present at the antenna 2544. In other embodiments of the transceiver power control loop 2502, the power coupler 2546 may be located at the output of the radio frequency power amplifier 2540 and configured to obtain a measurement of the amplified radio frequency output signal 2548 before passing through the radio frequency switch 2542. Some embodiments of the power coupler 2546 may include a power detector configured to measure the output power $P_{OUT}$ of the amplified radio frequency output signal 2548 at the output of the radio frequency power amplifier 2540. The power coupler 2546 may provide a measured amplified radio frequency output signal 2550 to the digital baseband circuit 2510. For example, the power coupler 2546 may provide the measured amplified radio frequency output signal 2550 to the configuration-feedback circuitry 2520 of the digital baseband circuit 2510.

The I/Q feedback system 2522 may receive the measured amplified radio frequency output signal 2550. The I/Q feedback system 2522 may demodulate the measured amplified radio frequency output signal 2550 to obtain a digitized in-phase feedback component $I_{MEASURED}$ 2570 and a digitized quadrature feedback component Q MEASURED 2572 as a function of the measured amplified radio frequency output signal 2550.

The digitized in-phase feedback component $I_{MEASURED}$ 2570 and the digitized quadrature feedback component Q MEASURED 2572 may be provided to the fast calibration iso-gain and delay alignment circuitry 2524 and the transceiver power control loop circuitry 2526. The transceiver power control loop circuitry 2526 also receives the transmit-target power setting parameter 2502A. Based on the digitized in-phase feedback component $I_{MEASURED}$ 2570 and the digitized quadrature feedback component Q MEASURED 2572, the transceiver power control loop circuitry 2526 may determine whether to increase or decrease the power level of the modulated radio frequency input signal 2504 as a function of the transmit-target power setting parameter 2502A.

For example, the transceiver power control loop circuitry 2526 may determine that the output power $P_{OUT}$ of the measured amplified radio frequency output signal 2550 is less than the transmit-target power setting parameter 2502A. In response to the determination that the output power $P_{OUT}$ of the measured amplified radio frequency output signal 2550 is less than the transmit-target power setting parameter 2502A, the transceiver power control loop circuitry 2526 may configure the transceiver circuitry 2512 to increase the input power $P_{IN}$ of the modulated radio frequency input signal 2504 provided to the radio frequency power amplifier 2540. For example, in some embodiments, the transceiver power control loop circuitry 2526 may increase the magnitude of the transmit-gain setting parameter 2502B. The transceiver power control loop circuitry 2526 may generate a transmit-gain setting signal 2526A based on the transmit-gain setting parameter 2502B. In some embodiments, the transceiver power control loop circuitry 2526 may provide the transmit-gain setting signal 2526A to a baseband controller 2511. The baseband controller 2511 may be configured to adjust various parameters and settings of the transceiver circuitry 2512 to increase the drive level or input power $P_{IN}$ of the modulated radio frequency input signal 2504 to compensate for the difference between the transmit-target power setting parameter 2502A and the output power $P_{OUT}$ of the measured amplified radio frequency output signal 2550.

In addition, the transceiver power control loop circuitry 2526 may provide the transmit-gain setting signal 2526A and a transmit-target power setting signal 2526B to a pseudo-envelope follower gain controller 2574, which in the drawings is abbreviated as the PEF gain control circuit. Alternatively, in some embodiments, the baseband controller 2511 may provide the transmit-gain setting parameter 2502B and a transmit-target output power parameter to the pseudo-envelope follower gain controller 2574. For example, in some alternative embodiments, the baseband controller 2511 may configure the pseudo-envelope follower gain controller 2574 to generate a gain control signal 2574A having a gain control magnitude substantially equal to $G_{CONTROL}$.

On the other hand, the transceiver power control loop circuitry 2526 may determine that the output power $P_{OUT}$ of the measured amplified radio frequency output signal 2550 exceeds the transmit-target power setting parameter 2502A. Based on a determination that the output power $P_{OUT}$ of the measured amplified radio frequency output signal 2550 exceeds the transmit-target power setting parameter 2502A, the transceiver power control loop circuitry 2526 may decrease the magnitude of the transmit-gain setting parameter 2502B.

The transceiver power control loop circuitry 2526 may generate a transmit-gain setting signal 2526A based on the reduced magnitude of the transmit-gain setting parameter 2502B. In some embodiments, the baseband controller 2511 may be configured to adjust various parameters and settings of the transceiver circuitry 2512 to reduce the drive level or input power $P_{IN}$ of the modulated radio frequency input signal 2504 to decrease the output power $P_{OUT}$ of the measured amplified radio frequency output signal 2550. In addition, the transceiver power control loop circuitry 2526 may provide the transmit-gain setting signal 2526A to the pseudo-envelope follower gain controller 2574.

In some embodiments the power coupler 2546 may include a detector. The detector may include a sensor in communication with an output of the radio frequency power amplifier 2540. The detector may measure an output power generated by the radio frequency power amplifier 2540. As an example, after accounting for losses in the radio frequency switch 2542, the power coupler 2546 may provide a measured output power, $P_{OUT}$, of the amplified radio frequency output signal 2548. The measured output power may provide an average power measurement. The power coupler 2546 may also provide an average power measurement based on various averaging techniques. In some embodiments, the power coupler 2546 may be configured to provide a peak power measurement. In some embodiments, the power coupler 2546 may be configured as a linear power detector. In other embodiments, the power coupler 2546 may be a logarithmic power detector. In still other embodiments, the power coupler 2546 may be a non-linear power detector.

The radio frequency switch 2542 includes a closed state of operation and an open state of operation. In the closed state of operation, the radio frequency switch 2542 may couple the radio frequency power amplifier 2540 to the antenna 2544, which permits the amplified radio frequency output signal 2548 to pass through the radio frequency switch 2542 to the antenna 2544 to transmit the amplified radio frequency output signal 2548. In the open state of operation, the radio frequency switch 2542 substantially attenuates the amplified radio frequency output signal 2548 to minimize or prevent a transmission of the amplified radio frequency output signal 2548. Ideally, in the open state of operation, the radio frequency switch 2542 has infinite impedance. In some embodiments, the radio frequency switch 2542 may provide antenna switch isolation around +25 dBm.

In some embodiments, the communication device may include a controller 50 configured to coordinate the functions of the various components and operations of the embodiments of the envelope tracking modulated power supply system 2500 with transceiver power control loop compensation. In some embodiments, the controller 50 may include a number of distributed processors, distributed microcontrollers, controllers, local control units, memory mapped local memory for various components, functions, and features of the various embodiments of the power management system 870, the various embodiments of the switch mode power supply converter 872, the various embodiments of the parallel amplifier circuit 874, firmware circuitry, reconfigurable digital logic circuitry, state machines, analog logic circuitry, a number of communication interfaces and busses, various forms of memory, data registers, control registers, cache memory, distributed memory, memory mappings, register mappings, various types of sensors and inputs for receiving sensory data or information, one or more digital-to-analog converters, one or more analog-to-digital converters, various types and numbers of output drivers, various types and numbers of digital input buffers and analog input buffers, various processor cores and arithmetic operation units, sub-processors, read only memory, random access memory, flash memory circuitry, electronically fusible memory, interrupt handlers, interrupt handling management systems, and controls signals. For the sake of simplicity of description, and not by way of limitation, the controller 50 may be described as performing various functions and features to govern the operation of the communication device, the various embodiments of the envelope tracking modulated power supply system 2500 with transceiver power control loop compensation, the digital baseband circuit 2510, the envelope tracking power converter system 2530, the radio frequency power amplifier 2540, the radio frequency switch 2542, the power coupler 2546. As an example, and not by way of limitation, the controller 50 may include a control bus 44 in communication with the digital baseband circuit 2510, the envelope tracking power converter system 2530, the radio frequency power amplifier 2540, the radio frequency switch 2542, and the power coupler 2546. For the sake of simplicity, and not by way of limitation, the control bus 44 is only depicted as being in communication with each component depicted in Figure 15. Even so, one of ordinary skill in the art will understand that this is by way of example and not by way of limitation.

For example, the controller 50 may be in communication with various other elements to be described in the digital baseband circuit 2510, the embodiments of the switch mode power supply converter 872, and the embodiments of the parallel amplifier circuit 874 of the envelope tracking power converter system 2530. As an example, the controller 50 may be in communication with and cooperatively operate with the various embodiments of the power management system 870.

The controller 50 may include a processor, a Digital Signal Processor (DSP), an Application Specific Integrated Circuit (ASIC), a Field Programmable Gate Array (FPGA) or other programmable logic device, discrete gate or transistor logic, discrete hardware components, or any combination thereof designed to perform the functions described herein. A processor may be a microprocessor. In the alternative, the processor may be any conventional processor, controller, microcontroller, a state machine and/or a combination thereof. A processor may also be implemented as a combination of computing devices. As an example, a combination of computing devices may include a combination of a DSP and a microprocessor, a plurality of microprocessors, one or more microprocessors in conjunction with a DSP core, or any other such configuration. The processor 28 may further include or be embodied in hardware and in computer executable instructions that are stored in memory, and may reside, for example, in Random Access Memory (RAM), flash memory, Read Only Memory (ROM), Electrically Programmable ROM (EPROM), Electrically Erasable Programmable ROM (EEPROM), registers, hard disk, a removable disk, a CD-ROM, or any other form of computer readable medium known in the art. An exemplary storage medium may be coupled to the processor such that a processor can read information from, and write information to, the storage medium. In the alternative, the storage medium or a portion of the storage medium may be integral to the processor. The processor and the storage medium may reside in an Application Specific Integrated Circuit (ASIC).

The front-end control interface circuit 2514 is in communication with the envelope tracking power converter system 2530 via a front-end control interface 2536. In some embodiments, the front-end control interface circuit 2514 may operate with a Mobile Industry Processor Interface® standard based device via the front-end control interface 2536. As an example, the front-end control interface circuit 2514 and the front-end control interface 2536 may be configured to control devices based on a Radio Frequency Front-End control interface specification.

In some embodiments, the controller 50 may cooperatively interoperate the front-end control interface circuit 2514 to configure and control the envelope tracking power converter system 2530. In still other embodiments, the controller 50 may be a supervisory processor that governs other controllers. The baseband controller 2511 may include configurable firmware, a processor, sub-controllers, control logic, control circuitry, one or more state machines, a Digital Signal Processor (DSP), an ASIC, a Field Programmable Gate Array (FPGA) or other programmable logic device, discrete gate or transistor logic, discrete hardware components, or any combination thereof designed to perform the functions described herein. The baseband controller 2511 may include firmware, executable program code, read only memory, fusible memory, a memory processor, a microprocessor, conventional processor, controller, microcontroller, or state machine. A processor may also be implemented as a combination of computing devices. As an example, a combination of computing devices may include a combination of a DSP and a microprocessor, a plurality of microprocessors, one or more microprocessors in conjunction with a DSP core, or any other such configuration. The controller 50 may further include or be embodied in hardware and in computer executable instructions that are stored in memory, and may reside, for example, in Random Access Memory (RAM), flash memory, Read Only Memory (ROM), Electrically Programmable ROM (EPROM), Electrically Erasable Programmable ROM (EEPROM), registers, hard disk, a removable disk, a CD-ROM, or any other form of computer readable medium known in the art. An exemplary storage medium may be coupled to the processor such that a processor can read information from, and write information to, the storage medium. In the alternative, the storage medium or a portion of the storage medium may be integral to the processor. The processor and the storage medium may reside in an Application Specific Integrated Circuit (ASIC).

The digital baseband circuit 2510 may receive a digital I/Q signal 2506 to be transmitted by the radio frequency power amplifier 2540. For example, the digital I/Q signal 2506 includes a digital data signal. Alternatively, the digital I/Q signal 2506 may be a test signal for calibrating various parts of the envelope tracking modulated power supply system 2500 with transceiver power control loop compensation. In some embodiments, the digital I/Q signal 2506 may include a digital in-phase component $I_{DIGITAL}$ 2506A and a digital quadrature component $Q_{DIGITAL}$ 2506B. The digital in-phase component $I_{DIGITAL}$ 2506A and the digital quadrature component $Q_{DIGITAL}$ 2506B where the digital in-phase component $I_{DIGITAL}$ 2506A and the digital quadrature component $Q_{DIGITAL}$ 2506B represent the in-phase and quadrature components of a signal to be transmitted. The digital I/Q signal 2506 may receive various types of test signals to generate a modulated radio frequency input signal 2504 having a desired envelope characteristic. In addition, the digital I/Q signal 2506 may include a test signal that generates the modulated radio frequency input signal 2504 having a desired frequency characteristic or periodicity. For example, dependent upon a band of operation of a communication network to which a communication device is assigned or a wideband modulation technique associated with the band of operation, the test signal received by the digital I/Q signal 2506 may include various frequency characteristics. As an example, for the case where a wideband modulation technique includes a particular modulation bandwidth, the digital I/Q signal 2506 may generate a modulated radio frequency input signal 2504 that has a bandwidth substantially similar to the bandwidth associated with the wideband modulation technique or the band of operation assigned to the communication device.

The digital baseband circuit 2510 may further include a pseudo-envelope follower gain controller 2574 configured to provide a gain control signal 2574A having a gain control magnitude substantially equal to $G_{CONTROL}$. The pseudo-envelope follower gain controller 2574 may adjust the magnitude of the gain control signal 2574A based as a function of a measured temperature of the transceiver circuitry 2512, the transmit-gain setting signal 2526A, a carrier frequency for the band of operation in which the communication device is configured to operate, and/or a combination thereof to generate the $V_{CC}$ look up table index signal 2584 at the input of the $V_{CC}$ look up table 2586. The pseudo-envelope follower gain controller 2574 may adjust the gain control magnitude, $G_{CONTROL}$, such that the $V_{CC}$ look up table index signal 2584 provides an index signal into the $V_{CC}$ look up table 2586 that substantially emulates the drive level or input power $P_{IN}$ of the modulated radio frequency input signal 2504 provided to the radio frequency power amplifier 2540. In other words, the pseudo-envelope follower gain controller 2574 may adjust the magnitude of the gain control magnitude, $G_{CONTROL}$, such that the $V_{CC}$ look up table compensated envelope signal 2588 may provide a target voltage for the modulated power supply voltage, $V_{CC}$, as a function of the iso-gain curve that corresponds to the transmit-target power setting parameter 2502A. As a result, the gain control signal 2574A may compensate for an increase in the input power of the modulated radio frequency input signal provided to the radio frequency power amplifier 2540 to prevent or minimize gain compression.

The envelope tracking power converter system 2530 may include various circuits to generate a modulated power supply voltage, $V_{CC}$, at the modulated power supply output 876. As a non-limiting example, some embodiments of the envelope tracking power converter system 2530 may include the switch mode power supply converter 872 and the parallel amplifier circuit 874. In some embodiments, the switch mode power supply converter 872 may be a buck converter. In other embodiments, the switch mode power supply converter 872 may include a multi-level charge pump buck converter configured to buck and/or boost a supply voltage to provide a switching voltage at different voltages dependent upon the control signal 2508. As a non-limiting example, in some embodiments, the envelope tracking power converter system 2530 may operate in various power level modulation modes depending on the expected output power to be generated by the radio frequency power amplifier 2540 in a data transmission.

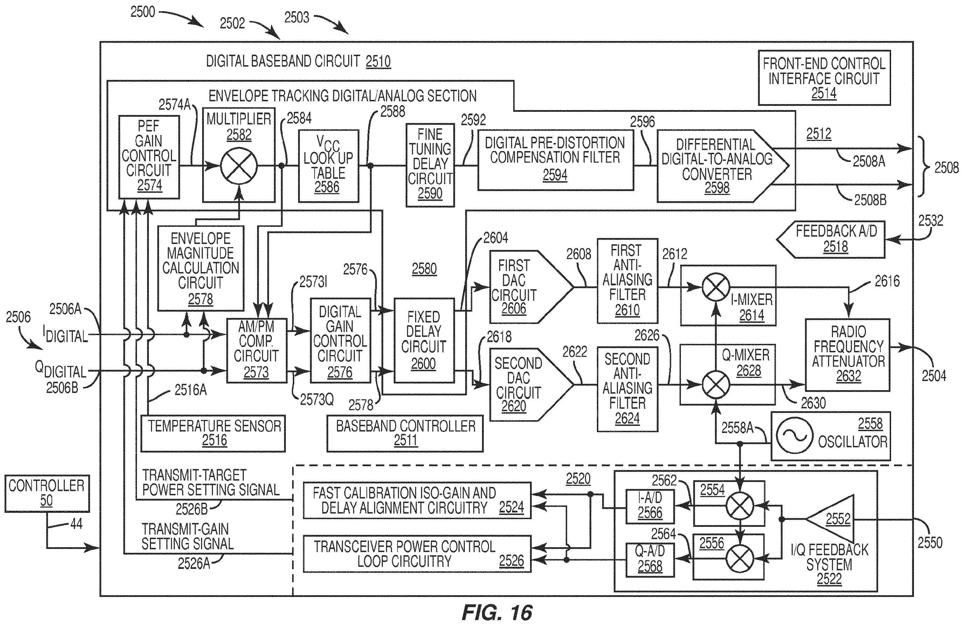

As depicted in Figure 16, the transceiver circuitry 2512 may include an AM/PM compensation circuit 2573, a digital gain control circuit 2576, an envelope magnitude calculation circuit 2578, and an envelope tracking digital/analog section 2580. The envelope magnitude calculation circuit 2578 may receive the digital in-phase component $I_{DIGITAL}$ 2506A and the digital quadrature component $Q_{DIGITAL}$ 2506B. The envelope magnitude calculation circuit 2578 may calculate an envelope magnitude, $\zeta_{MAGNITUDE}$, of an expected envelope of the modulated radio frequency input signal 2504, $P_{IN}$. As an example, the envelope magnitude calculation circuit 2578 may generate the envelope magnitude, $\zeta_{MAGNITUDE}$, based on the digital in-phase component $I_{DIGITAL}$ 2506A and the digital quadrature component $Q_{DIGITAL}$ 2506B. In some embodiments, the envelope magnitude, $\zeta_{MAGNITUDE}$, may be proportional to the magnitude of the envelope of the modulated radio frequency input signal 2504, $P_{IN}$. As a non-limiting example, the envelope magnitude, $\zeta_{MAGNITUDE}$, may be described by equation (1) as follows:

$$(1) \quad \zeta_{MAGNITUDE} = \sqrt{I_{DIGITAL}^{2} + Q_{DIGITAL}^{2}}$$

The envelope magnitude calculation circuit 2578 provides the envelope magnitude, $\zeta_{MAGNITUDE}$, to the envelope tracking digital/analog section 2580.

The AM/PM compensation circuit 2573 may be configured to receive the digital in-phase component $I_{DIGITAL}$ 2506A and the digital quadrature component $Q_{DIGITAL}$ 2506B. In some embodiments, the AM/PM compensation circuit 2573 may be configured to provide amplitude modulation and phase modulation compensation for the radio frequency power amplifier 2540. For example, some embodiments of the AM/PM compensation circuit 2573 may adjust the digital in-phase component $I_{DIGITAL}$ 2506A and the digital quadrature component $Q_{DIGITAL}$ 2506B to compensate for any phase shift due to the modulated power supply voltage, $V_{CC}$, the input power, $P_{IN}$, of the modulated radio frequency input signal 2504 to be transmitted by the radio frequency power amplifier 2540, and/or a combination thereof.

For example, some embodiments of the AM/PM compensation circuit 2573 may receive the $V_{CC}$ look up table index signal 2584 and the $V_{CC}$ look up table compensated envelope signal 2588. The $V_{CC}$ look up table index signal 2584 may be substantially equivalent to a digital representation of the envelope of the modulated radio frequency input signal 2504 provided to the radio frequency power amplifier 2540 for transmission. The $V_{CC}$ look up table compensated envelope signal 2588 may be substantially equivalent to a digital representation of a target envelope for the envelope tracking power converter system 2530 to track or follow to generate a modulated power supply voltage, $V_{CC}$, that substantially corresponds to the modulated radio frequency input signal 2504. In other words, the $V_{CC}$ look up table 2586 may translate the $V_{CC}$ look up table index signal 2584 into a desired target voltage for the modulated power supply voltage, $V_{CC}$.

As will be described, the pseudo-envelope follower gain controller 2574 may generate the gain control, $G_{CONTROL}$, signal as a function of a temperature of the digital baseband circuit 2510, the transmit-target power setting signal 2526B, the transmit-gain setting signal 2526A, and/or a combination thereof to adjust the magnitude of the envelope magnitude, $\zeta_{MAGNITUDE}$, signal. As a result, the $V_{CC}$ look up table index signal 2584 may include a transceiver gain adjusted envelope magnitude $\zeta_{TGA-MAGNITUDE}$, substantially equal to the product of the envelope magnitude, $\zeta_{MAGNITUDE}$, signal and the gain control, $G_{CONTROL}$, signal. The gain control, $G_{CONTROL}$, adjusts the envelope magnitude, $\zeta_{MAGNITUDE}$, signal to reflect a change in the transceiver gain such that the $V_{CC}$ look up table index signal is not solely based on the expected output power to be generated by the radio frequency power amplifier 2540 in response to the modulated radio frequency input signal 2504. Transceiver gain adjusted envelope magnitude, $\zeta_{TGA-MAGNITUDE}$, is provided by the equation (2) as follows:

$$(2) \quad \zeta_{TGA-MAGNITUDE} = \zeta_{MAGNITUDE} \times G_{CONTROL},$$

where the gain control, $G_{CONTROL}$, may be a function of the transceiver temperature, $T_{TRANCEIVER}$, and the transceiver gain settings, $G_{TRANSCEIVER}$. In some embodiments, the gain control, $G_{CONTROL}$, may also be a function of the transceiver transmit frequency, $F_{TRANSMIT}$.

Accordingly, the $V_{CC}$ look up table index signal 2584 substantially compensates for a change in the gain of the digital transceiver to reflect the input drive level to the radio frequency power amplifier. Thus, the $V_{CC}$ look up table index signal 2584 provides an emulated "Pin drive level of the power amplifier" rather using as index the output power of the radio frequency power amplifier 2540 to generate the control signal 2508.

Because the gain control, $G_{CONTROL}$, provided by the pseudo-envelope follower gain controller 2574 compensates for changes in the transmit gain setting used to set the power level of the modulated radio frequency input signal 2504, the $V_{CC}$ look up table index signal 2584 may index into the $V_{CC}$ look up table 2586 to generate a $V_{CC}$ look up table compensated envelope signal 2588 that is adjusted for a change in the transmit-gain setting signal 2526A used to set the power level of the modulated radio frequency input signal 2504 provided to the radio frequency power amplifier 2540.

The AM/PM compensation circuit 2573 may compensate for any phase shift due to the drive level change in of the modulated radio frequency input signal 2504 provided to the radio frequency power amplifier 2540.

In some embodiments, the AM/PM compensation circuit 2573 may receive either the $V_{CC}$ look up table index signal 2584 or the $V_{CC}$ look up table compensated envelope signal 2588 as a scaled version of the digital envelope of the modulated radio frequency input signal 2504. In other words, the AM/PM compensation circuit 2573 may use either the $V_{CC}$ look up table index signal 2584, the $V_{CC}$ look up table compensated envelope signal 2588, and/or a combination thereof to represent the modulated radio frequency input signal 2504. Based on the representation of the modulated radio frequency input signal 2504, the AM/PM compensation circuit 2573 may calculate a phase correction as a function of the input power $P_{IN}$. The AM/PM compensation circuit 2573 may apply the phase correction to generate a phase corrected digital in-phase component $I_{DIGITAL}$ 2573I and a phase corrected digital in-phase component $I\text{-}_{DIGITAL}$ 2527Q, which are provide to the digital gain control circuit 2576. In response to the phase corrected digital in-phase component $I_{DIGITAL}$ 2573I and the phase corrected digital in-phase component $I_{DIGITAL}$ 2527Q, the digital gain control circuit 2576 may generate a gain adjusted digital in-phase, $I_{DIGITAL\text{-}\text{-}GAIN\_ADJUSTED}$, component and the gain adjusted digital quadrature, $Q_{DIGITAL\_GAIN\_ADJUSTED}$, component based on the transmit-gain setting parameter 2502B.

The envelope tracking digital/analog section 2580 may include the pseudo-envelope follower gain controller 2574, a multiplier 2582, the $V_{CC}$ look up table 2586, a fine tuning delay circuit 2590, a digital pre-distortion compensation filter 2594, a differential digital-to-analog converter 2598, and a fixed delay circuit 2600. The multiplier 2582 may include a first input in communication with the output of the pseudo-envelope follower gain controller 2574 and a second input in communication with the envelope magnitude calculation circuit 2578. The first input of the multiplier 2582 may receive the gain control, $G_{CONTROL}$, from the pseudo-envelope follower gain controller 2574. The second input of the multiplier 2582 may receive the envelope magnitude, $\zeta_{MAGNITUDE}$. The multiplier 2582 multiplies the envelope magnitude, $\zeta_{MAGNITUDE}$, by the gain control, $G_{CONTROL}$, to generate the $V_{CC}$ look up table index signal 2584. In some embodiments, the gain control, $G_{CONTROL}$, is adjusted to compensate for variations in a setup of the digital baseband circuit 2510. For example, the value of the gain control, $G_{CONTROL}$, may be adjusted to increase or decrease the modulated power supply voltage, $V_{CC}$, generated by the envelope tracking power converter system 2530 as a function of the input power $P_{IN}$ or drive level of the modulated radio frequency input signal 2504 provided to the radio frequency power amplifier 2540.

The multiplier 2582 provides a $V_{CC}$ look up table index signal 2584 to the $V_{CC}$ look up table 2586 based on the product of the envelope magnitude, $\zeta_{MAGNITUDE}$, and the gain control, $G_{CONTROL}$.

The $V_{CC}$ look up table 2586 may include one or more tables to translate the $V_{CC}$ look up table index signal 2584 into a $V_{CC}$ look up table compensated envelope signal 2588. The $V_{CC}$ look up table compensated envelope signal 2588 may provide a target voltage for the modulated power supply voltage, $V_{CC}$, to be generated by the envelope tracking power converter system 2530 based on the envelope of the modulated radio frequency input signal 2504. For example, depending upon a band of operation, a power level modulation mode of operation of the communication device, a spectrum target, and/or an error vector magnitude target, the baseband controller 2511 or the controller 50 may configure the $V_{CC}$ look up table 2586 to select a particular set of look up values as a function of an operational mode of the communication device, the digital baseband circuit 2510, the envelope tracking power converter system 2530, the envelope tracking digital/analog section 2580, and/or a combination thereof. The $V_{CC}$ look up table 2586 provides a $V_{CC}$ look up table compensated envelope signal 2588 to the fine tuning delay circuit 2590.

The fine tuning delay circuit 2590 may be configured to delay propagation of the $V_{CC}$ look up table compensated envelope signal 2588 based on a programmable delay parameter. The programmable delay parameter may be controlled by the controller 50 the baseband controller 2511 and/or a combination thereof. Depending upon the programmable delay parameter, the fine tuning delay circuit 2590 may provide a delay propagation of the $V_{CC}$ look up table compensated envelope signal 2588 based on a programmable delay parameter by a fine tuning delay time, $T_{FINE\_TUNING}$. The granularity of the fine tuning delay time, $T_{FINE\_TUNING}$, may depend upon a clock of the digital baseband circuit 2510. In some embodiments, the propagation delay of the fine tuning delay circuit 2590 may be provided by an interpolator. In other embodiments, the propagation delay of the fine tuning delay circuit 2590 may be provided by a tapped delay line or other delay circuit. The fine tuning delay circuit 2590 provides a digitally delayed control signal without pre-distortion compensation 84 to the digital pre-distortion compensation filter 2594. The digitally delayed control signal without pre-distortion compensation 84 may be provided to the digital pre-distortion compensation filter 2594.

The digital pre-distortion compensation filter 2594 may be either an infinite impulse response filter (IIR) or a finite impulse response filter (FIR). In some embodiments, the coefficients of the digital pre-distortion compensation filter 2594 may be configured by the controller 50, baseband controller 2511 and/or a combination thereof. In addition, the propagation delay through the digital pre-distortion compensation filter 2594 may vary depending upon the various modes of operation of the communication device.

For example, the propagation delay through the digital pre-distortion compensation filter 2594 may depend on various factors including a band of operation, a channel bandwidth, a wideband modulation bandwidth, channel conditions, a location of the communication device relative to communication hubs, points, towers, and hot-spots, signal modulation techniques, expected envelope characteristics, the peak-to-average ratio of the envelope of the signal to be transmitted, the data rate, the bandwidth of the channel, error vector magnitude, desired transmit spectrum characteristics, and/or some combination thereof.

As an example application, the digital pre-distortion compensation filter 2594 may be configured to equalize the frequency response of the modulated power supply voltage, $V_{CC}$, relative to the differential $V_{RAMP}$ signal. The digital pre-distortion compensation filter 2594 may provide a digital control signal 2596 to the differential digital-to-analog converter 2598. In some embodiments, the digital control signal 2596 may be a digital $V_{RAMP}$ signal, $V_{RAMP\_DIGITAL}$. The differential digital-to-analog converter 2598 may convert the digital control signal 2596 into the control signal 2508. In some embodiments, the control signal 2508 may be a differential control signal. For example, as described above, the control signal 2508 may include the non-inverted control signal component 2508A and the inverted control signal component 2508B. In some embodiments, the non-inverted control signal component 2508A may be the non-inverted $V_{RAMP}$ signal component, $V_{RAMP}+$, and the inverted control signal component 2508B may be the inverted $V_{RAMP}$ signal component, $V_{RAMP}-$. Although not depicted in Figure 16, the differential digital-to-analog converter 2598 may further include anti-aliasing filters to accomplish proper image rejection after converting digital data into an analog signal.

The fixed delay circuit 2600 may provide a fixed delay to offset the propagation delay of the of the envelope magnitude, $\zeta_{MAGNITUDE}$, signal through the envelope tracking digital/analog section 2580 and provide a range of delay for the fine tuning delay circuit 2590. The fixed delay circuit 2600 receives the gain adjusted digital in-phase, $I_{DIGITAL\_GAIN\_ADJUSTED}$, component and the gain adjusted digital quadrature, $Q_{DIGITAL\_GAIN\_ADJUSTED}$, component from the digital gain control circuit 2576. The fixed delay circuit 2600 provides a delay adjusted digital in-phase component 2604 and a delay adjusted quadrature component 2618 as outputs.

A first digital-to-analog converter circuit 2606 is configured to receive the delay adjusted digital in-phase component 2604. The first digital-to-analog converter circuit 2606 converts the delay adjusted digital in-phase component 2604 into an analog signal to generate a pre-reconstruction in-phase component 2608, which is provided to a first anti-aliasing filter 2610. The first anti-aliasing filter 2610 filters the pre-reconstruction in-phase component 2608 to provide an analog in-phase component 2612 to be mixed.

Similarly, a second digital-to-analog converter circuit 2620 may receive the delay adjusted quadrature component 2618. The second digital-to-analog converter circuit 2620 converts the delay adjusted quadrature component 2618 into a pre-reconstruction quadrature component 2622, which is provided to a second anti-aliasing filter 2624. The second anti-aliasing filter 2624 filters the pre-reconstruction quadrature component 2622 to provide an analog quadrature component 2626 to be mixed.

The digital baseband circuit 2510 may further include an oscillator 2558, an in-phase component mixer 2614, I-Mixer, and a quadrature component mixer 2628, Q-Mixer. The oscillator 2558 is configured to generate a carrier signal 2558A having a transmit carrier frequency for a band of operation, which is provided to the quadrature component mixer 2628, Q-Mixer, and the in-phase component mixer 2614, I-Mixer. The quadrature component mixer 2628, Q-Mixer, mixes the analog quadrature component 2626 to generate a modulated quadrature component 2630. The in-phase component mixer 2614, I-Mixer, mixes the analog in-phase component 2612 to generate a modulated in-phase component 2616. The modulated quadrature component 2630 and the modulated in-phase component 2616 are provided to a radio frequency attenuator 2632. The controller 50 may adjust the radio frequency attenuator 2632 to provide a magnitude of the modulated quadrature component 2630 and the modulated in-phase component 2616 used to provide the modulated radio frequency input signal 2504 having an input power $P_{IN}$ to the radio frequency power amplifier 2540. The radio frequency attenuator 2632 may be either a digital radio frequency attenuator or an analog radio frequency attenuator.

The fine tuning delay time, $T_{FINE\_TUNING}$, of the fine tuning delay circuit 2590 may be configured to adjust the group delay relationship between the control signal 2508 provided to the envelope tracking power converter system 2530 and the modulated radio frequency input signal 2504, $P_{IN}$, provided to the radio frequency power amplifier 2540. The output power of the amplified radio frequency output signal 2548 may depend on the relative group delay mismatch between the control signal 2508 and the modulated radio frequency input signal 2504, $P_{IN}$.

Figure 16 depicts a more detailed view of the digital baseband circuit 2510 including the baseband controller 2511, the transceiver circuitry 2512, and the configuration-feedback circuitry 2520. Although Figure 16 depicts that the transceiver circuitry 2512 and the configuration-feedback circuitry 2520 are substantially separate portions of the digital baseband circuit 2510, in some embodiments, the features and the functions of the transceiver circuitry 2512 and the configuration-feedback circuitry 2520 may be cooperatively shared.

Figure 16 further depicts an I/Q feedback system 2522 having a buffer 2552 configured to receive the measured amplified radio frequency output signal 2550 from the power coupler 2546. The buffer 2552 provides the measured amplified radio frequency output signal 2550 to the in-phase component feedback mixer 2554 and the quadrature component feedback mixer 2556. The in-phase component feedback mixer 2554 and the quadrature component feedback mixer 2556 may receive a carrier signal 2558A having a transmit carrier frequency from an oscillator 2558. The in-phase component feedback mixer 2554 and the quadrature component feedback mixer 2556 may demodulate the measured amplified radio frequency output signal 2550 to recover an in-phase feedback component 2562 and a quadrature feedback component 2564. The in-phase component feedback mixer 2554 may provide the in-phase feedback component 2562 to an in-phase component analog-to-digital converter 2566 to generate a digitized in-phase feedback component $I_{MEASURED}$ 2570. The quadrature component feedback mixer 2556 may provide the quadrature feedback component 2564 to a quadrature component analog-to-digital converter 2568 to generate a digitized quadrature feedback component $Q_{MEASURED}$ 2572. The fast calibration iso-gain and delay alignment circuitry 2524 and the transceiver power control loop circuitry 2526 may each receive the digitized in-phase feedback component $I_{MEASURED}$ 2570 and the digitized quadrature feedback component $Q_{MEASURED}$ 2572.

As a non-limiting example, the $V_{CC}$ look up table 2586 may store a plurality of calibrated iso-gain contours. The iso-gain contours may be calibrated by measuring the relationship between a range of drive levels or input power $P_{IN}$ levels of a modulated radio frequency input signal 2504 versus an output power $P_{OUT}$ generated by the radio frequency power amplifier 2540 at a given modulated power supply voltage, $V_{CC}$. For example, in the simplest form, the input power $P_{IN}$ for a modulated radio frequency input signal 2504 may sweep through 27dBn to + 7 dbm at a given modulated power supply voltage, $V_{CC}$. The fast calibration iso-gain and delay alignment circuitry 2524 may determine the output power generated in response to the input power $P_{IN}$ level. The process may then be repeated for different magnitudes of the modulated power supply voltage, $V_{CC}$.

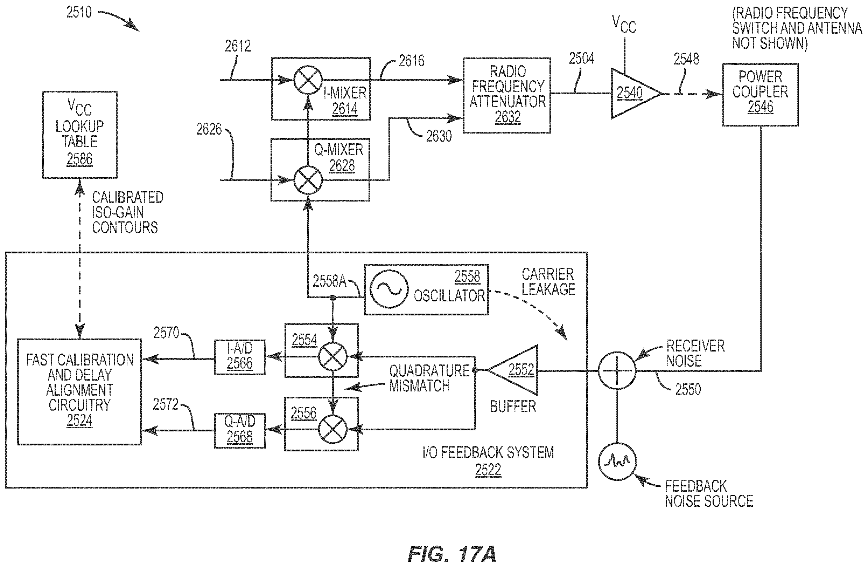

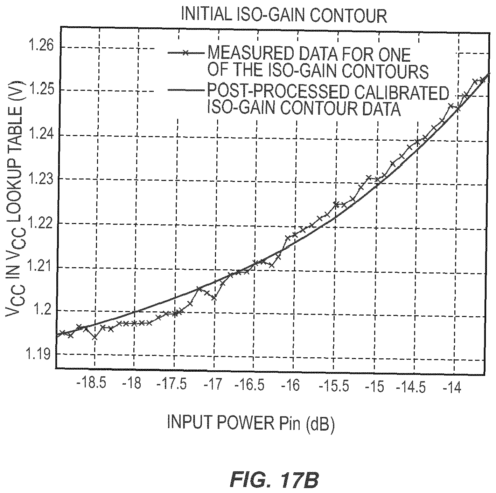

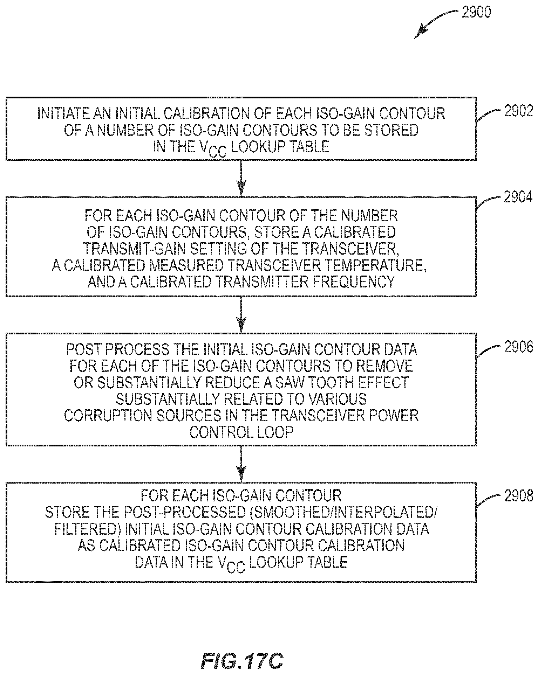

As depicted in the Figure 17B, the measured data for the iso-gain contours may have a saw tooth characteristic. As depicted in Figure 17A, the saw tooth effect may be due in part to various corruption sources that affect the accuracy of calibration including feedback noise sources that impact the measured amplified radio frequency output signal 2550, carrier leakage from the oscillator 2558, quadrature mismatch between the in-phase component feedback mixer 2554 and the quadrature component feedback mixer 2556, and/or some combination thereof. To correct for the saw tooth effect, as depicted in Figure 17B and described in 17C, the initial measured data may be post-processed either by the controller 50, the baseband controller 2511, or factor test equipment to remove or minimize the impact of the corruption sources. For example, Figure 17C depicts a method 2900 for reducing a saw tooth effect.

At the factor, an initial calibration of each iso-gain contour of a number of iso-gain contours to be stored in the $V_{CC}$ lookup table 2586 may be initiated. (Step 2902.)

For each iso-gain contour of the number of iso-gain contours, the fast calibration iso-gain and delay alignment circuitry 2524 may store a calibrated transmit-gain setting of the transceiver circuitry 2512, a calibrated measured transceiver temperature, and a calibrated transmitter frequency. (Step 2904.)

Thereafter, one of the controller 50, the baseband controller 2511, fast calibration iso-gain and delay alignment circuitry 2524, and/or factor test equipment may post process the initial iso-gain contour data for each of the iso-gain contours to remove or substantially reduce a saw tooth effect substantially related to various corruption sources in the transceiver power control loop 2502. As an example, a fit-post processing algorithm may be applied to the initial iso-gain contour data to remove the overall saw tooth effect and recalculate discrete points for the $V_{CC}$ look up table 2586 based on an interpolation process. As an example, the controller 50 or a factory calibration computer may execute the fit-processing and then recalculate the new discrete point to define the iso-gain curves. For example, in some embodiments, N data point may be used to generate an $M^{th}$ order polynomial that provides a polyfit with respect to the initial iso-gain contour data. Other advance filtering techniques may also be applied to remove the saw tooth effect and provide clean post processed calibrated iso-gain contour data. (Step 2906).

For each iso-gain contour, one of the controller 50, the baseband controller 2511, fast calibration iso-gain and delay alignment circuitry 2524, and/or factor test equipment may the store the post-processed (smoothed/interpolated/filtered) initial iso-gain contour calibration data as calibrated iso-gain contour calibration data in the $V_{CC}$ look up table 2586. (Step 2908).

In response to receipt of the in-phase feedback component 2562, the in-phase component analog-to-digital converter 2566 provides the digitized in-phase feedback component $I_{MEASURED}$ 2570 to the fast calibration iso-gain and delay alignment circuitry 2524 and the transceiver power control loop circuitry 2526. Similarly, the quadrature component feedback mixer 2556 provides a quadrature feedback component 2564 to the quadrature component analog-to-digital converter 2568. In response, the quadrature component analog-to-digital converter 2568 provides the digitized quadrature feedback component $Q_{MEASURED}$ 2572 to both the fast calibration iso-gain and delay alignment circuitry 2524 and the transceiver power control loop circuitry 2526.

The transceiver power control loop circuitry 2526 may determine a measured output power, $P_{OUT-MEASURED}$,

generated by the radio frequency power amplifier 2540 in response to the modulated radio frequency input signal 2504 having an input power $P_{IN}$ and the control signal 2508. For example, the transceiver power control loop circuitry 2526 may calculate the measured output power, $P_{OUT\_MEASURED}$, as a function of the digitized in-phase feedback component $I_{MEASURED}$ 2570 and the digitized quadrature feedback component $Q_{MEASURED}$ 2572. Based on the measured output power, $P_{OUT\_MEASURED}$, and the transmit-target power setting parameter 2502A, the transceiver power control loop circuitry 2526 may generate a transmit-gain setting signal 2526A to minimize a difference between the measured output power, $P_{OUT\_MEASURED}$, and the transmit-target power setting parameter 2502A. The transceiver power control loop circuitry 2526 may also provide the transmit-gain setting signal 2526A to a baseband controller 2511. In addition, in some embodiments, transceiver power control loop circuitry 2526 may provide the measured output power, $P_{OUT\_MEASURED}$, to the controller 50 via the control bus 44. In this case, the baseband controller 2511 may provide the transmit-target power setting parameter 2502A to the transceiver power control loop circuitry 2526. In some embodiments, the pseudo-envelope follower gain control circuit 2574 may receive an indication of the transmit-gain setting parameter 2502B of the transceiver from the configuration-feedback circuitry 2520 via the transmit-gain setting signal 2526A.

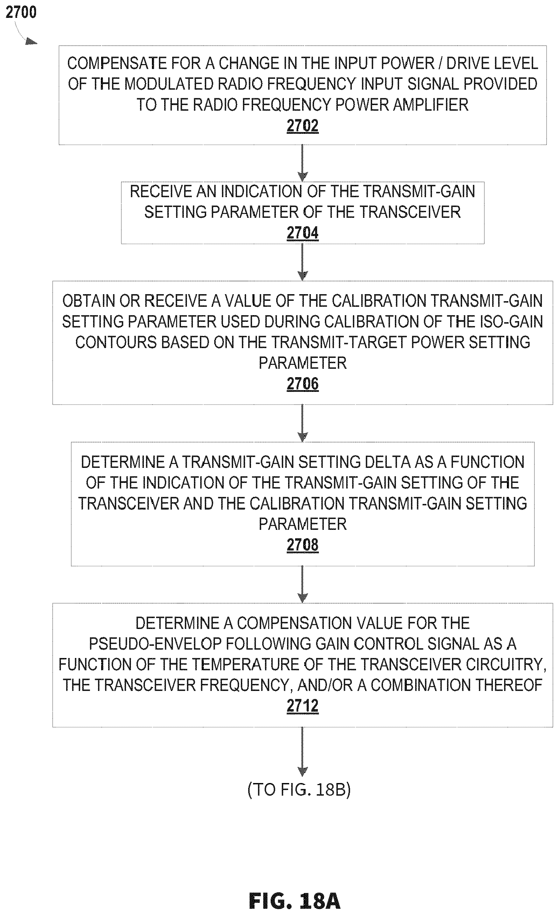

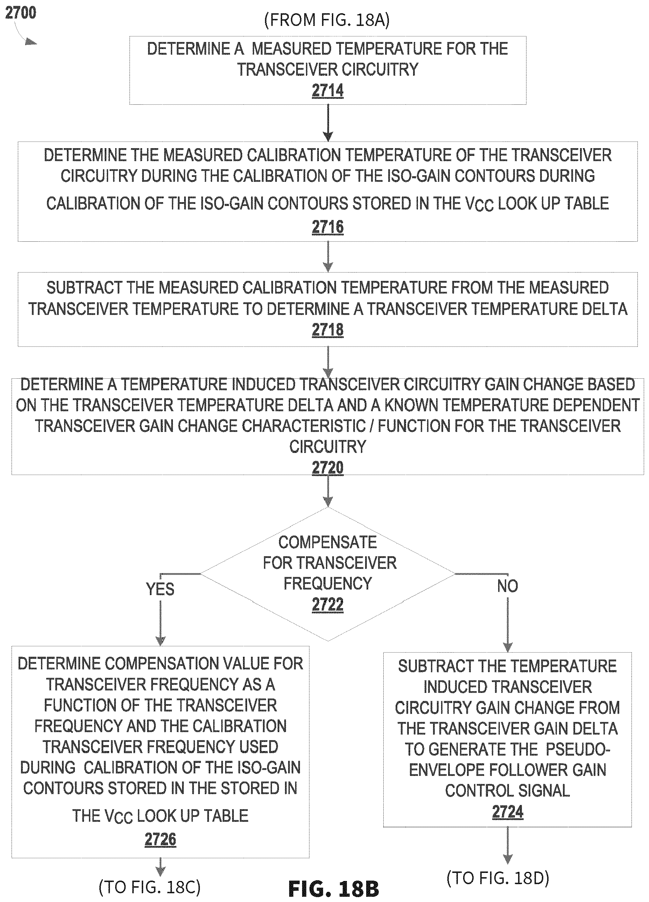

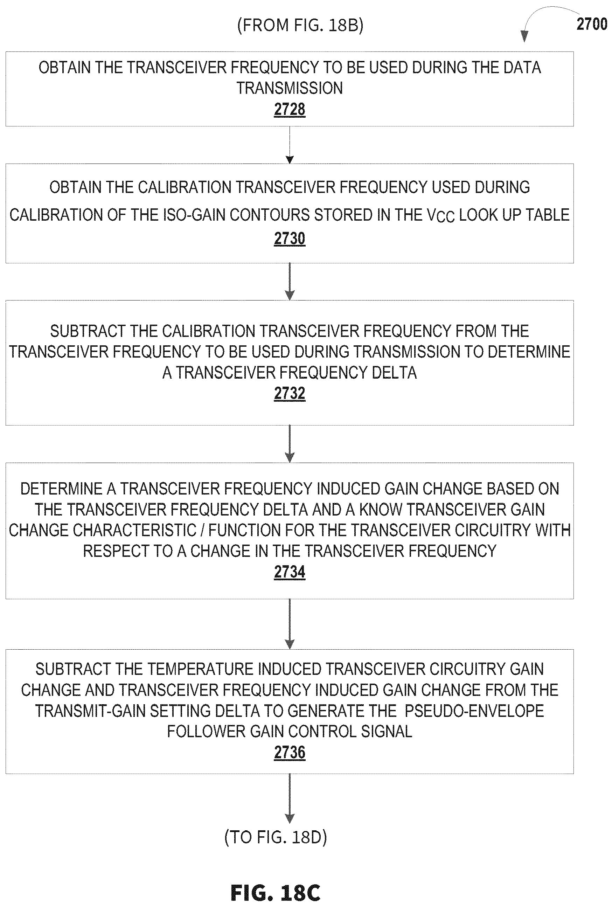

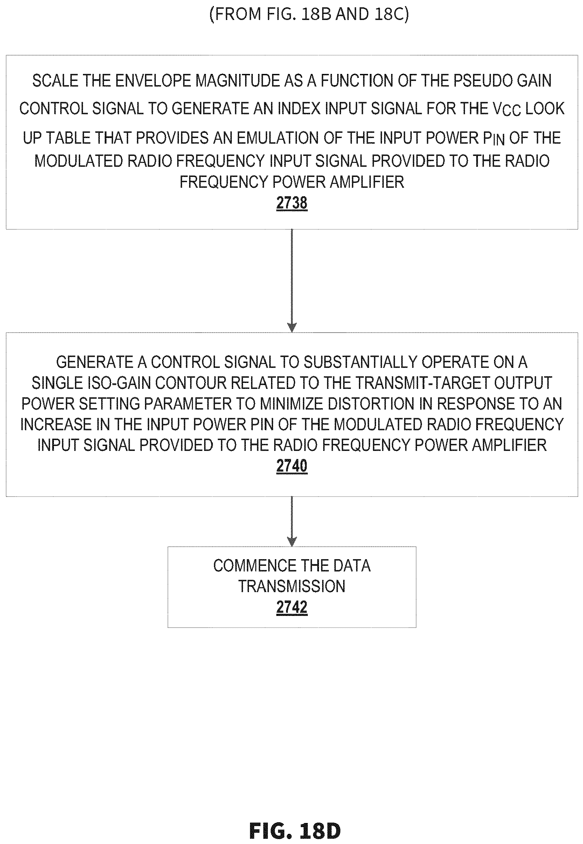

Figures 18A-D depict a method 2700 for compensating a control signal generated as part of an envelope tracking system for changes in the drive level or input power $P_{IN}$ of a modulated radio frequency input signal 2504. The digital baseband circuit 2510 may provide the modulated radio frequency input signal 2504 to the radio frequency power amplifier 2540 to generate the amplified radio frequency output signal 2548. The radio frequency power amplifier 2540 may provide the amplified radio frequency output signal 2548 to the antenna 2544 for transmission. As previously discussed, the transceiver power control loop 2502 may adjust the drive level or input power $P_{IN}$ of the modulated radio frequency input signal 2504 in response a determination that the output power $P_{OUT}$ of the amplified radio frequency output signal 2548, measured at the antenna 2544, outside a threshold limit of a target-transmit output power parameter. For example, the configuration-feedback circuitry 2520

may determine whether an output power of a radio frequency power amplifier is outside of a threshold limit of a target-transmit output power parameter. Based on a determination that the output power of the radio frequency power amplifier is outside of the threshold limit of the target-transmit output power parameter, a transceiver circuit configured to generate a modulated radio frequency input signal based on a difference between the output power of the radio frequency power amplifier and the target-transmit output power parameter, and generate a control signal to regulate generation of a modulated supply voltage to maintain a linear gain characteristic of the radio frequency power amplifier through a new dynamic range of the modulated radio frequency input signal.

The envelope tracking control system 2530 may be configured to compensate for a change in the input power $P_{IN}$ or drive level of the modulated radio frequency input signal provided to the radio frequency power amplifier 2540. (Step 2702). As an example, the pseudo-envelope follower gain controller 2574 may receive an indication of the transmit-gain setting parameter of the transceiver circuit and the configuration-feedback circuitry 2520 via the transmit-gain setting signal 2526A. In addition the pseudo-envelope follower gain controller 2574 may receive an indication of the transmit-target power setting parameter 2502A from the configuration-feedback circuitry 2520 via the transmit-target power setting signal 2526B. (Step 2704).

In response to receipt of the indication of the transmit-gain setting parameter, the pseudo-envelope follower gain controller 2574 may obtain or receive a value of the calibration transmit-gain setting parameter used during calibration of the iso-gain contours based on the transmit-target power setting parameter. (Step 2706.)

The pseudo-envelope follower gain controller 2574 may determine a transmit gain setting delta as a function of the indication of the transmit-gain setting of the transceiver and the calibration transmit-gain setting parameter. The transmit gain setting delta may be calculated by subtracting the calibration transmit-gain setting parameter from the transmit-gain setting parameter. (Step 2708).

The pseudo-envelope follower gain controller 2574 may determine a compensation value for the pseudo-envelope following gain control signal as a function of the temperature of the transceiver circuitry 2512, the transceiver frequency, and/or a combination thereof (Step 2712.)

The pseudo-envelope follower gain controller 2574 may determine a measured temperature for the transceiver circuitry 2512. To determine a compensation value for the pseudo-envelope following gain control signal 2574A, the pseudo-envelope follower gain controller 2574 may receive a measured temperature for the transceiver circuitry 2512 from the temperature sensor 2516 via the temperature signal 2516A. (Step 2714.)

The pseudo-envelope follower gain controller 2574 may determine the measured calibration temperature of the transceiver circuitry 2512 during the calibration of the iso-gain contours during calibration of the iso-gain contours stored in the $V_{CC}$ look up table 2586. As an example, in some embodiments, the baseband controller 2511 may obtain or receive the measured calibration temperature of the transceiver circuitry 2512 from the controller 50. Alternatively, the measured calibration temperature of the transceiver circuitry 2512 may be stored in a memory or register accessible by the baseband controller 2511. In some embodiments, the controller 50 may provide the measured calibration temperature of the transceiver circuitry 2512 to the pseudo-envelope follower gain controller 2574. In still other embodiments, the pseudo-envelope follower gain controller 2574 may request the measured calibration temperature of the transceiver circuitry 2512 from the baseband controller 2511 or the controller 50. In still other embodiments, the measured calibration temperature of the transceiver circuitry 2512 may be provided to the pseudo-envelope follower gain controller 2574 prior to commencement of a data transmission. (Step 2716.)

The pseudo-envelope follower gain controller 2574 may subtract the measured calibration temperature from the measured transceiver temperature to determine a transceiver temperature delta. (Step 2718.)

Thereafter, the pseudo-envelope follower gain controller 2574 may determine a temperature induced transceiver circuitry gain change based on the transceiver temperature delta and a known temperature dependent transceiver gain change characteristic / function for the transceiver circuitry 2512. (Step 2720.)

In some embodiments of the envelope tracking control system 2503, the pseudo-envelope follower gain controller 2574 may further compensate the transceiver frequency being used to generate the modulated radio frequency input signal 2504. In other embodiments, the envelope tracking control system 2503 may determine whether to compensate for the transceiver frequency. For example, the envelope tracking control system 2503 may determine whether the present transceiver frequency is substantially near a calibration transceiver frequency used during calibration of the iso-gain contours stored in the $V_{CC}$ look up table 2586. Based on a determination that the present transceiver frequency is substantially near the calibration transceiver frequency, the pseudo-envelope follower gain controller 2574 may determine to dispense with determining a compensation factor for a difference between the present transceiver frequency and the calibration transceiver frequency. In other embodiments, the pseudo-envelope follower gain controller 2574 may always generate a compensation factor for a difference between the present transceiver frequency and the calibration transceiver frequency. (Step 2722.)

Based on a determination to not generate a compensation factor for a difference between the present transceiver frequency and the calibration transceiver frequency, the pseudo-envelope follower gain controller 2574 may subtract the temperature induced transceiver circuitry gain change from the transceiver gain delta to generate the pseudo-envelope follower gain control signal. (Step 2724.)

Otherwise, based on a determination to generate a compensation factor for a difference between the present transceiver frequency and the calibration transceiver frequency, the pseudo-envelope follower gain controller 2574 may determine compensation value for transceiver frequency as a function of the transceiver frequency and the calibration transceiver frequency used during calibration of the iso-gain contours stored in the stored in the $V_{CC}$ look up table 2586. (Step 2726.)

The pseudo-envelope follower gain controller 2574 may obtain the transceiver frequency to be used during the data transmission. For example, in some embodiments, the pseudo-envelope follower gain controller 2574 may obtain or receive the transceiver frequency to be used during the data transmission from the baseband controller 2511, the controller 50, or the digital baseband circuit 2510. For example, the transceiver frequency may be based on the band of operation of the communication device. The controller 50 or the baseband controller 2511 may configure the oscillator 2558 to generate a carrier signal 2558A having a transceiver frequency substantially equal to the transceiver frequency to be used during the data transmission. (Step 2728.)

The pseudo-envelope follower gain controller 2574 may obtain the calibration transceiver frequency used during calibration of the iso-gain contours stored in the $V_{CC}$ look up table 2586. For example, the pseudo-envelope follower gain controller 2574 may obtain or receive the calibration transceiver frequency used during calibration of the iso-gain contours from the controller 50, the baseband controller 2511, or from a memory local to the digital baseband circuit 2510. In some embodiments, the pseudo-envelope follower gain controller 2574 may receive the calibration transceiver frequency used during calibration of the iso-gain contours prior to initiation of a data transmission. (Step 2730.) The pseudo-envelope follower gain controller 2574 may subtract the calibration transceiver frequency from the transceiver frequency to be used during transmission to determine a transceiver frequency delta. (Step 2732.)

Thereafter, the pseudo-envelope follower gain controller 2574 may determine a transceiver frequency induced gain change based on the transceiver frequency delta and a known transceiver gain change characteristic / function for the transceiver circuitry with respect to a change in the transceiver frequency. (Step 2734.) The pseudo-envelope follower gain controller 2574 may subtract the temperature induced transceiver circuitry gain change and the transceiver frequency induced gain change from the transmit-gain setting delta to generate the pseudo-envelope follower gain control signal. (Step 2736.)

The pseudo-envelope follower gain controller 2574 may scale the envelope magnitude as a function of the pseudo gain control signal to generate an index input signal for the $V_{CC}$ look up table 2586 that provides an emulation of the input power $P_{IN}$ of the modulated radio frequency input signal provided to the radio frequency power amplifier. (Step 2738.)

The pseudo-envelope follower gain controller 2574 may generate a control signal to substantially operate on a single iso-gain contour related to the transmit-target output power setting parameter to minimize distortion in response to an increase in the input power $P_{IN}$ of the modulated radio frequency input signal provided to the radio frequency power amplifier (Step 2740). Thereafter, the digital baseband circuit 2510 may commence the data transmission. (Step 2742.)

Those skilled in the art will recognize improvements and modifications to the embodiments of the present disclosure. All such improvements and modifications are considered within the scope of the concepts disclosed herein and the claims that follow.

**Claims**

1. Circuitry comprising:

   configuration-feedback circuitry (2520) configured to regulate an output power ($P_{OUT}$) from a radio frequency power amplifier (2540) based on a difference between a target output power from the radio frequency power amplifier (2540) and a measured output power from the radio frequency power amplifier (2540); and
   transceiver circuitry (2512) configured to regulate a modulated power supply voltage ($V_{CC}$), which is used by the radio frequency power amplifier (2540) to provide power for amplification, based on the difference between the target output power from the radio frequency power amplifier (2540) and the measured output power from the radio frequency power amplifier (2540);
   wherein:

   the transceiver circuitry (2512) is further configured to provide a modulated radio frequency input signal (2504) to the radio frequency power amplifier (2540);
   the transceiver circuitry (2512) comprises a $V_{CC}$ look up table (2586);
   the modulated power supply voltage ($V_{CC}$) is based on the $V_{CC}$ look up table (2586); and
   a $V_{CC}$ look up table index signal (2584) is configured to provide an index signal into the $V_{CC}$ look up table (2586) that substantially emulates an input power ($P_{IN}$) of the modulated radio frequency input signal (2504).

2. The circuitry of claim 1 wherein the configuration-feedback circuitry (2520) is further configured to:

   receive a measured amplified radio frequency output signal (2550);
   provide a transmit-target power setting signal (2526B), which is based on a transmit-target power setting parameter; and
   provide a transmit-gain setting signal (2526A), which is based on a transmit-gain setting parameter.

3. The circuitry of claim 2 wherein:

   • the transmit-target power setting parameter is representative of the target output power from the radio frequency power amplifier (2540); and
   • the transmit-gain setting parameter is representative of a transmit-gain setting of the transceiver circuitry (2512).

4. The circuitry of claim 2 wherein the transceiver circuitry (2512) is further configured to provide and adjust an input power ($P_{IN}$) of a modulated radio frequency input signal (2504) to the radio frequency power amplifier (2540) based on the transmit-target power setting parameter and the transmit-gain setting parameter.

5. The circuitry of claim 2 wherein the transceiver circuitry (2512) is further configured to adjust the transmit-gain setting parameter in response to temperature changes of the transceiver circuitry (2512).

6. The circuitry of claim 2 wherein the transceiver circuitry (2512) is further configured to adjust the transmit-gain setting parameter in response to changes in a voltage standing wave ratio (VSWR) associated with the radio frequency power amplifier (2540).

7. The circuitry of claim 2 wherein the transceiver circuitry (2512) is further configured to adjust the transmit-gain setting parameter in response to changes in a transmit frequency of the radio frequency power amplifier (2540).

8. The circuitry of claim 2 wherein the transceiver circuitry (2512) is further configured to adjust the transmit-gain setting parameter in response to changes in a transmit frequency of the radio frequency power amplifier (2540) and to temperature changes of the transceiver circuitry (2512).

9. The circuitry of claim 2 wherein the transceiver circuitry (2512) is further configured to adjust the transmit-gain setting parameter in response to changes in a transmit frequency of the radio frequency power amplifier (2540) and to changes in a voltage standing wave ratio (VSWR) associated with the radio frequency power amplifier (2540).

**10.** The circuitry of claim 1 wherein:

the transceiver circuitry (2512) is further configured to provide a modulated radio frequency input signal (2504) having an input power ($P_{IN}$) to the radio frequency power amplifier (2540);

the radio frequency power amplifier (2540) is configured to generate an amplified radio frequency output signal (2548) based on the input power ($P_{IN}$) of the modulated radio frequency input signal (2504) and the modulated power supply voltage ($V_{CC}$);

the measured output power from the radio frequency power amplifier (2540) is representative of the output power ($P_{OUT}$) from the radio frequency power amplifier (2540); and

a measured amplified radio frequency output signal (2550) is representative of the measured output power from the radio frequency power amplifier (2540).

**11.** The circuitry of claim 1 further comprising an envelope tracking power converter system (2530) configured to provide the modulated power supply voltage ($V_{CC}$) based on a control signal (2508), which is provided by the transceiver circuitry (2512).

**12.** The circuitry of claim 11 wherein the envelope tracking power converter system (2530) comprises a parallel amplifier circuit (874) and a switch mode power supply converter (872), which is configured to cooperatively operate with the parallel amplifier circuit (874).

**13.** The circuitry of claim 12 wherein the parallel amplifier circuit (874) is configured to regulate the modulated power supply voltage ($V_{CC}$) based on the control signal (2508).

**14.** The circuitry of claim 12 wherein the envelope tracking power converter system (2530) further comprises a coupling capacitor (18A) coupled between the parallel amplifier circuit (874) and the switch mode power supply converter (872).

**15.** The circuitry of claim 14 wherein the switch mode power supply converter (872) is further configured to regulate an offset voltage ($V_{OFFSET}$) across the coupling capacitor (18A).

*FIG. 1A*

FIG. 1B

EP 3 499 715 A1

**FIG. 2A**

FIG. 2B

FIG. 2C

FIG. 2D

EP 3 499 715 A1

**FIG. 2E**

EQUIVALENT CIRCUIT FOR LOW POWER MODULATION MODE

FIG. 3

1300

DETERMINE AN EXPECTED OUTPUT
POWER TO BE GENERATED BY A RADIO
FREQUENCY POWER AMPLIFIER
DURING A DATA TRANSMISSION
1302

EXPECTED
OUTPUT POWER
≥ HIGH POWER
MODULATION MODE
THRESHOLD

BASED ON THE EXPECTED OUTPUT POWER
TO BE GENERATED BY THE RADIO
FREQUENCY POWER AMPLIFIER
DURING THE DATA TRANSMISSION,
SELECT A POWER MODULATION MODE
1304

EXPECTED
OUTPUT POWER
≤ LOW POWER
MODULATION
MODE
THRESHOLD

HIGH POWER
MODULATION
MODE
THRESHOLD    >    EXPECTED
OUTPUT
POWER    >    LOW POWER
MODULATION
MODE
THRESHOLD

CONFIGURE PSEUDO-
ENVELOPE FOLLOWER
POWER MANAGEMENT
SYSTEM TO OPERATE
IN A HIGH POWER
MODULATION MODE
1306

CONFIGURE PSEUDO-
ENVELOPE FOLLOWER
POWER MANAGEMENT
SYSTEM TO OPERATE
IN MEDIUM POWER
MODULATION MODE
1308

CONFIGURE PSEUDO-
ENVELOPE FOLLOWER
POWER MANAGEMENT
SYSTEM TO OPERATE
IN LOW POWER
MODULATION MODE
1310

TO FIG. 5A

TO FIG. 6A

TO FIG. 7

FIG. 4

— 1400

FROM FIG. 4

CONFIGURE A POWER MANAGEMENT SYSTEM
TO OPERATE IN A HIGH POWER MODULATION MODE — 1402

CONFIGURE A LINEAR REGULATOR OPERATION
AS A FUNCTION OF A BATTERY VOLTAGE — 1404

CONFIGURE A DIFFERENTIAL FILTER TO PREDISTORT
A DIFFERENTIAL $V_{RAMP}$ SIGNAL
TO PROVIDE A COMPENSATED
$V_{RAMP}$ SIGNAL TO THE PARALLEL AMPLIFIER
BASED ON HIGH POWER MODULATION MODE — 1406

CONFIGURE A µC CHARGE PUMP TO PROVIDE
A SUPPLY VOLTAGE TO THE PARALLEL
AMPLIFIER AS A FUNCTION
OF THE BATTERY VOLTAGE — 1408

CONFIGURE A PARALLEL AMPLIFIER OUTPUT
BYPASS SWITCH TO BE IN AN OPEN STATE — 1410

TO FIG. 5B

*FIG. 5A*

1400

FROM FIG. 5A

CONFIGURE A SWITCH MODE POWER SUPPLY
CONVERTER OPERATION AS A FUNCTION
OF AN EXPECTED HIGH OUTPUT POWER
OF A RADIO FREQUENCY POWER AMPLIFIER
(ADJUST SEGMENTATION)

1412

ADJUST SEGMENTATION OF THE PARALLEL AMPLIFIER
OUTPUT BASED ON AN EXPECTED
OUTPUT POWER OF THE RADIO FREQUENCY
POWER AMPLIFIER

1414

CONFIGURE AN ACTIVE NOISE REDUCTION CIRCUIT
FOR THE HIGH POWER MODULATION MODE

1416

CONFIGURE A $V_{OFFSET}$ LOOP CIRCUIT

1418

CONFIGURE A FEEDBACK DELAY COMPENSATION
CIRCUIT OPERATION BASED ON THE
EXPECTED HIGH OUTPUT POWER
OF THE RADIO FREQUENCY POWER AMPLIFIER

1420

TRANSMIT DATA

1422

*FIG. 5B*

1500

FROM FIG. 4

CONFIGURE THE POWER MANAGEMENT SYSTEM
TO OPERATE IN MEDIUM POWER MODULATION MODE — 1502

CONFIGURE THE LINEAR REGULATOR OPERATION
AS A FUNCTION OF A BATTERY VOLTAGE — 1504

CONFIGURE THE DIFFERENTIAL FILTER
TO PREDISTORT A DIFFERENTIAL $V_{RAMP}$ SIGNAL
TO PROVIDE A COMPENSATED $V_{RAMP}$ SIGNAL
TO THE PARALLEL AMPLIFIER BASED ON
AN EXPECTED MEDIUM OUTPUT POWER OF THE
RADIO FREQUENCY POWER AMPLIFIER — 1506

CONFIGURE THE μC CHARGE PUMP TO PROVIDE
A SUPPLY VOLTAGE TO THE PARALLEL AMPLIFIER
AS A FUNCTION OF THE BATTERY VOLTAGE — 1508

CONFIGURE THE PARALLEL AMPLIFIER OUTPUT
BYPASS SWITCH TO BE IN AN OPEN STATE — 1510

TO FIG. 6B

**FIG. 6A**

1500

FROM FIG. 6A

CONFIGURE THE SWITCH MODE POWER SUPPLY
CONVERTER OPERATION AS A FUNCTION
OF THE EXPECTED MEDIUM LEVEL OUTPUT
POWER OF A RADIO FREQUENCY POWER AMPLIFIER
(ADJUST SEGMENTATION)
— 1512

ADJUST SEGMENTATION OF THE PARALLEL AMPLIFIER
OUTPUT BASED ON THE EXPECTED MEDIUM
OUTPUT POWER OF THE RADIO FREQUENCY
POWER AMPLIFIER
— 1514

CONFIGURE THE ACTIVE NOISE REDUCTION CIRCUIT
FOR MEDIUM POWER MODULATION MODE
— 1516

CONFIGURE THE $V_{OFFSET}$ LOOP CIRCUIT OPERATION
— 1518

CONFIGURE THE FEEDBACK DELAY COMPENSATION
CIRCUIT OPERATION BASED ON EXPECTED MEDIUM
OUTPUT POWER OF THE RADIO FREQUENCY
POWER AMPLIFIER
— 1520

TRANSMIT DATA
— 1522

*FIG. 6B*

1600

FROM FIG. 4

CONFIGURE THE POWER MANAGEMENT SYSTEM TO OPERATE
IN A LOW POWER MODULATION MODE — 1602

DISABLE THE PARALLEL AMPLIFIER
(HIGH OUTPUT IMPEDANCE) — 1604

ENABLE THE PARALLEL AMPLIFIER OUTPUT BYPASS
SWITCH TO BE IN A CLOSED STATE — 1606

DISABLE THE SWITCH MODE POWER SUPPLY CONVERTER
(HIGH OUTPUT IMPEDANCE) — 1608

DISABLE THE ACTIVE NOISE REDUCTION CIRCUIT, THE
$V_{OFFSET}$ LOOP CIRCUIT, AND THE FEEDBACK
DELAY COMPENSATION CIRCUIT — 1610

CONFIGURE THE µC CHARGE PUMP TO PROVIDE THE
SUPPLY VOLTAGE TO THE LINEAR REGULATOR
BASED ON THE BATTERY VOLTAGE AND THE EXPECTED
LOW OUTPUT POWER OF THE RF POWER AMPLIFIER — 1612

SELECT A LINEAR REGULATOR MODE OF OPERATION — 1614

1616 —
CONFIGURE $V_{RAMP}$ TO PROVIDE
FIXED DC REFERENCE
(NO TRACKING MODE)

1618
CONFIGURE $V_{RAMP}$ TO PROVIDE
SLOW TRACKING MODE

1620
CONFIGURE
THE DIFFERENTIAL FILTER
BASED ON TRACKING MODE

1622
TRANSMIT DATA

*FIG. 7*

**FIG. 8A**

*FIG. 8B*

FIG. 8C

FIG. 8D

FIG. 8E

EP 3 499 715 A1

FIG. 8F

FIG. 8G

EP 3 499 715 A1

FIG. 8H

EP 3 499 715 A1

1700

DETERMINE AN EXPECTED OUTPUT POWER TO BE GENERATED
BY A RADIO FREQUENCY POWER AMPLIFIER
DURING A DATA TRANSMISSION
— 1702

EXPECTED OUTPUT POWER ≥
HIGH POWER MODULATION MODE
THRESHOLD

1704

BASED ON THE EXPECTED OUTPUT
POWER TO BE GENERATED BY THE RADIO
FREQUENCY POWER AMPLIFIER
DURING THE DATA TRANSMISSION,
SELECT A POWER MODULATION MODE

EXPECTED OUTPUT POWER <
LOW POWER AVERAGE POWER TRACKING (ATP)
MODULATION MODE THRESHOLD

HIGH POWER MODULATION
MODE  THRESHOLD >
EXPECTED OUTPUT POWER ≥
MEDIUM POWER MODULATION
MODE THRESHOLD

MEDIUM POWER MODULATION
MODE THRESHOLD > EXPECTED
OUTPUT POWER ≥ MEDIUM
POWER AVERAGE POWER
TRACKING (ATP) MODULATION
MODE THRESHOLD

1706

HIGH POWER
MODULATION MODE

1708

MEDIUM POWER
MODULATION MODE

1710

MEDIUM POWER
AVERAGE POWER
TRACKING (APT)
MODULATION MODE

1712

LOW POWER
AVERAGE POWER
TRACKING (APT)
MODULATION MODE

TO FIG. 10A

TO FIG. 11A

TO FIG. 12A

TO FIG. 13A

*FIG. 9*

1800

FROM FIG. 9

CONFIGURE A POWER MANAGEMENT SYSTEM
TO OPERATE IN HIGH POWER MODULATION MODE — 1802

DISABLE A FIRST LINEAR REGULATOR, A LOW
POWER DIFFERENTIAL TO SINGLE ENDED CONVERTER,
AND AN AVERAGE POWER TRACKING CONTROLLER — 1804

CONFIGURE SECOND LINEAR REGULATOR OPERATION
BASED ON BATTERY VOLTAGE — 1806

CONFIGURE THE PREDISTORTION CHARACTERISTICS
OF A DIFFERENTIAL FILTER FOR MAXIMUM FREQUENCY
RESPONSE COMPENSATION — 1808

CONFIGURE A SWITCH MODE POWER SUPPLY CONVERTER
BASED ON EXPECTED HIGH OUTPUT POWER OF THE
RADIO FREQUENCY POWER AMPLIFIER
TO BE TRANSMITTED (ADJUST SEGMENTATION) — 1810

ADJUST SEGMENTATION OF A PARALLEL
AMPLIFIER OUTPUT AND SET A PARALLEL
AMPLIFIER BYPASS SWITCH TO OPEN STATE — 1812

CONFIGURE A µC CHARGE PUMP OPERATION
AS A FUNCTION OF THE BATTERY VOLTAGE AND $V_{CC\_PKPK}$ — 1814

TO FIG. 10B

*FIG. 10A*

1800

```
FROM FIG. 10A
```

CONFIGURE A FIRST SIGNAL CONTROL MULTIPLEXER
TO PROVIDE THE $I_{PAWA\_OUT\_EST}$ SIGNAL
TO THE SWITCH MODE POWER SUPPLY CONVERTER — 1816

CONFIGURE A FEEDBACK DELAY COMPENSATION
CIRCUIT AND ACTIVE NOISE REDUCTION CIRCUIT
FOR THE HIGH POWER MODULATION MODE — 1818

CONFIGURE A $V_{OFFSET}$ LOOP CIRCUIT — 1820

TRANSMIT DATA — 1822

**FIG. 10B**

```
                          ╭─────────────╮              ← 1900
                          │  FROM FIG. 9 │          ↙
                          ╰──────┬──────╯
                                 │
                                 ▼
        ┌──────────────────────────────────────────────┐  ─ 1902
        │      CONFIGURE THE POWER MANAGEMENT SYSTEM     │
        │    TO OPERATE IN MEDIUM POWER MODULATION MODE  │
        └──────────────────────┬───────────────────────┘
                                 │
                                 ▼
        ┌──────────────────────────────────────────────┐  ─ 1904
        │    DISABLE THE FIRST LINEAR REGULATOR, THE LOW │
        │  POWER DIFFERENTIAL TO SINGLE ENDED CONVERTER, │
        │    AND THE AVERAGE POWER TRACKING CONTROLLER   │
        └──────────────────────┬───────────────────────┘
                                 │
                                 ▼
        ┌──────────────────────────────────────────────┐  ─ 1906
        │   CONFIGURE SECOND LINEAR REGULATOR OPERATION  │
        │        BASED ON THE BATTERY VOLTAGE            │
        └──────────────────────┬───────────────────────┘
                                 │
                                 ▼
        ┌──────────────────────────────────────────────┐  ─ 1908
        │  CONFIGURE THE PREDISTORTION CHARACTERISTICS   │
        │       OF DIFFERENTIAL FILTER FOR MEDIUM        │
        │     FREQUENCY RESPONSE COMPENSATION            │
        └──────────────────────┬───────────────────────┘
                                 │
                                 ▼
        ┌──────────────────────────────────────────────┐  ─ 1910
        │ CONFIGURE THE SWITCHING POWER SUPPLY BASED ON  │
        │   THE EXPECTED MEDIUM OUTPUT POWER OF THE      │
        │            RADIO FREQUENCY AMPLIFIER           │
        │             (ADJUST SEGMENTATION)             │
        └──────────────────────┬───────────────────────┘
                                 │
                                 ▼
        ┌──────────────────────────────────────────────┐  ─ 1912
        │      ADJUST SEGMENTATION OF THE PARALLEL       │
        │         AMPLIFIER OUTPUT AND SET THE           │
        │  PARALLEL AMPLIFIER OUTPUT BYPASS SWITCH       │
        │          TO BE IN AN OPEN STATE               │
        └──────────────────────┬───────────────────────┘
                                 │
                                 ▼
                          ╭─────────────╮
                          │  TO FIG. 11B │
                          ╰─────────────╯
```

## FIG. 11A

1900

FROM FIG. 11A

CONFIGURE THE OPERATION OF μC CHARGE PUMP AS A FUNCTION OF THE BATTERY VOLTAGE AND $V_{CC\_PKPK}$ — 1914

CONFIGURE THE CONTROL SIGNAL MUX TO PROVIDE THE $I_{PAWA\_OUT\_EST}$ SIGNAL TO THE SWITCH MODE POWER SUPPLY CONVERTER — 1916

CONFIGURE THE FEEDBACK DELAY COMPENSATION CIRCUIT AND THE ACTIVE NOISE REDUCTION CIRCUIT FOR THE MEDIUM POWER MODULATION MODE — 1918

CONFIGURE THE $V_{OFFSET}$ LOOP CIRCUIT — 1920

TRANSMIT DATA — 1922

**FIG. 11B**

FIG. 12A

2000

FROM FIG. 12A

CONFIGURE THE APT CONTROL CIRCUIT
TO CONTROL THE SWITCH MODE POWER
SUPPLY CONVERTER — 2014

SET AN APT MODE
OF OPERATIONAL MODE OF SWITCH MODE
POWER SUPPLY CONVERTER — 2016

CONFIGURE THE SWITCH MODE POWER SUPPLY
CONVERTER TO OPERATE IN THE SELECTED
APT MODE OF OPERATION — 2018

CONFIGURE THE $V_{OFFSET}$ LOOP CIRCUIT
BASED ON THE SWITCH MODE POWER SUPPLY
CONVERTER APT MODE OF OPERATION — 2020

DISABLE THE FEEDBACK DELAY COMPENSATION
CIRCUIT AND THE ACTIVE NOISE
COMPENSATION CIRCUIT — 2022

TRANSMIT DATA — 2024

*FIG. 12B*

2100

FROM FIG. 9

CONFIGURE POWER MANAGEMENT SYSTEM TO OPERATE
IN LOW POWER APT MODULATION MODE — 2102

ENABLE THE FIRST LINEAR REGULATOR
AND THE SECOND LINEAR REGULATOR — 2104

DISABLE THE PARALLEL AMPLIFIER
(HIGH IMPEDANCE) — 2106

ENABLE THE PARALLEL AMPLIFIER OUTPUT BYPASS
SWITCH TO BE IN A CLOSED STATE — 2108

DISABLE THE SWITCH MODE POWER SUPPLY CONVERTER
(HIGH IMPEDANCE) — 2110

DISABLE THE ACTIVE NOISE REDUCTION CIRCUIT, THE
$V_{OFFSET}$ LOOP CIRCUIT, AND THE FEEDBACK
DELAY COMPENSATION CIRCUIT — 2112

CONFIGURE THE µC CHARGE PUMP BASED ON THE
BATTERY VOLTAGE AND $V_{CC\_MAX}$ — 2114

DISABLE DIFFERENTIAL FILTER AND ENABLE LOW POWER
DIFFERENTIAL TO SIGNAL ENDED CONVERTER — 2116

2118 — CONFIGURE $V_{RAMP}$ TO PROVIDE
FIXED DC REFERENCE
(NO TRACKING MODE)

CONFIGURE $V_{RAMP}$ TO PROVIDE
SLOW TRACKING MODE — 2120

TRANSMIT DATA — 2122

FIG. 13

90

FIG. 14

FIG. 15

FIG. 16

FIG. 17A

EP 3 499 715 A1

FIG. 17B

2900

┌─────────────────────────────────────────────────────────────┐
│ INITIATE AN INITIAL CALIBRATION OF EACH ISO-GAIN CONTOUR      │ 2902
│ OF A NUMBER OF ISO-GAIN CONTOURS TO BE STORED                 │
│ IN THE $V_{CC}$ LOOKUP TABLE                                  │
└─────────────────────────────────────────────────────────────┘

┌─────────────────────────────────────────────────────────────┐
│ FOR EACH ISO-GAIN CONTOUR OF THE NUMBER                       │ 2904
│ OF ISO-GAIN CONTOURS, STORE A CALIBRATED                      │
│ TRANSMIT-GAIN SETTING OF THE TRANSCEIVER,                     │
│ A CALIBRATED MEASURED TRANSCEIVER TEMPERATURE,                │
│ AND A CALIBRATED TRANSMITTER FREQUENCY                        │
└─────────────────────────────────────────────────────────────┘

┌─────────────────────────────────────────────────────────────┐
│ POST PROCESS THE INITIAL ISO-GAIN CONTOUR DATA                │ 2906
│ FOR EACH OF THE ISO-GAIN CONTOURS TO REMOVE                   │
│ OR SUBSTANTIALLY REDUCE A SAW TOOTH EFFECT                    │
│ SUBSTANTIALLY RELATED TO VARIOUS                              │
│ CORRUPTION SOURCES IN THE TRANSCEIVER POWER                   │
│ CONTROL LOOP                                                  │
└─────────────────────────────────────────────────────────────┘

┌─────────────────────────────────────────────────────────────┐
│ FOR EACH ISO-GAIN CONTOUR                                     │ 2908
│ STORE THE POST-PROCESSED (SMOOTHED/INTERPOLATED/              │
│ FILTERED) INITIAL ISO-GAIN CONTOUR CALIBRATION DATA           │
│ AS CALIBRATED ISO-GAIN CONTOUR CALIBRATION                    │
│ DATA IN THE $V_{CC}$ LOOKUP TABLE                             │
└─────────────────────────────────────────────────────────────┘

*FIG.17C*

2700

COMPENSATE FOR A CHANGE IN THE INPUT POWER / DRIVE LEVEL OF THE MODULATED RADIO FREQUENCY INPUT SIGNAL PROVIDED TO THE RADIO FREQUENCY POWER AMPLIFIER
2702

RECEIVE AN INDICATION OF THE TRANSMIT-GAIN SETTING PARAMETER OF THE TRANSCEIVER
2704

OBTAIN OR RECEIVE A VALUE OF THE CALIBRATION TRANSMIT-GAIN SETTING PARAMETER USED DURING CALIBRATION OF THE ISO-GAIN CONTOURS BASED ON THE TRANSMIT-TARGET POWER SETTING PARAMETER
2706

DETERMINE A TRANSMIT-GAIN SETTING DELTA AS A FUNCTION OF THE INDICATION OF THE TRANSMIT-GAIN SETTING OF THE TRANSCEIVER AND THE CALIBRATION TRANSMIT-GAIN SETTING PARAMETER
2708

DETERMINE A COMPENSATION VALUE FOR THE PSEUDO-ENVELOP FOLLOWING GAIN CONTROL SIGNAL AS A FUNCTION OF THE TEMPERATURE OF THE TRANSCEIVER CIRCUITRY, THE TRANSCEIVER FREQUENCY, AND/OR A COMBINATION THEREOF
2712

(TO FIG. 18B)

# FIG. 18A

2700

(FROM FIG. 18A)

DETERMINE A MEASURED TEMPERATURE FOR THE
TRANSCEIVER CIRCUITRY
<u>2714</u>

DETERMINE THE MEASURED CALIBRATION TEMPERATURE OF THE TRANSCEIVER
CIRCUITRY DURING THE CALIBRATION OF THE ISO-GAIN CONTOURS DURING
CALIBRATION OF THE ISO-GAIN CONTOURS STORED IN THE $V_{CC}$ LOOK UP TABLE
<u>2716</u>

SUBTRACT THE MEASURED CALIBRATION TEMPERATURE FROM THE MEASURED
TRANSCEIVER TEMPERATURE TO DETERMINE A TRANSCEIVER TEMPERATURE DELTA
<u>2718</u>

DETERMINE A TEMPERATURE INDUCED TRANSCEIVER CIRCUITRY GAIN CHANGE BASED
ON THE TRANSCEIVER TEMPERATURE DELTA AND A KNOWN TEMPERATURE DEPENDENT
TRANSCEIVER GAIN CHANGE CHARACTERISTIC / FUNCTION FOR THE TRANSCEIVER
CIRCUITRY
<u>2720</u>

COMPENSATE
FOR TRANSCEIVER
FREQUENCY
<u>2722</u>

YES                                                                                      NO

DETERMINE COMPENSATION VALUE FOR
TRANSCEIVER FREQUENCY AS A
FUNCTION OF THE TRANSCEIVER
FREQUENCY AND THE CALIBRATION
TRANSCEIVER FREQUENCY USED
DURING CALIBRATION OF THE ISO-GAIN
CONTOURS STORED IN THE STORED IN
THE $V_{CC}$ LOOK UP TABLE
<u>2726</u>

SUBTRACT THE TEMPERATURE
INDUCED TRANSCEIVER
CIRCUITRY GAIN CHANGE FROM
THE TRANSCEIVER GAIN DELTA
TO GENERATE THE PSEUDO-
ENVELOPE FOLLOWER GAIN
CONTROL SIGNAL
<u>2724</u>

(TO FIG. 18C)          **FIG. 18B**          (TO FIG. 18D)

(FROM FIG. 18B)                                    2700

> OBTAIN THE TRANSCEIVER FREQUENCY TO BE USED DURING THE DATA
> TRANSMISSION
> 2728

> OBTAIN THE CALIBRATION TRANSCEIVER FREQUENCY USED DURING
> CALIBRATION OF THE ISO-GAIN CONTOURS STORED IN THE $V_{CC}$ LOOK UP TABLE
> 2730

> SUBTRACT THE CALIBRATION TRANSCEIVER FREQUENCY FROM THE
> TRANSCEIVER FREQUENCY TO BE USED DURING TRANSMISSION TO DETERMINE
> A TRANSCEIVER FREQUENCY DELTA
> 2732

> DETERMINE A TRANSCEIVER FREQUENCY INDUCED GAIN CHANGE BASED ON
> THE TRANSCEIVER FREQUENCY DELTA AND A KNOW TRANSCEIVER GAIN
> CHANGE CHARACTERISTIC / FUNCTION FOR THE TRANSCEIVER CIRCUITRY WITH
> RESPECT TO A CHANGE IN THE TRANSCEIVER FREQUENCY
> 2734

> SUBTRACT THE TEMPERATURE INDUCED TRANSCEIVER CIRCUITRY GAIN
> CHANGE AND TRANSCEIVER FREQUENCY INDUCED GAIN CHANGE FROM THE
> TRANSMIT-GAIN SETTING DELTA TO GENERATE THE  PSEUDO-ENVELOPE
> FOLLOWER GAIN CONTROL SIGNAL
> 2736

(TO FIG. 18D)

**FIG. 18C**

(FROM FIG. 18B AND 18C)

SCALE THE ENVELOPE MAGNITUDE AS A FUNCTION OF THE PSEUDO GAIN CONTROL SIGNAL TO GENERATE AN INDEX INPUT SIGNAL FOR THE $V_{CC}$ LOOK UP TABLE THAT PROVIDES AN EMULATION OF THE INPUT POWER $P_{IN}$ OF THE MODULATED RADIO FREQUENCY INPUT SIGNAL PROVIDED TO THE RADIO FREQUENCY POWER AMPLIFIER
2738

GENERATE A CONTROL SIGNAL TO SUBSTANTIALLY OPERATE ON A SINGLE ISO-GAIN CONTOUR RELATED TO THE TRANSMIT-TARGET OUTPUT POWER SETTING PARAMETER TO MINIMIZE DISTORTION IN RESPONSE TO AN INCREASE IN THE INPUT POWER PIN OF THE MODULATED RADIO FREQUENCY INPUT SIGNAL PROVIDED TO THE RADIO FREQUENCY POWER AMPLIFIER
2740

COMMENCE THE DATA TRANSMISSION
2742

**FIG. 18D**

Europäisches
Patentamt
European
Patent Office
Office européen
des brevets

# EUROPEAN SEARCH REPORT

**Application Number**

EP 19 15 5709

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | US 2006/087372 A1 (HENZE RONALD W [US]) 27 April 2006 (2006-04-27) * paragraph [0009]; figures 3,5A,5B * * paragraph [0035] - paragraph [0041] * * paragraph [0026] - paragraph [0035] * ----- | 1-10 | INV. H03F1/32 H03F1/02 H03F3/195 H03F3/24 H04B17/00 |
| X | US 2008/085684 A1 (PHILLIPS KERRY B [US] ET AL) 10 April 2008 (2008-04-10) | 1,10 | H03G3/00 H03G3/30 |
| A | * paragraph [0023] - paragraph [0029]; figure 2 * * paragraph [0044] * ----- | 2-9 | H03F3/217 |
| A | US 2011/043282 A1 (DROGI SERGE FRANCOIS [US] ET AL) 24 February 2011 (2011-02-24) * the whole document * ----- | 1-15 | |
| A | US 6 141 541 A (MIDYA PALLAB [US] ET AL) 31 October 2000 (2000-10-31) * the whole document * ----- | 1-15 | |

TECHNICAL FIELDS
SEARCHED      (IPC)

H03F
H04B
H03G

The present search report has been drawn up for all claims

| Place of search | Date of completion of the search | Examiner |
|---|---|---|
| Munich | 30 April 2019 | Kurzbauer, Werner |

EPO FORM 1503 03.82 (P04C01)

## ANNEX TO THE EUROPEAN SEARCH REPORT
## ON EUROPEAN PATENT APPLICATION NO.

EP 19 15 5709

This annex lists the patent family members relating to the patent documents cited in the above-mentioned European search report.
The members are as contained in the European Patent Office EDP file on
The European Patent Office is in no way liable for these particulars which are merely given for the purpose of information.

30-04-2019

| Patent document cited in search report | | Publication date | Patent family member(s) | | Publication date |
|---|---|---|---|---|---|
| US 2006087372 | A1 | 27-04-2006 | EP | 1810398 A1 | 25-07-2007 |
| | | | US | 2006087372 A1 | 27-04-2006 |
| | | | WO | 2006043140 A1 | 27-04-2006 |
| US 2008085684 | A1 | 10-04-2008 | EP | 2070278 A2 | 17-06-2009 |
| | | | KR | 20090078812 A | 20-07-2009 |
| | | | US | 2008085684 A1 | 10-04-2008 |
| | | | US | 2010248657 A1 | 30-09-2010 |
| | | | WO | 2008045159 A2 | 17-04-2008 |
| US 2011043282 | A1 | 24-02-2011 | NONE | | |
| US 6141541 | A | 31-10-2000 | DE | 19860097 A1 | 15-07-1999 |
| | | | FR | 2773282 A1 | 02-07-1999 |
| | | | GB | 2338130 A | 08-12-1999 |
| | | | US | 6141541 A | 31-10-2000 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20060270366 A
- US 2006087372 A
- US 2005208907 A
- US 7917105 B
- EP 1383235 A